# EUROPEAN PATENT APPLICATION

(11) **EP 4 460 029 A1**
(43) Date of publication of application: **06.11.2024**
(21) Application number: 22915686.4
(22) Date of filing: 09.12.2022
(51) Int. Cl.: H04N 25/13, G02B 5/20, H01L 27/146, H04N 25/10, H04N 25/70

(54) **LIGHT DETECTION DEVICE AND ELECTRONIC APPARATUS**

(30) Priority: 27.12.2021 JP 2021212984
(71) Applicant: Sony Semiconductor Solutions Corporation, Atsugi-shi, Kanagawa 243-0014 (JP)
(72) Inventor: YOKOCHI Kaito, Atsugi-shi, Kanagawa 243-0014 (JP); TAKASE Hiroaki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/045492
(87) International publication number: WO 2023/127462

(57) **Abstract**

Provided is a technique for achieving spectral separation. A light detection device includes a semiconductor layer in which a photoelectric conversion unit is provided for each of pixels, and an optical filter layer provided on a light incidence surface side of the semiconductor layer. The optical filter layer includes a first filter part and a second filter part, each provided for each of the pixels. Each of the first and second filter parts includes: a first metal film provided on the light incidence surface side of the semiconductor layer; a first dielectric film and a second dielectric film which have different refractive indices and which are arranged in a thickness direction of the semiconductor layer side by side, on a side of the first metal film opposite from a side on which the semiconductor layer is located; and a second metal film provided on a side of the first and second dielectric films opposite from a side on which the first metal film is located. A ratio of thicknesses of the first dielectric film and the second dielectric film is different in the first filter part and in the second filter part.

## Description

### [Technical Field]

The present technique (the technique according to the present disclosure) relates to a light detection device, and particularly relates to a technique useful for applications in a light detection device having an optical filter layer and an electronic device provided with the same.

### [Background Art]

Light detection devices, such as solid-state image capturing devices and rangefinding devices, include an optical filter layer that guides incident light to a photoelectric conversion region in a semiconductor layer. PTL 1 discloses a color filter layer including a filter part constituted by a thermosetting resin to which a pigment is added.

### [Citation List]

### [Patent Literature]

[PTL 1]
JP 2021-150325A

### [Summary]

### [Technical Problem]

However, in a color filter layer constituted by a resin to which a pigment is added, the transmittance is determined by the properties of the material, and it has therefore been difficult to achieve spectral separation, where light is divided into a variety of wavelength bands.

An object of the present technique is to provide a technique capable of achieving spectral separation.

### [Solution to Problem]

(1) A light detection device according to one aspect of the present technique includes:
   a semiconductor layer in which a photoelectric conversion unit is provided for each of pixels; and
   an optical filter layer provided on a light incidence surface side of the semiconductor layer,
   wherein
   the optical filter layer includes a first filter part and a second filter part, each provided for each of the pixels,
   each of the first and second filter parts includes:
      a first metal film provided on the light incidence surface side of the semiconductor layer;
      a first dielectric film and a second dielectric film which have different refractive indices and which are arranged in a thickness direction of the semiconductor layer side by side, on a side of the first metal film opposite from a side on which the semiconductor layer is located; and
      a second metal film provided on a side of the first and second dielectric films opposite from a side on which the first metal film is located, and
      a ratio of thicknesses of the first dielectric film and the second dielectric film is different in the first filter part and in the second filter part.
(2) A light detection device according to another aspect of the present technique includes:
   a semiconductor layer in which a photoelectric conversion unit is provided; and
   an optical filter layer provided on a light incidence surface side of the semiconductor layer,
   wherein
   the optical filter layer includes:
      a first metal film provided on the light incidence surface side of the semiconductor layer;
      a first dielectric film and a second dielectric film which have different refractive indices and which are arranged in a thickness direction of the semiconductor layer side by side, on a side of the first metal film opposite from a side on which the semiconductor layer is located; a second metal film provided on a side of the first and second dielectric films opposite from a side on which the first metal film is located; and
      a light absorption film provided between the first dielectric film and the second dielectric film.
(3) An electronic device according to another aspect of the present technique includes:
   the light detection device;
   an optical lens that forms an image of image light from a subject on an image capturing plane of the light detection device; and
   a signal processing circuit that performs signal processing on a signal output from the light detection device.

### [Brief Description of Drawings]

[Fig. 1]

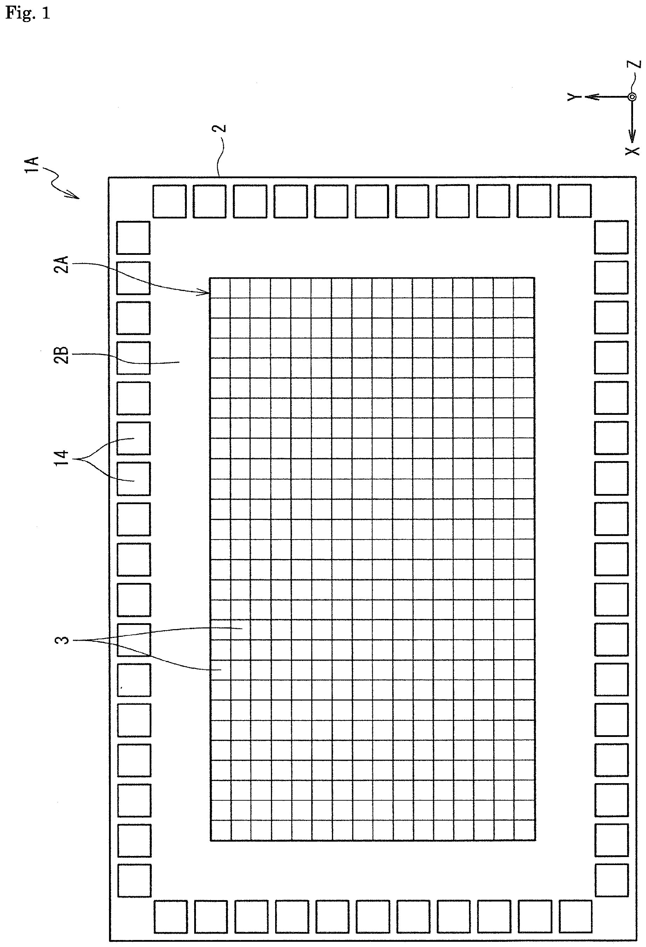

   Fig. 1 is a chip layout diagram illustrating one example of the configuration of a solid-state image capturing device according to a first embodiment of the present technique.
[Fig. 2]

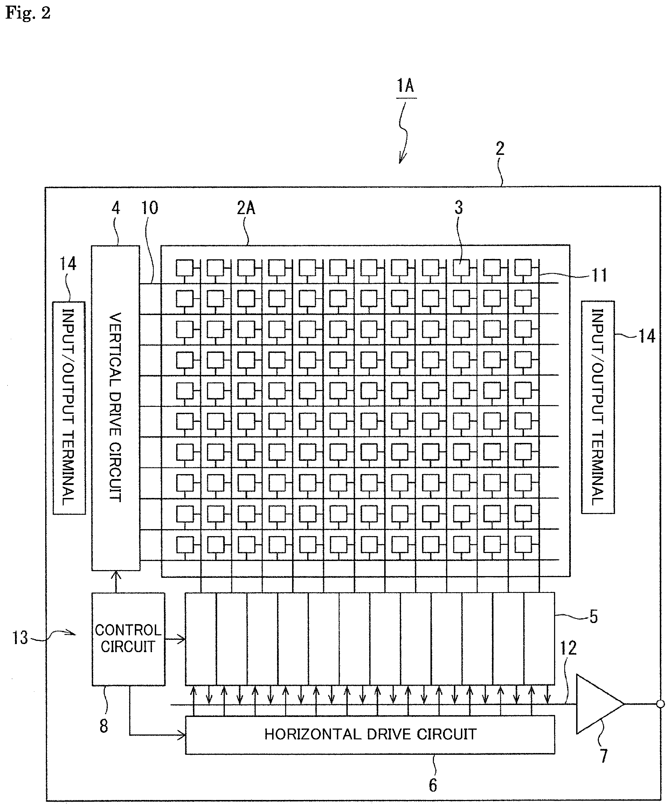

   Fig. 2 is a block diagram illustrating an example of the configuration of the solid-state image capturing device according to the first embodiment of the present technique.
[Fig. 3]

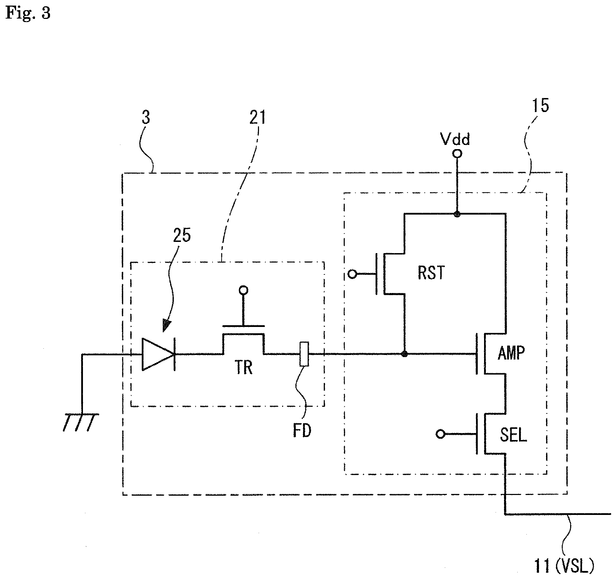

   Fig. 3 is an equivalent circuit diagram illustrating an example of the configuration of a pixel in the solid-state image capturing device according to the first embodiment of the present technique.
[Fig. 4]

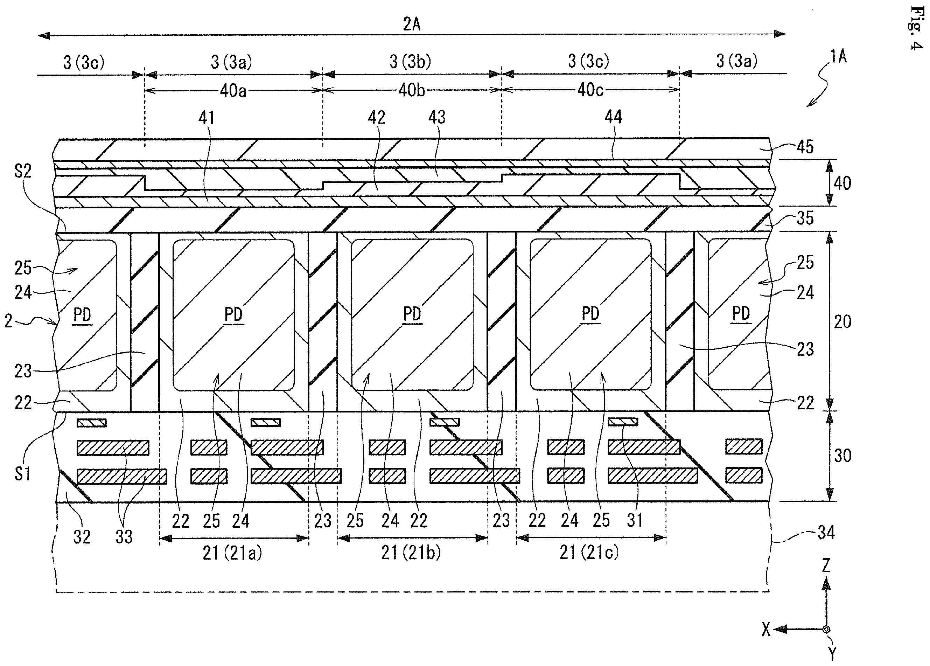

   Fig. 4 is a longitudinal cross-sectional view schematically illustrating the longitudinal cross-sectional structure of a pixel array part of the solid-state image capturing device according to the first embodiment of the present technique.
[Fig. 5]

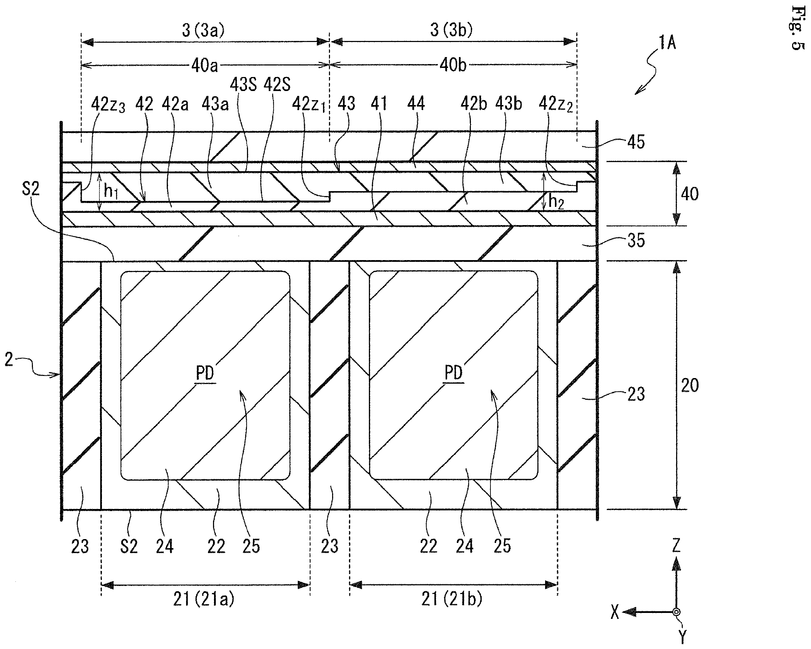

   Fig. 5 is a longitudinal cross-sectional view illustrating two pixels adjacent to each other in Fig. 4.
[Fig. 6]

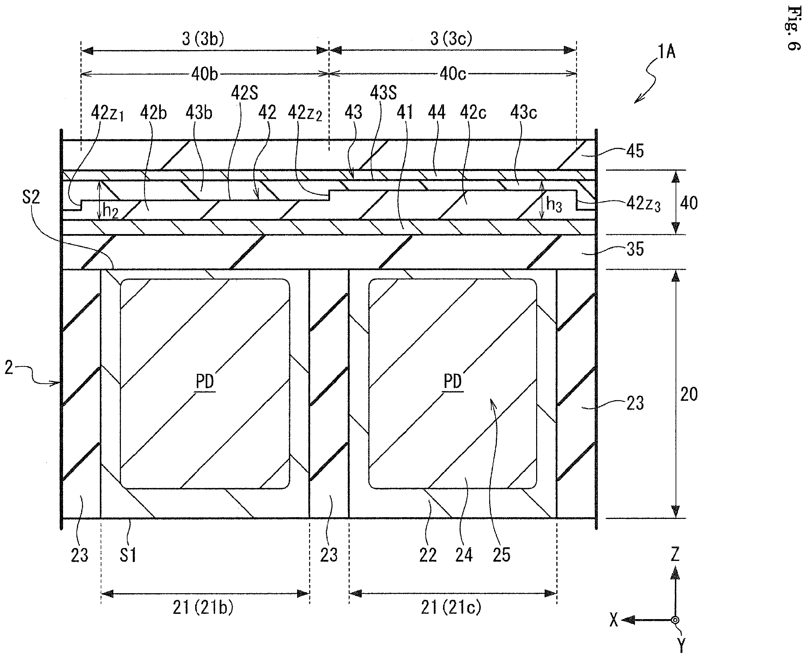

   Fig. 6 is a longitudinal cross-sectional view illustrating two pixels adjacent to each other in Fig. 4.
[Fig. 7A]

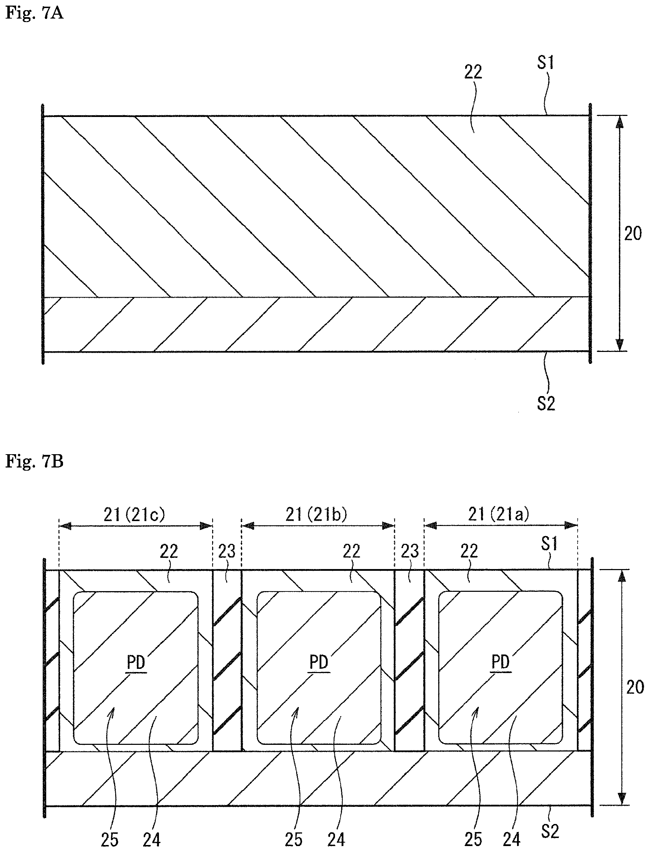

   Fig. 7A is a process cross-sectional view illustrating a method for manufacturing the solid-state image capturing device according to the first embodiment of the present technique.
[Fig. 7B]
   Fig. 7B is a process cross-sectional view subsequent to Fig. 7A.
[Fig. 7C]

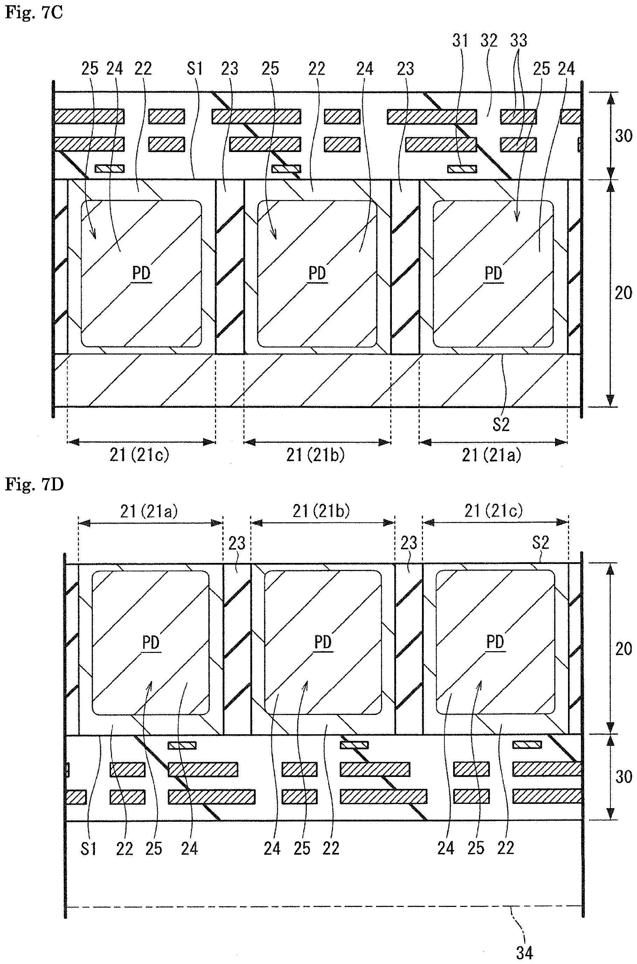

   Fig. 7C is a process cross-sectional view subsequent to Fig. 7B.
[Fig. 7D]
   Fig. 7D is a process cross-sectional view subsequent to Fig. 7C.
[Fig. 7E]

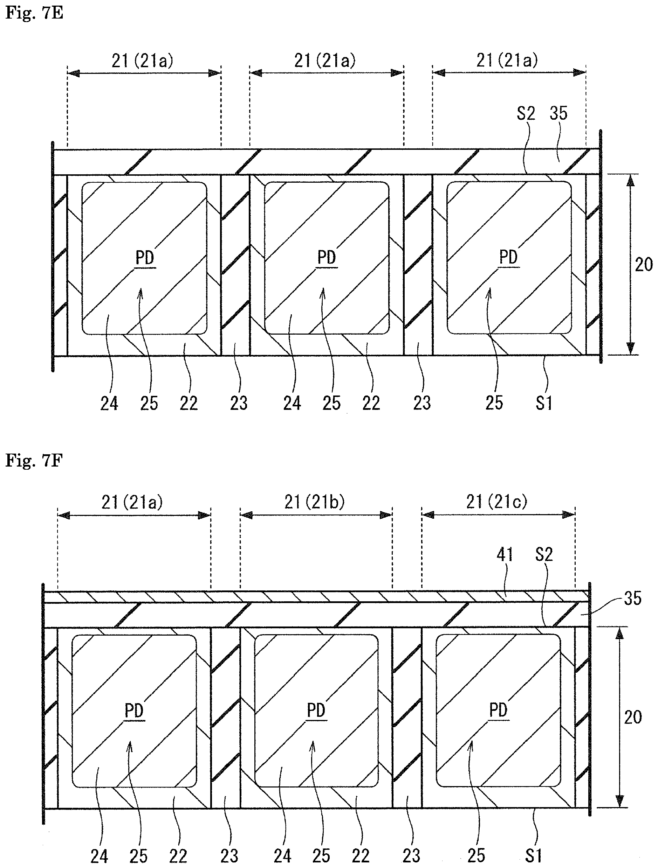

   Fig. 7E is a process cross-sectional view subsequent to Fig. 7D.
[Fig. 7F]
   Fig. 7F is a process cross-sectional view subsequent to Fig. 7E.
[Fig. 7G]

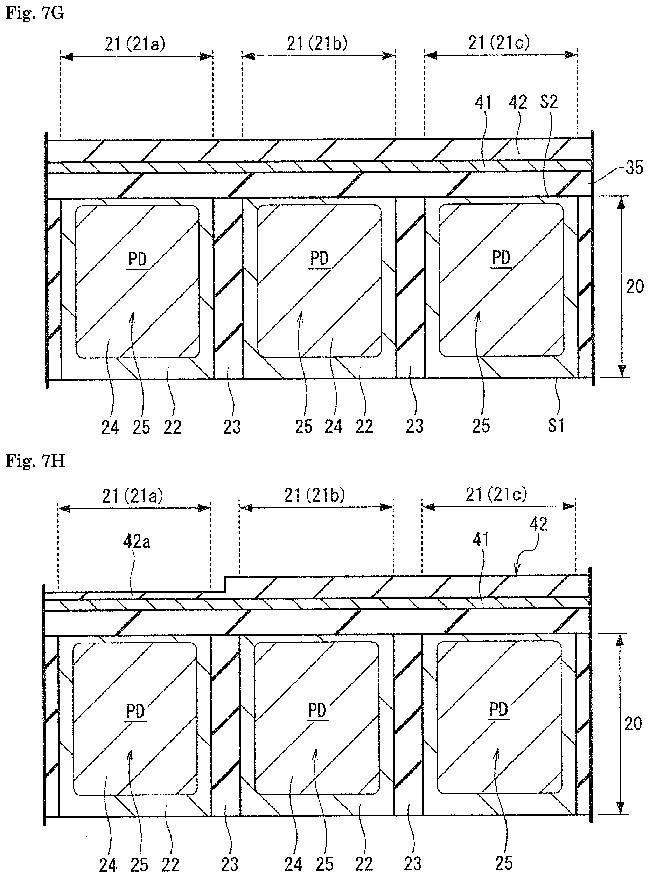

   Fig. 7G is a process cross-sectional view subsequent to Fig. 7F.
[Fig. 7H]
   Fig. 7H is a process cross-sectional view subsequent to Fig. 7G.
[Fig. 7I]

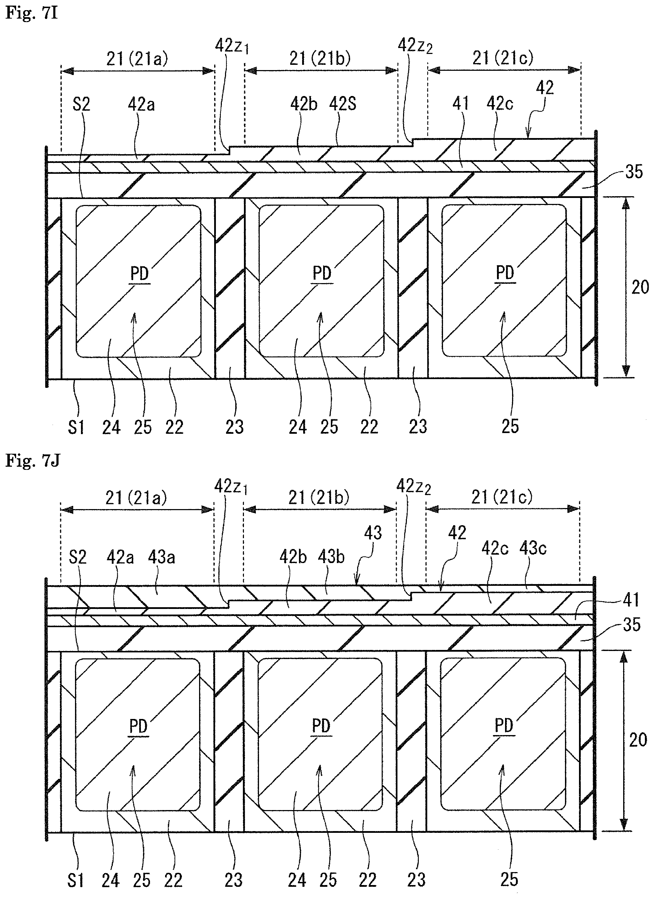

   Fig. 7I is a process cross-sectional view subsequent to Fig. 7H.
[Fig. 7J] Fig. 7J is a process cross-sectional view subsequent to Fig. 7I.
[Fig. 7K]

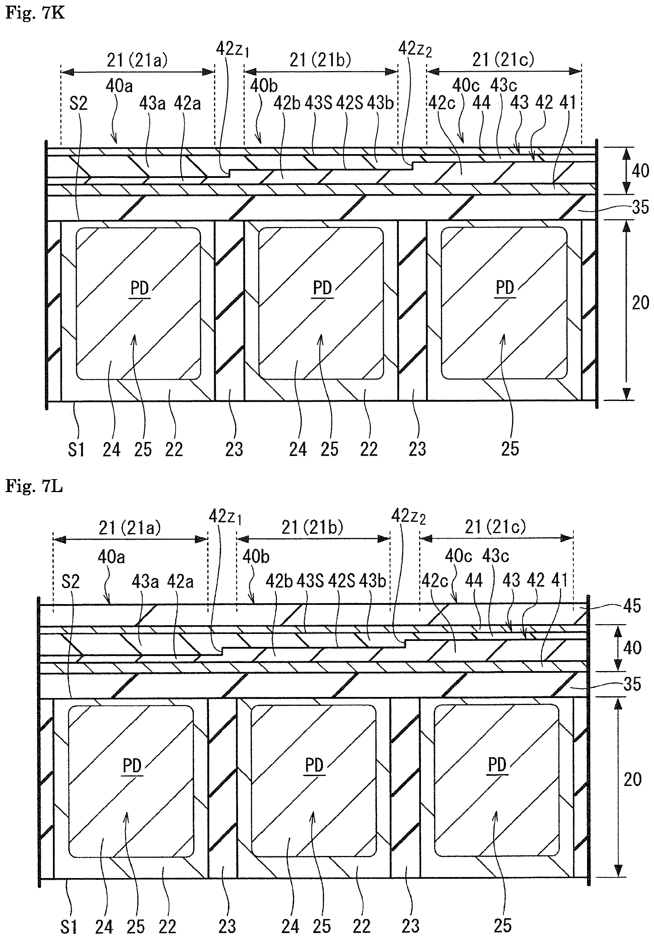

   Fig. 7K is a process cross-sectional view subsequent to Fig. 7J.
[Fig. 7L]
   Fig. 7L is a process cross-sectional view subsequent to Fig. 7K.
[Fig. 8A]

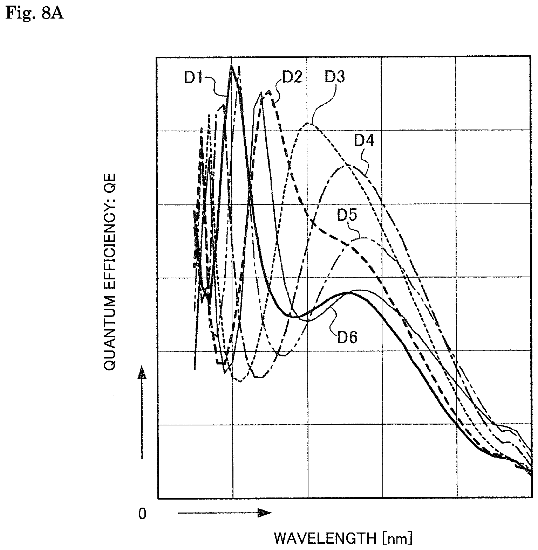

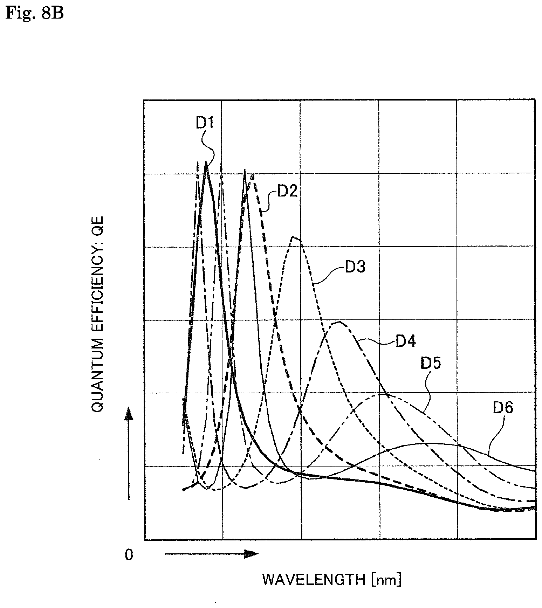

   Fig. 8Ais a characteristic chart indicating a quantum efficiency QE when a first metal film and a second metal have the same thickness.
[Fig. 8B]
   Fig. 8B is a characteristic chart indicating the quantum efficiency QE when the first metal film is thicker than the second metal film.
[Fig. 9]

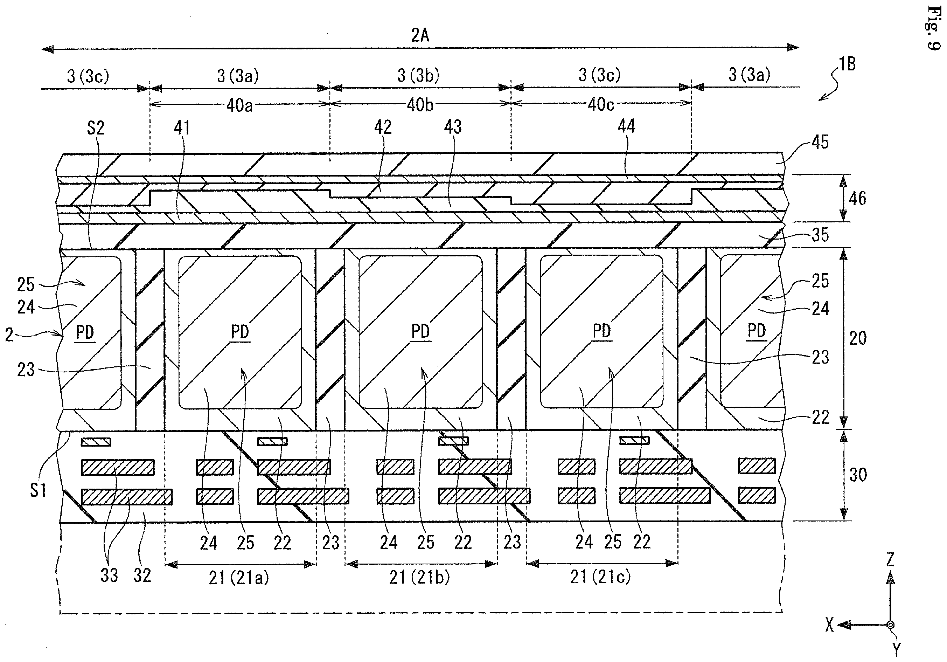

   Fig. 9 is a longitudinal cross-sectional view schematically illustrating the longitudinal cross-sectional structure of the pixel array part of the solid-state image capturing device according to a second embodiment of the present technique.
[Fig. 10]

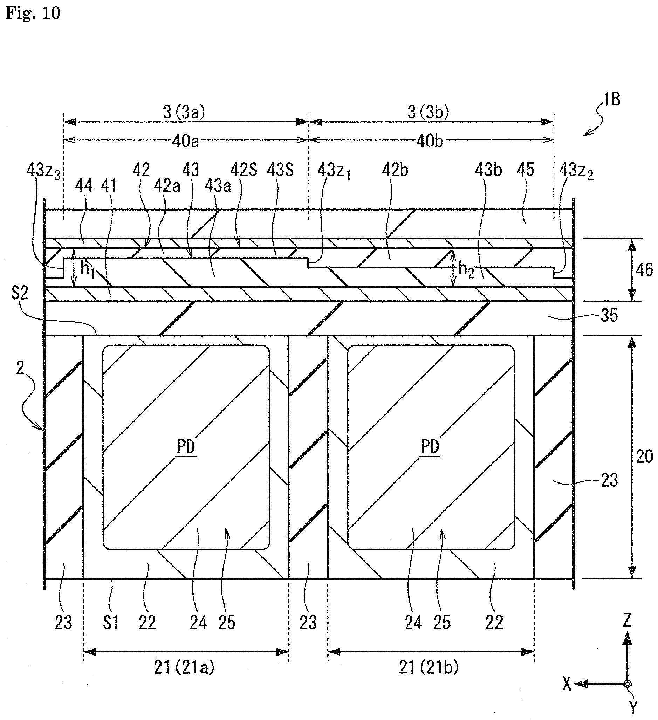

   Fig. 10 is a longitudinal cross-sectional view illustrating two pixels adjacent to each other in Fig. 9.
[Fig. 11]

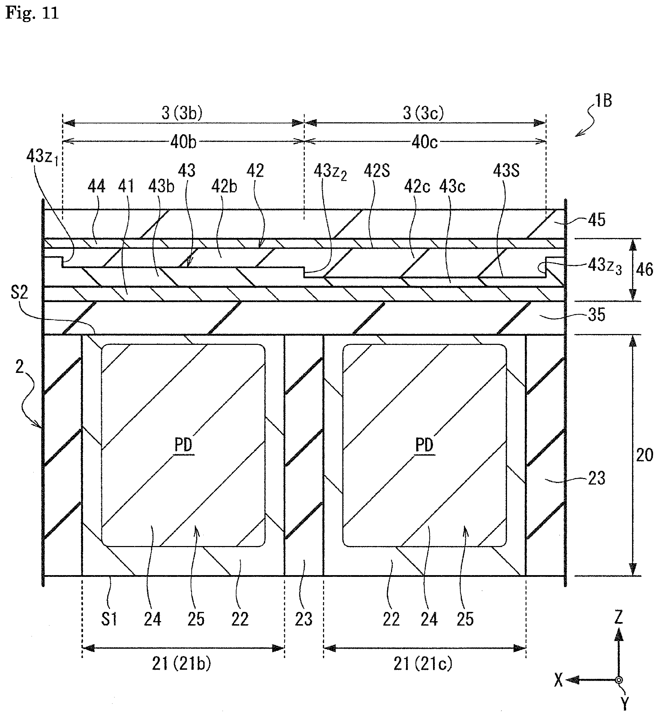

   Fig. 11 is a longitudinal cross-sectional view illustrating two pixels adjacent to each other in Fig. 9.
[Fig. 12]

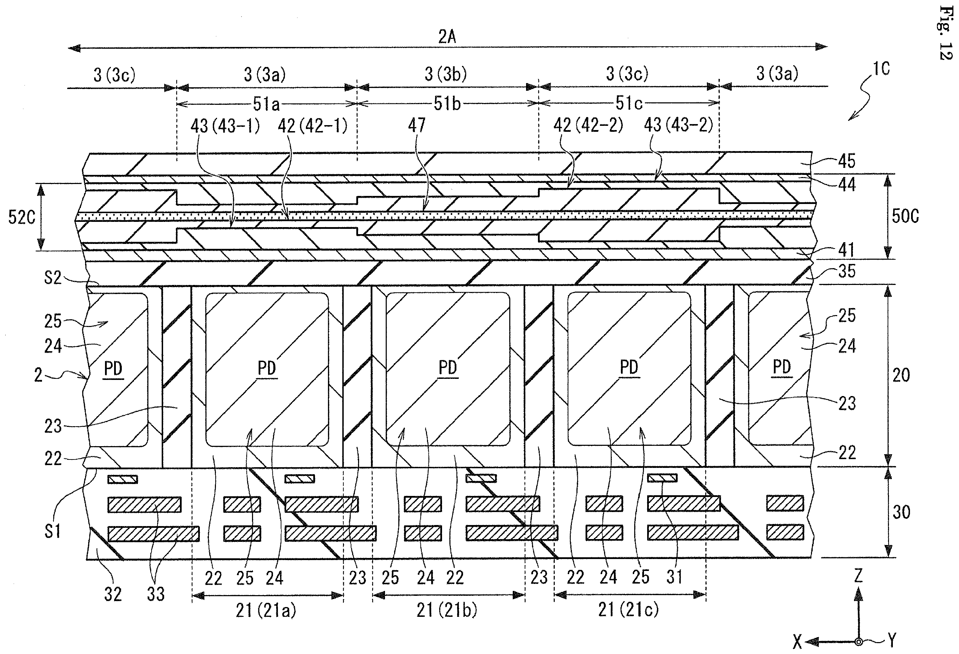

   Fig. 12 is a longitudinal cross-sectional view schematically illustrating the longitudinal cross-sectional structure of the solid-state image capturing device according to a third embodiment of the present technique.
[Fig. 13]

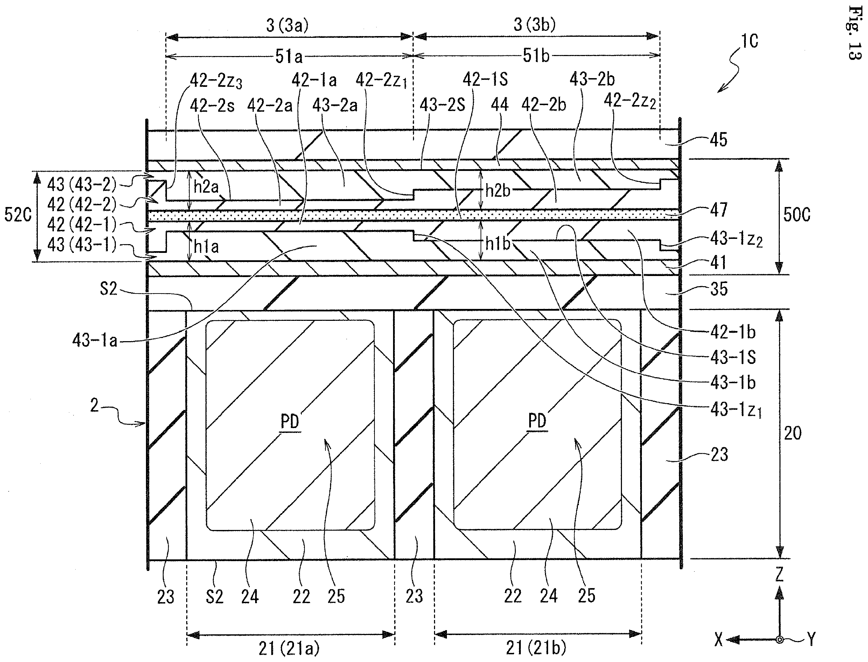

   Fig. 13 is a longitudinal cross-sectional view illustrating two pixels adjacent to each other in Fig. 12.
[Fig. 14]

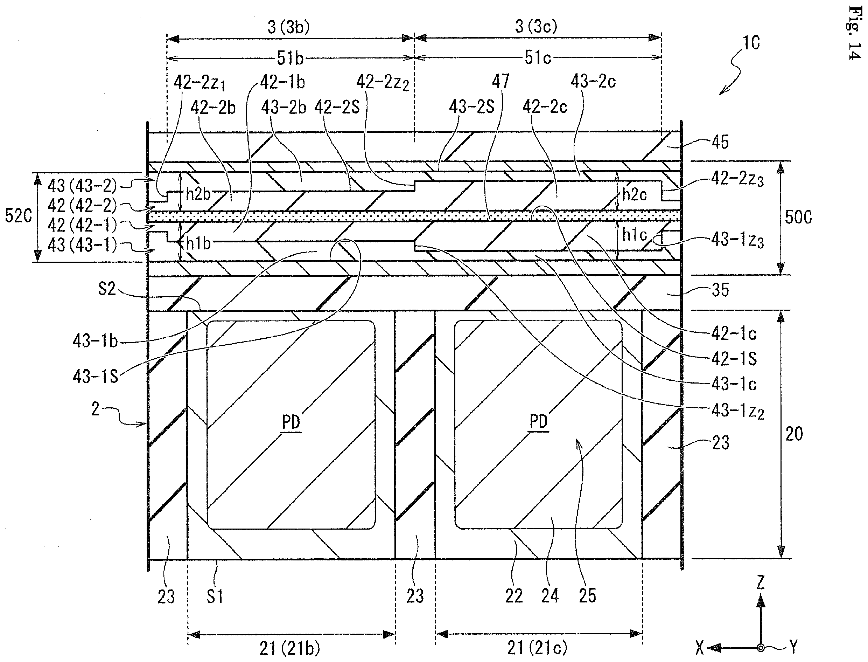

   Fig. 14 is a longitudinal cross-sectional view illustrating two pixels adjacent to each other in Fig. 12.
[Fig. 15A]

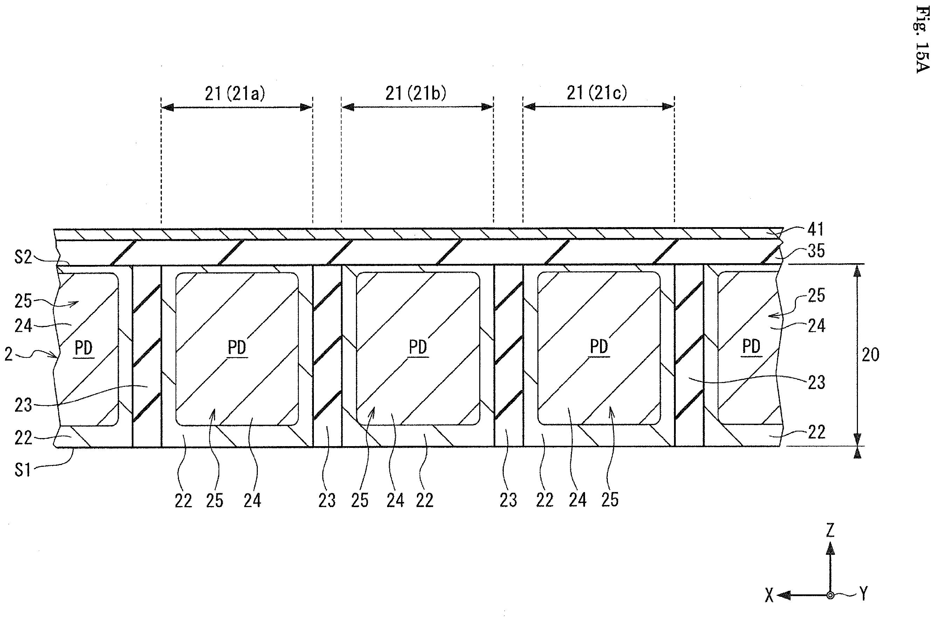

   Fig. 15A is a process cross-sectional view illustrating a method for manufacturing the solid-state image capturing device according to the third embodiment of the present technique.
[Fig. 15B]

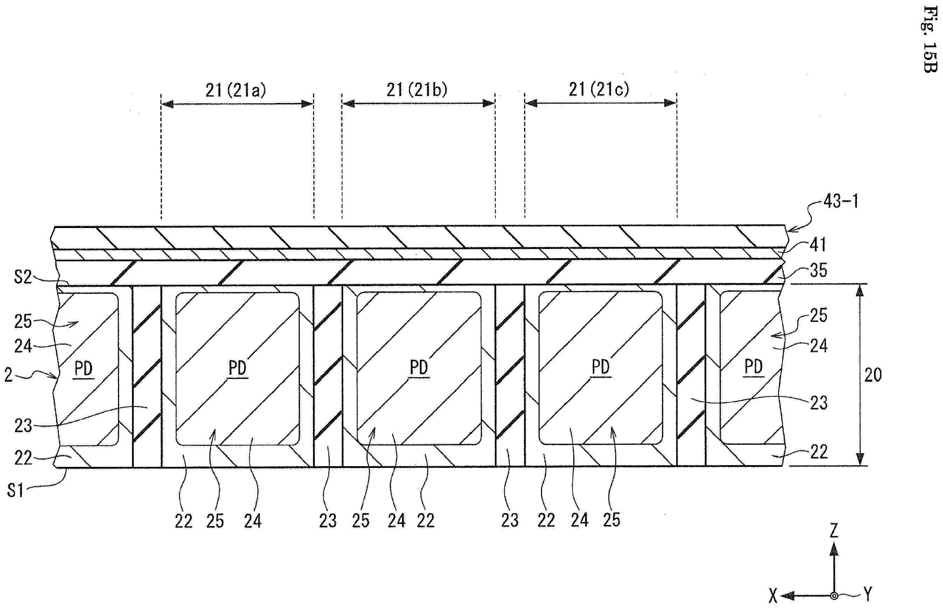

   Fig. 15B is a process cross-sectional view subsequent to Fig. 15A.
[Fig. 15C]

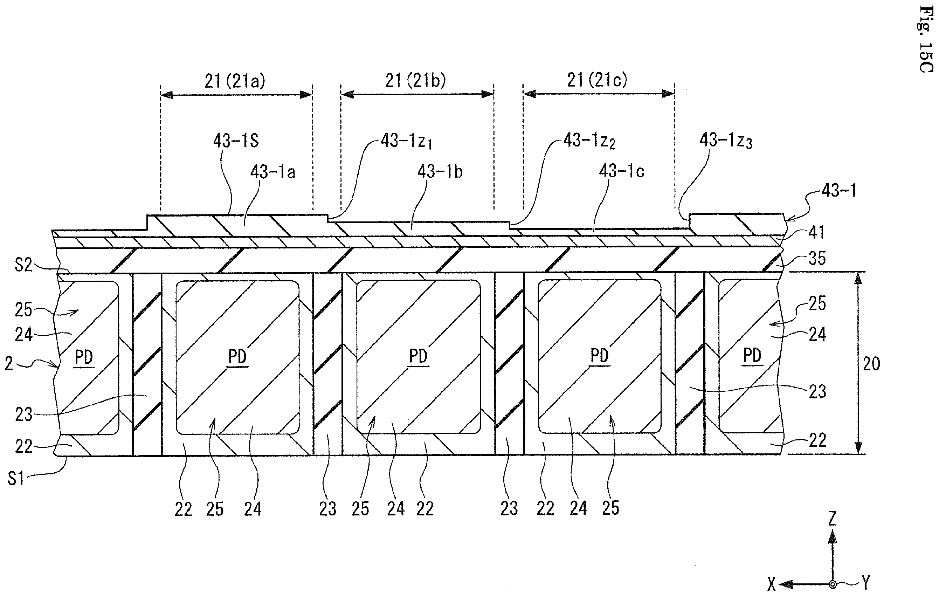

   Fig. 15C is a process cross-sectional view subsequent to Fig. 15B.
[Fig. 15D]

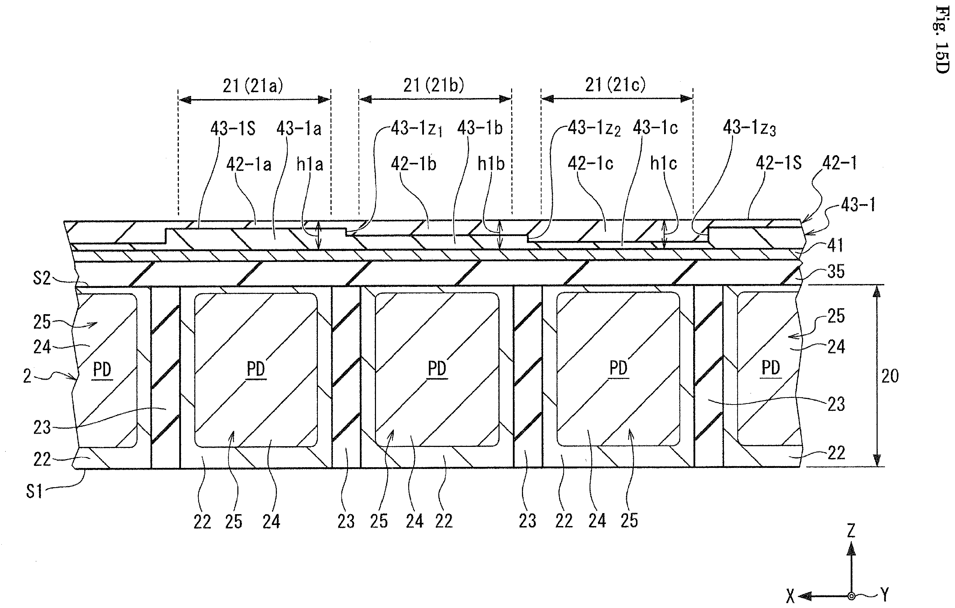

   Fig. 15D is a process cross-sectional view subsequent to Fig. 15C.
[Fig. 15E]

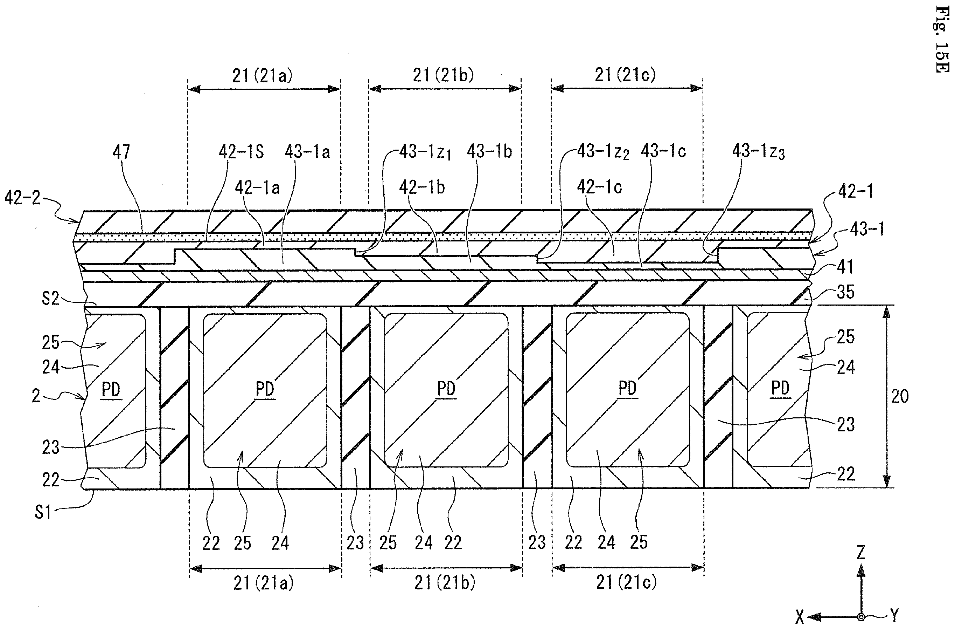

   Fig. 15E is a process cross-sectional view subsequent to Fig. 15D.
[Fig. 15F]

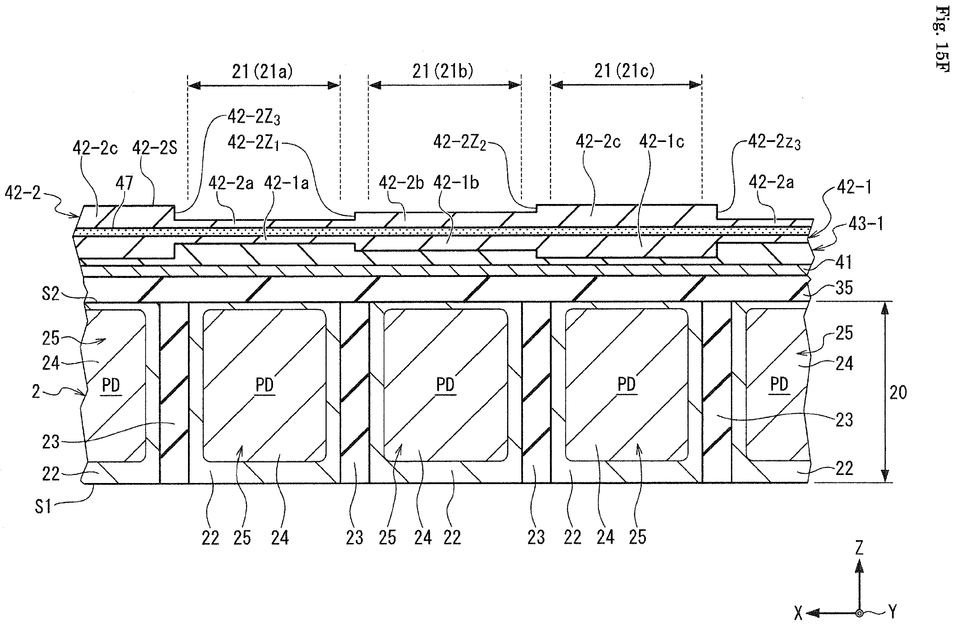

   Fig. 15F is a process cross-sectional view subsequent to Fig. 15E.
[Fig. 15G]

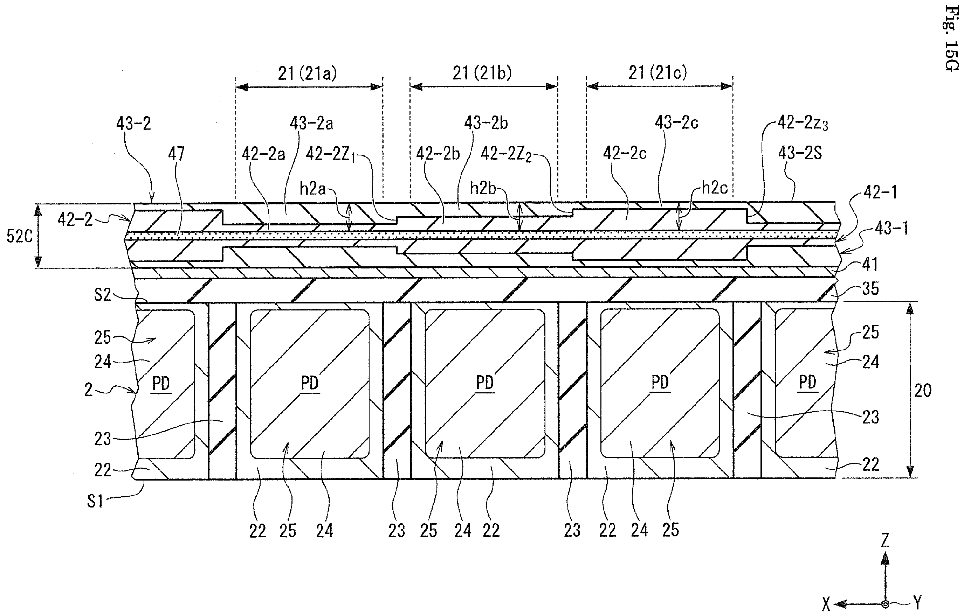

   Fig. 15G is a process cross-sectional view subsequent to Fig. 15F.
[Fig. 15H]

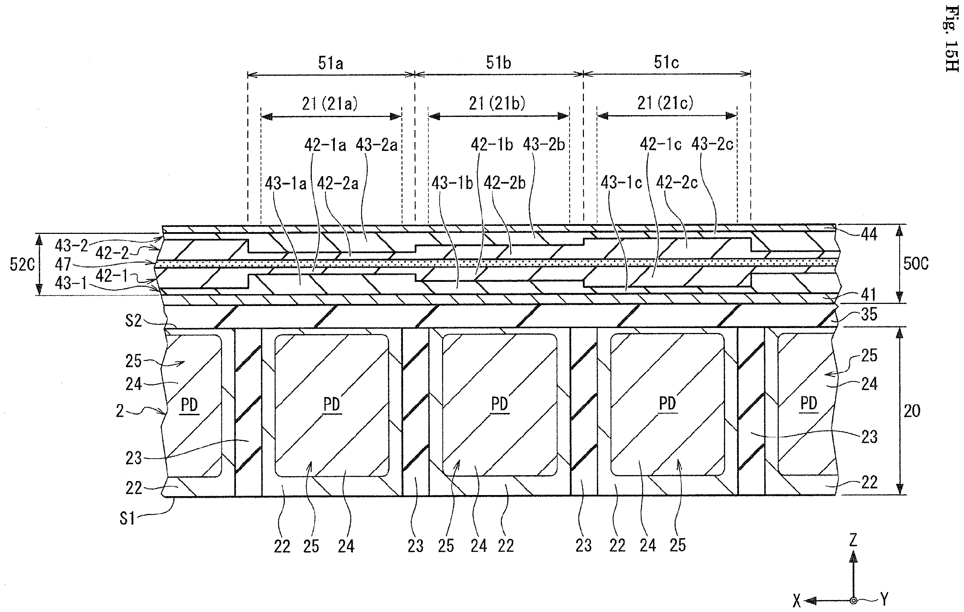

   Fig. 15H is a process cross-sectional view subsequent to Fig. 15G.
[Fig. 15I]

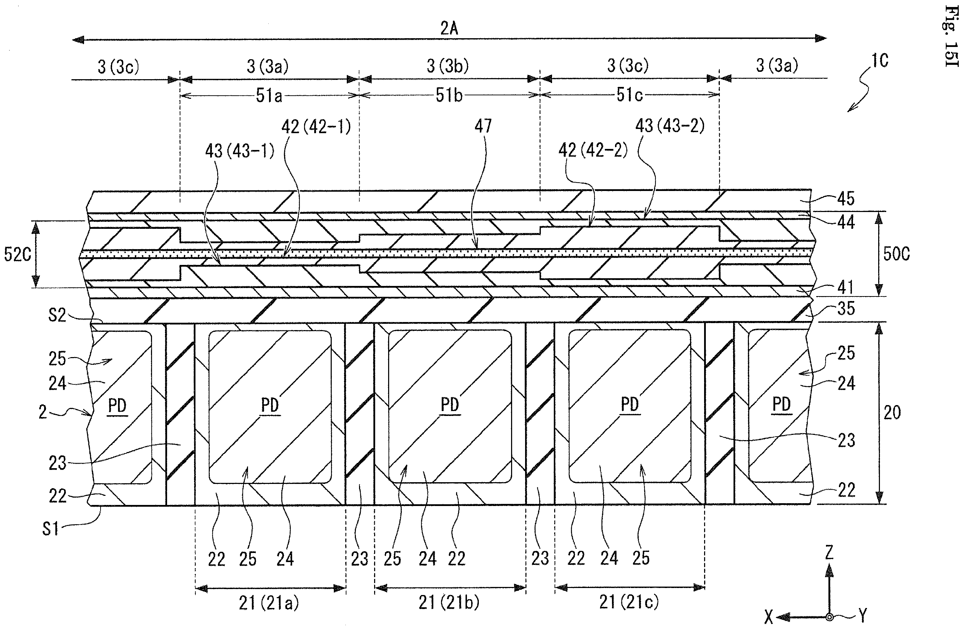

   Fig. 15I is a process cross-sectional view subsequent to Fig. 15H.
[Fig. 16A]

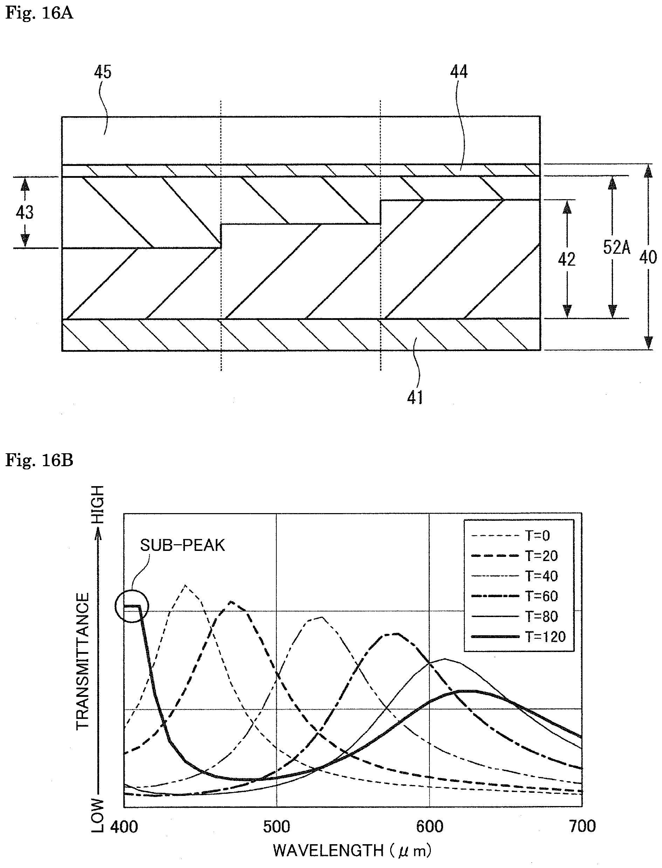

   Fig. 16A is a longitudinal cross-sectional view schematically illustrating an optical filter layer of the first embodiment as a reference example.
[Fig. 16B]
   Fig. 16B is a diagram illustrating a correlation between transmittance and the thickness of a first dielectric film (high refraction film) in the optical filter layer according to the reference example illustrated in Fig. 16A.
[Fig. 17A]

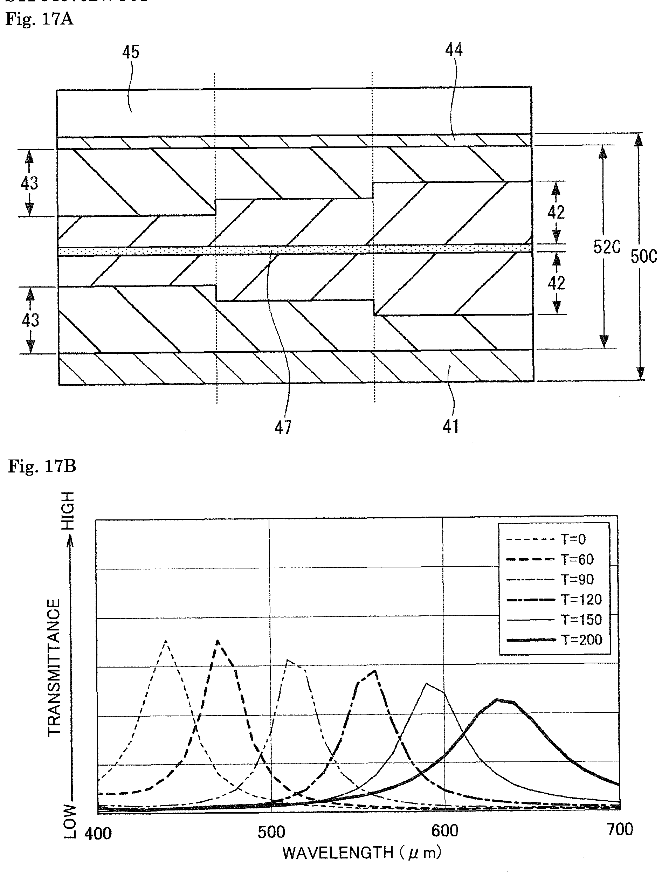

   Fig. 17A is a longitudinal cross-sectional view schematically illustrating the optical filter layer of the third embodiment.
[Fig. 17B]
   Fig. 17B is a diagram illustrating a correlation between transmittance and the total thickness of two first dielectric films (high refraction films) on respective sides of a light absorption film, in the optical filter layer according to the third embodiment illustrated in Fig. 17A.
[Fig. 18]

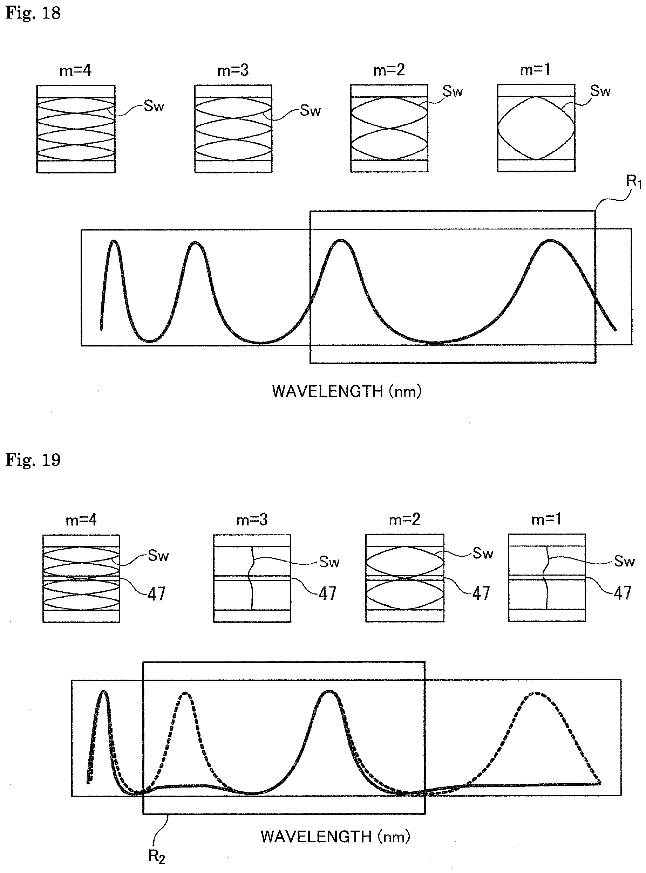

   Fig. 18 is a diagram illustrating stationary waves (standing waves) for each of orders of resonance in a Fabry-Perot resonance structure in which a dielectric film is interposed between two metal films.
[Fig. 19]
   Fig. 19 is a diagram illustrating stationary waves (standing waves) for each of orders of resonance in a Fabry-Perot resonance structure in which a dielectric film, into which a light absorption film has been inserted, is interposed between two metal films.
[Fig. 20]

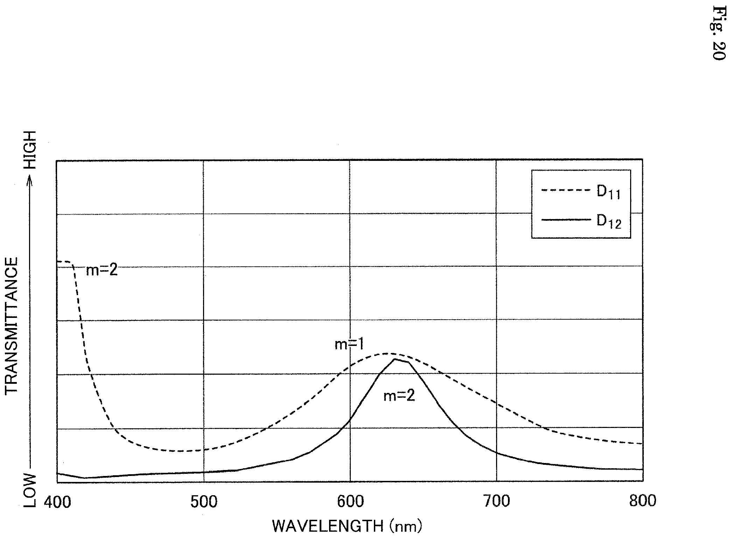

   Fig. 20 is a diagram illustrating a correlation between transmittance, the thickness of a resonance layer in the optical filter layer according to the reference example illustrated in Fig. 16A, and the thickness of a resonance layer in the optical filter layer according to the third embodiment illustrated in Fig. 17A.
[Fig. 21A]

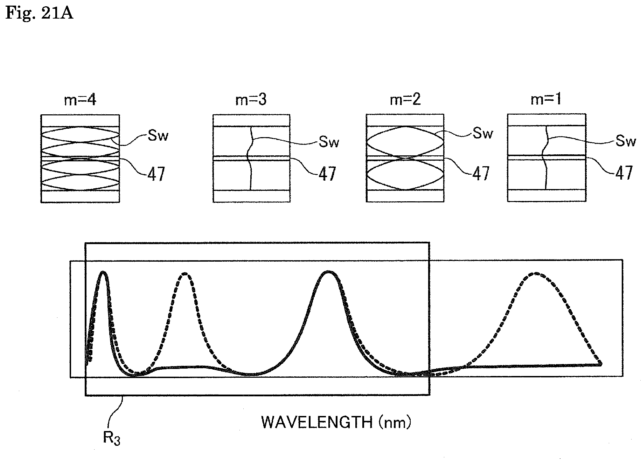

   Fig. 21A is a diagram illustrating stationary waves (standing waves) for each of orders of resonance in a Fabry-Perot resonance structure in which a dielectric film, into which a light absorption film has been inserted, is interposed between two metal films.
[Fig. 21B]

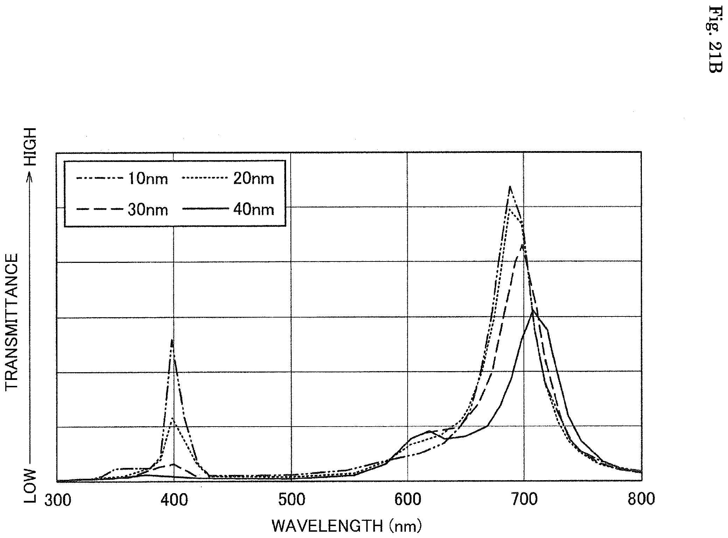

   Fig. 21B is a diagram illustrating a correlation between transmittance and the thickness of the light absorption film in the Fabry-Perot resonance structure illustrated in Fig. 21A.
[Fig. 22]

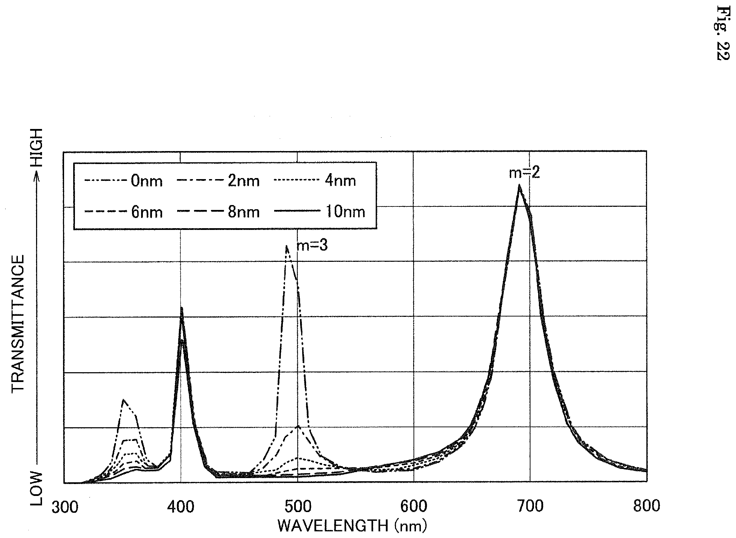

   Fig. 22 is a diagram illustrating a correlation between transmittance and the thickness of a light absorption film in a Fabry-Perot resonance structure in which a dielectric film, into which the light absorption film has been inserted, is interposed between two metal films.
[Fig. 23]

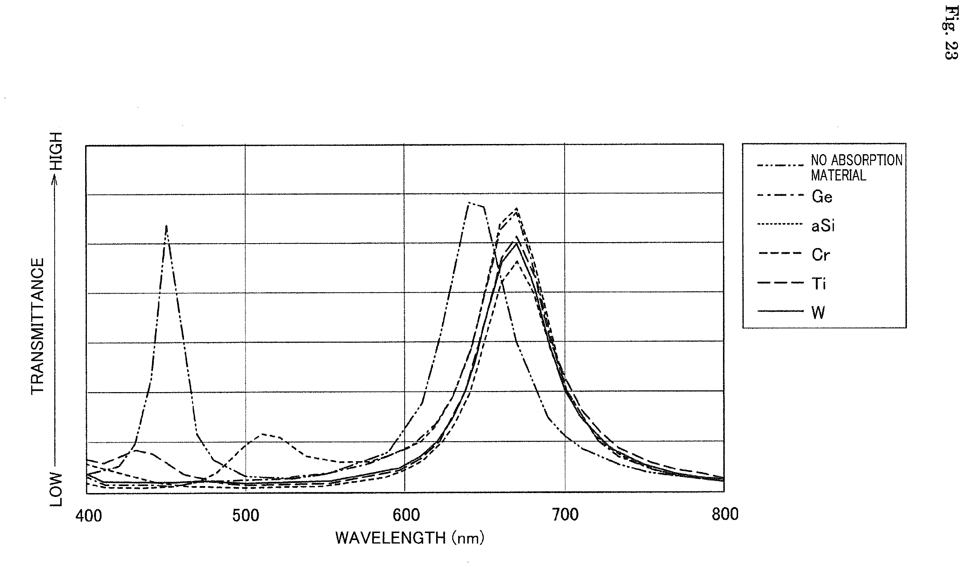

   Fig. 23 is a diagram illustrating a correlation between transmittance and the material of a light absorption film in a Fabry-Perot resonance structure in which a dielectric film, into which the light absorption film has been inserted, is interposed between two metal films.
[Fig. 24]

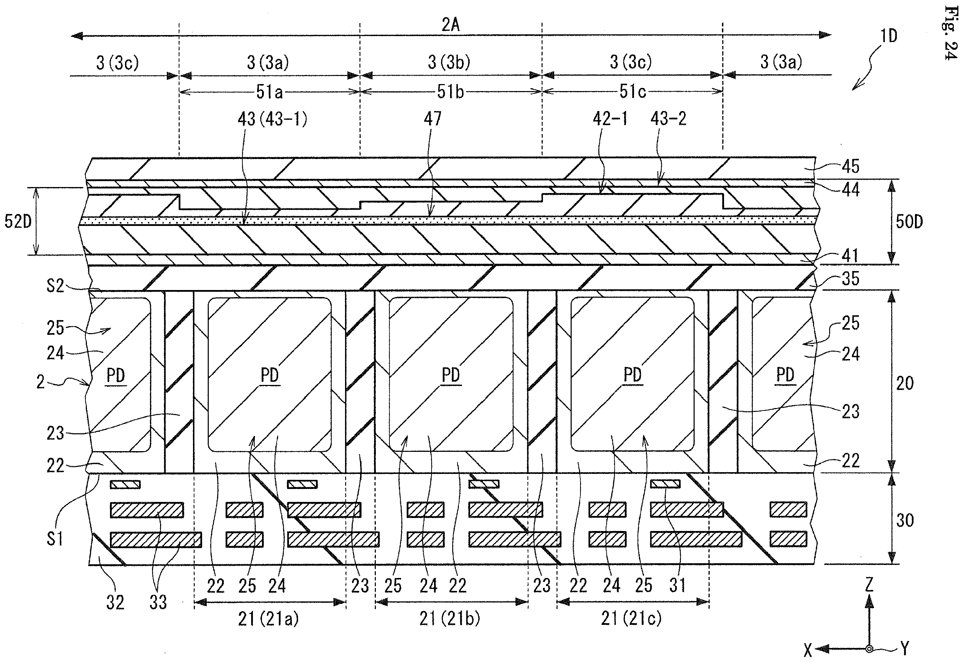

   Fig. 24 is a longitudinal cross-sectional view schematically illustrating the longitudinal cross-sectional structure of the solid-state image capturing device according to a fourth embodiment of the present technique.
[Fig. 25]

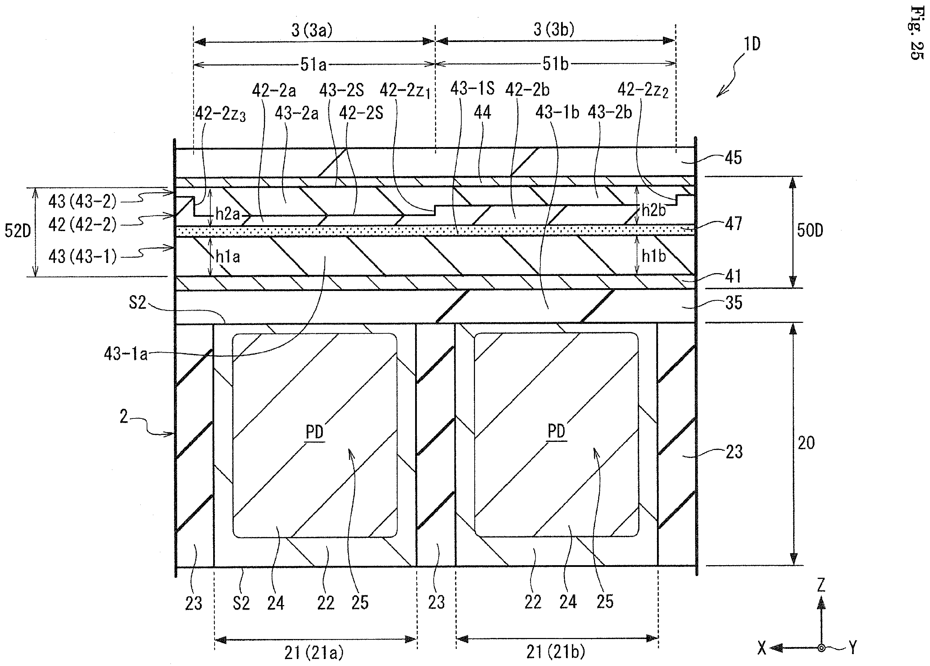

   Fig. 25 is a longitudinal cross-sectional view illustrating two pixels adjacent to each other in Fig. 24.
[Fig. 26]

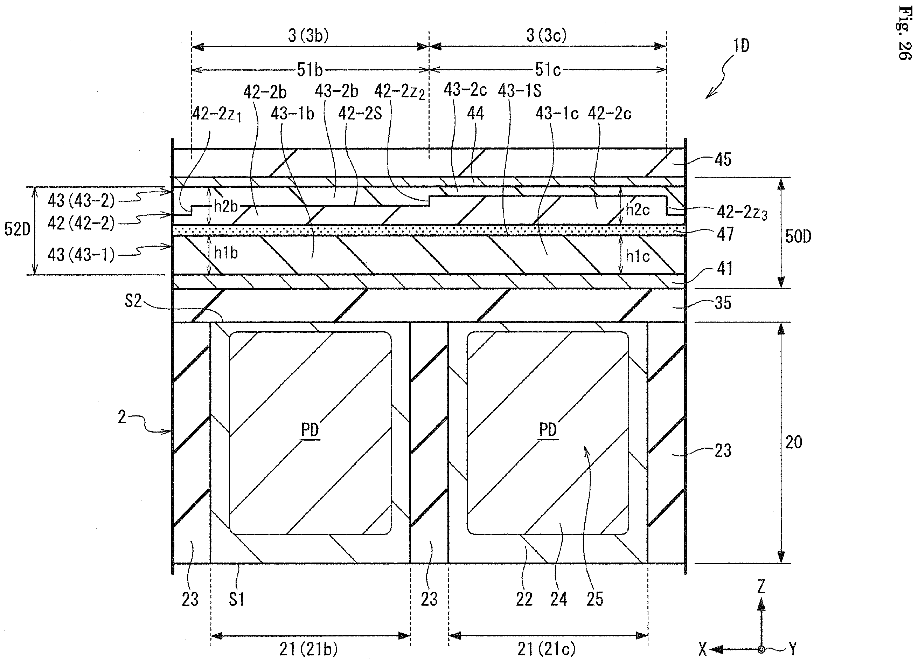

   Fig. 26 is a longitudinal cross-sectional view illustrating two pixels adjacent to each other in Fig. 24.
[Fig. 27]

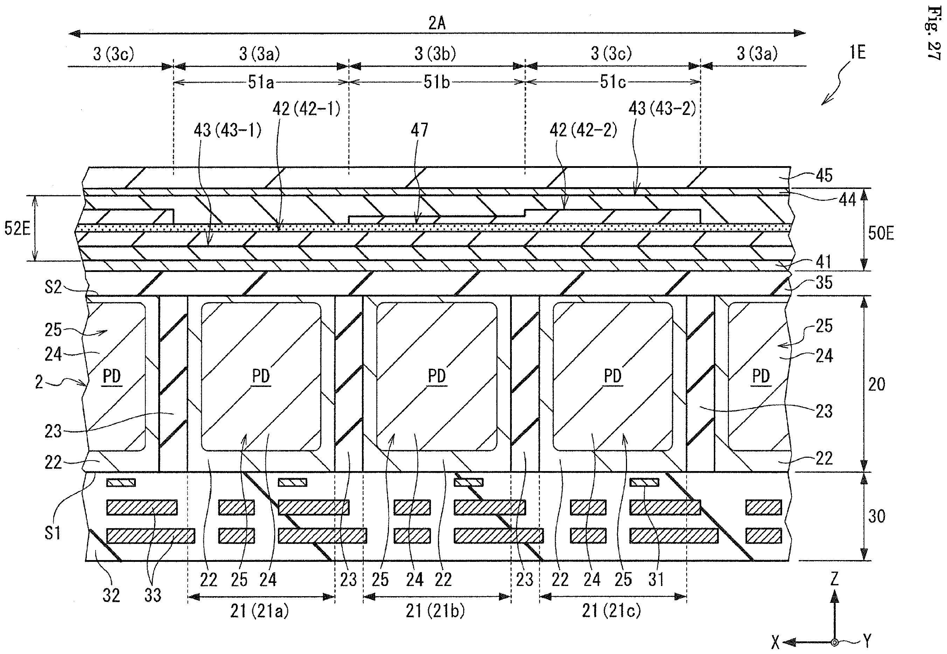

   Fig. 27 is a longitudinal cross-sectional view schematically illustrating the longitudinal cross-sectional structure of the solid-state image capturing device according to a fifth embodiment of the present technique.
[Fig. 28]

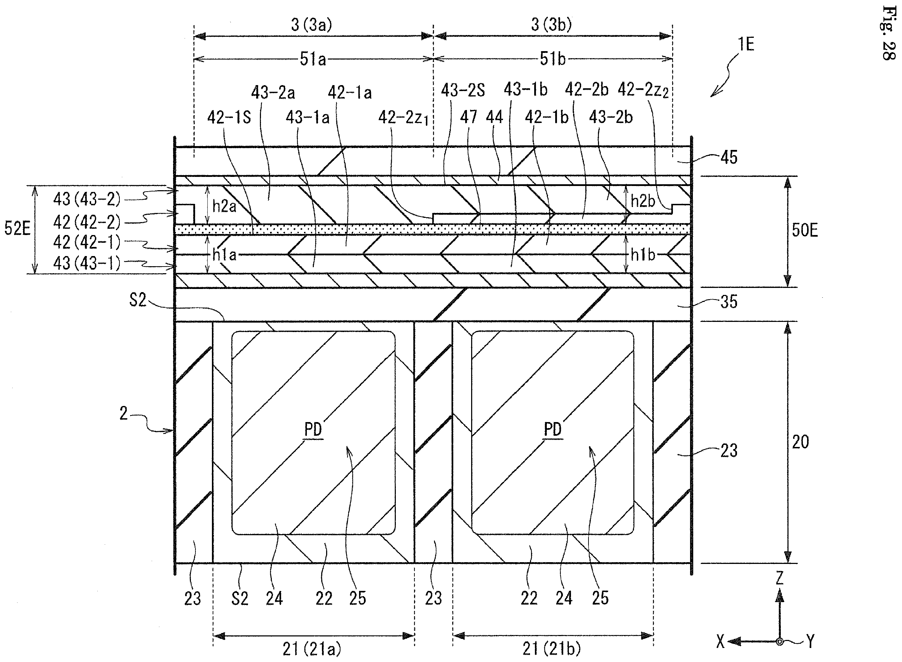

   Fig. 28 is a longitudinal cross-sectional view illustrating two pixels adjacent to each other in Fig. 27.
[Fig. 29]

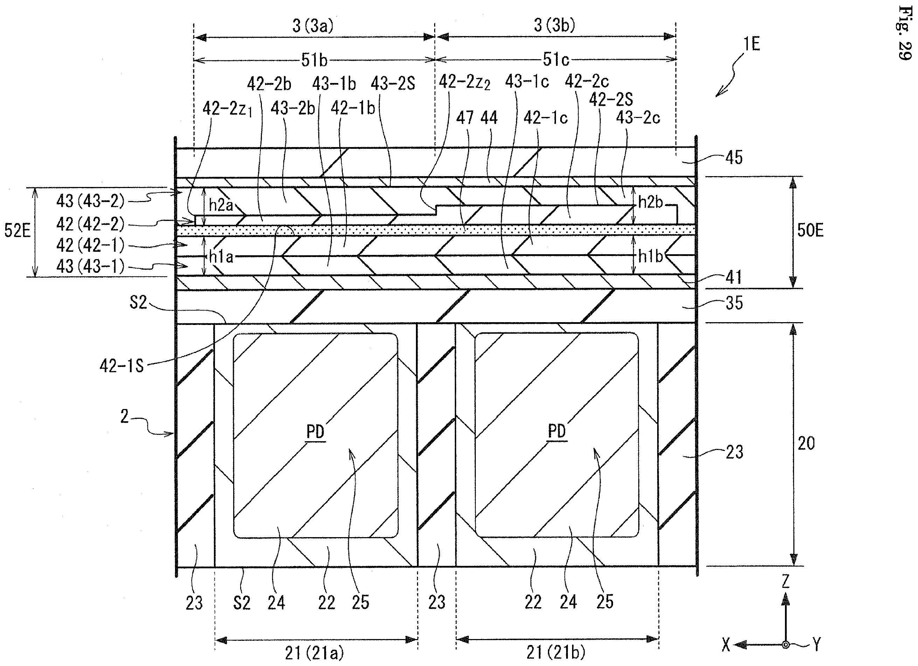

   Fig. 29 is a longitudinal cross-sectional view illustrating two pixels adjacent to each other in Fig. 27.
[Fig. 30]

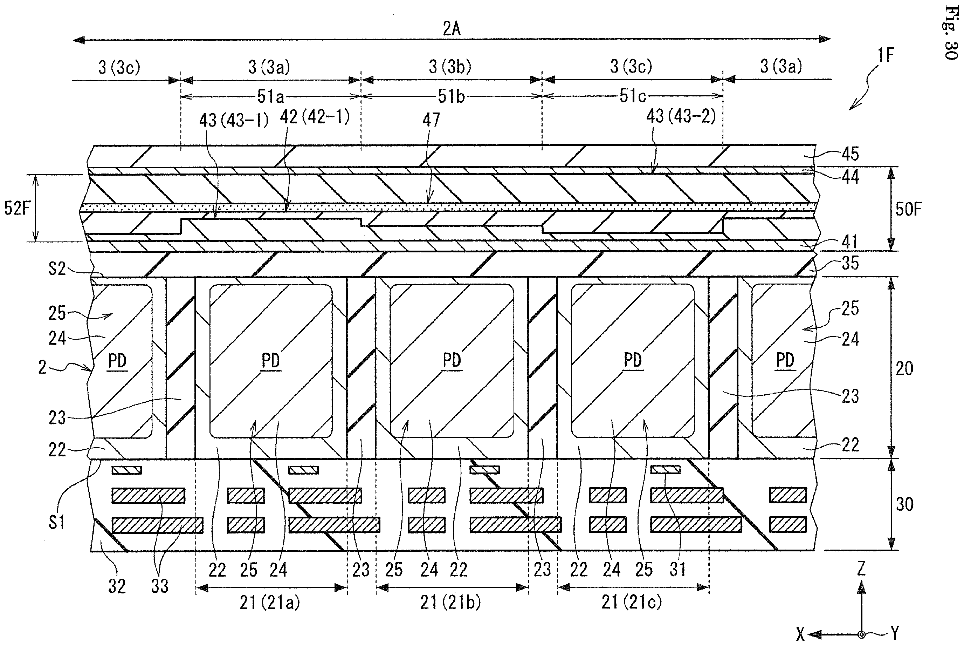

   Fig. 30 is a longitudinal cross-sectional view schematically illustrating the longitudinal cross-sectional structure of the solid-state image capturing device according to a sixth embodiment of the present technique.
[Fig. 31]

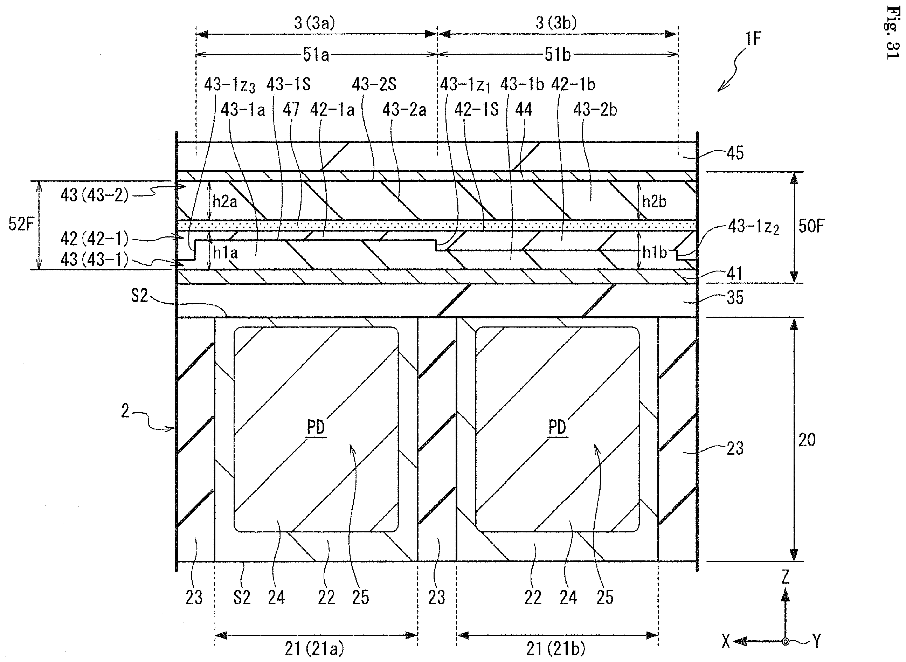

   Fig. 31 is a longitudinal cross-sectional view illustrating two pixels adjacent to each other in Fig. 30.
[Fig. 32]

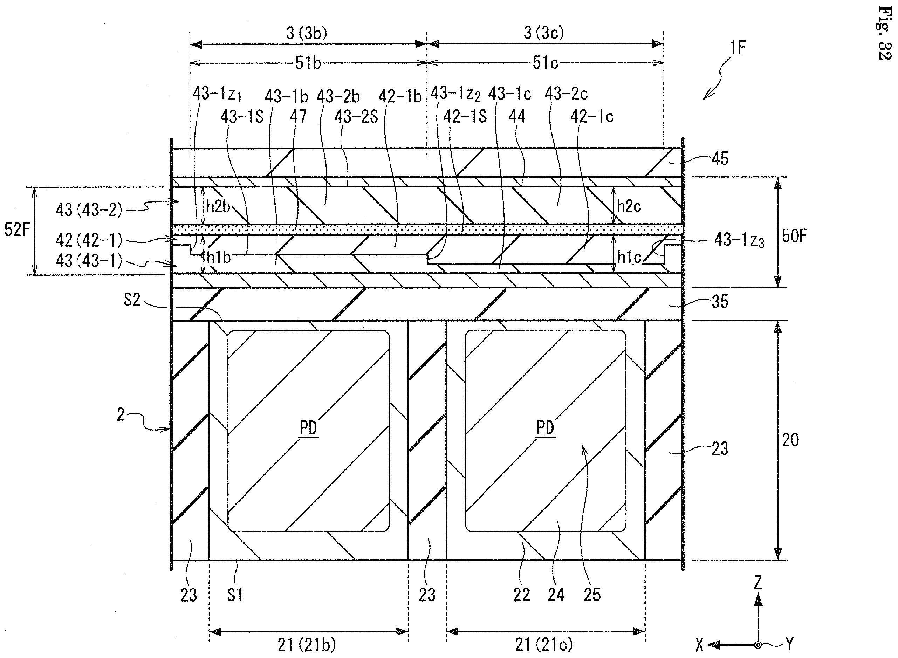

   Fig. 32 is a longitudinal cross-sectional view illustrating two pixels adjacent to each other in Fig. 30.
[Fig. 33]

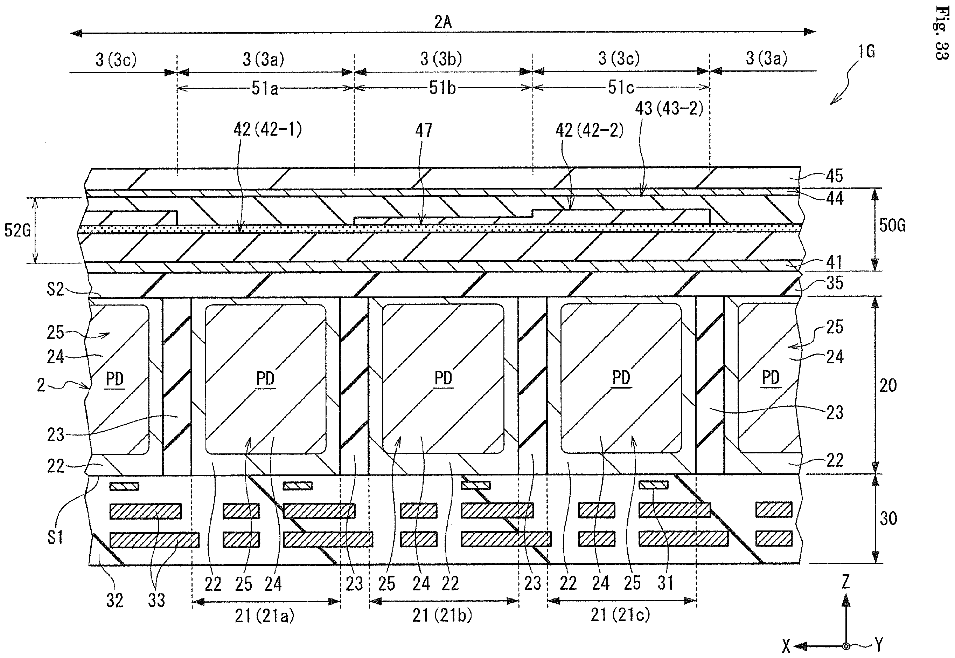

   Fig. 33 is a longitudinal cross-sectional view schematically illustrating the longitudinal cross-sectional structure of the solid-state image capturing device according to a seventh embodiment of the present technique.
[Fig. 34]

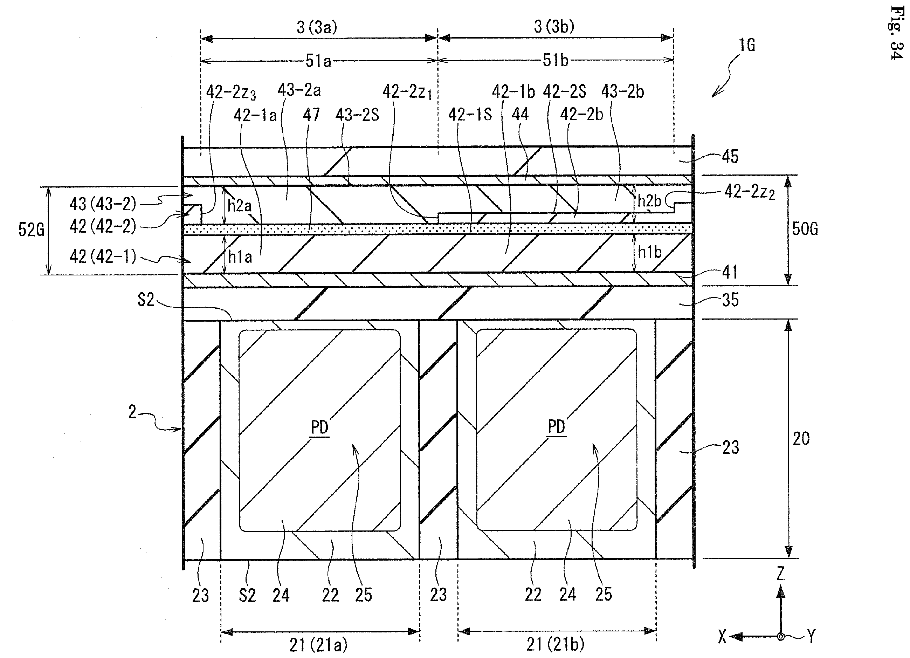

   Fig. 34 is a longitudinal cross-sectional view illustrating two pixels adjacent to each other in Fig. 33.
[Fig. 35]

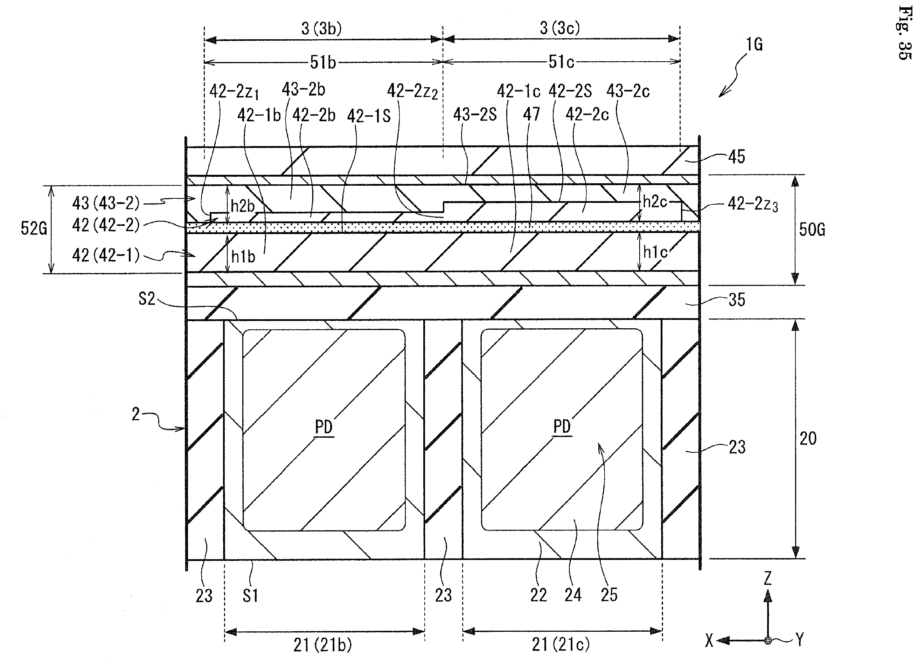

   Fig. 35 is a longitudinal cross-sectional view illustrating two pixels adjacent to each other in Fig. 33.
[Fig. 36]

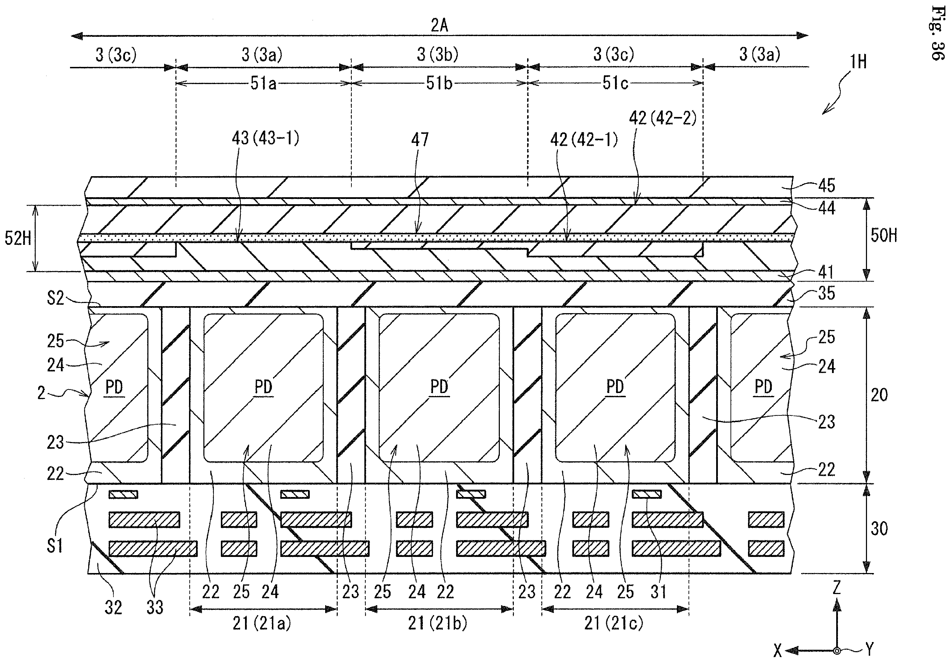

   Fig. 36 is a longitudinal cross-sectional view schematically illustrating the longitudinal cross-sectional structure of the solid-state image capturing device according to an eighth embodiment of the present technique.
[Fig. 37]

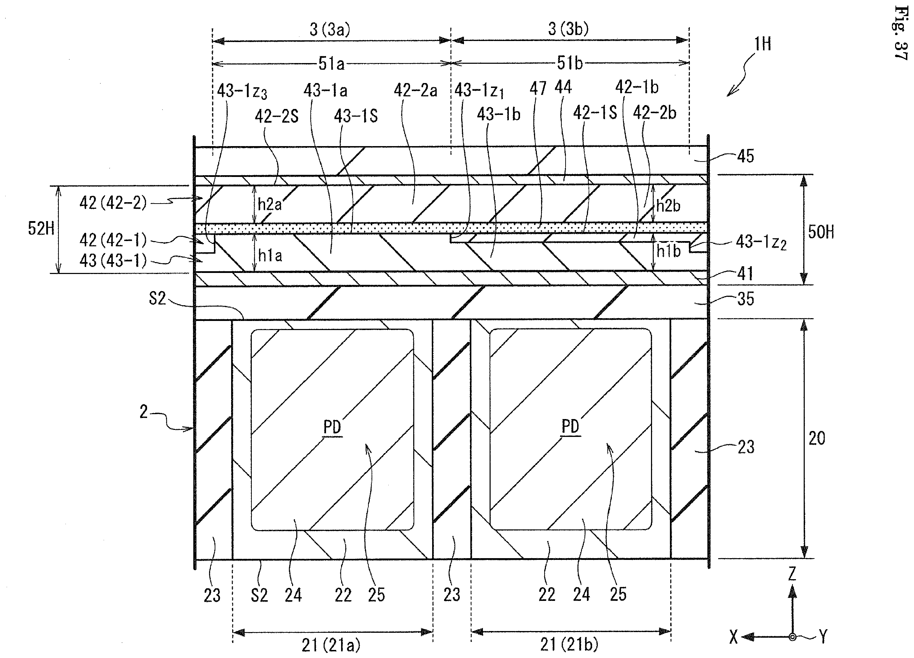

   Fig. 37 is a longitudinal cross-sectional view illustrating two pixels adjacent to each other in Fig. 36.
[Fig. 38]

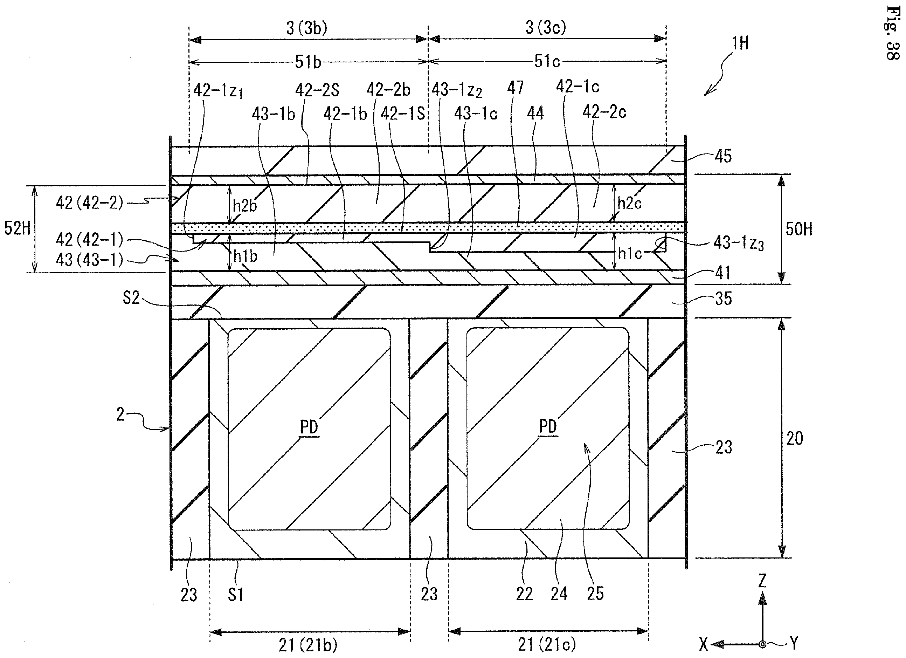

   Fig. 38 is a longitudinal cross-sectional view illustrating two pixels adjacent to each other in Fig. 36.
[Fig. 39]

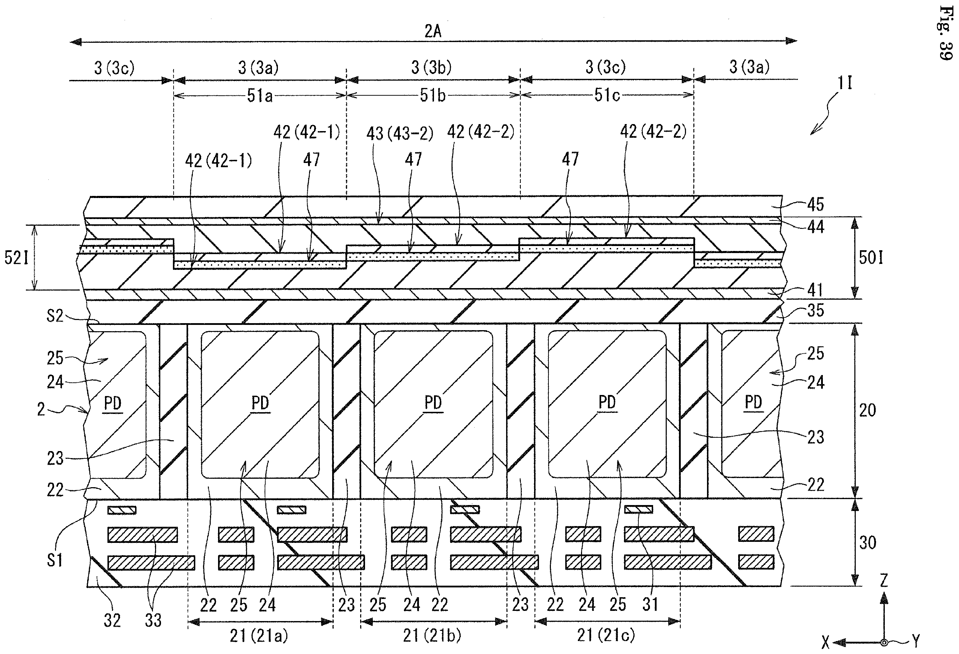

   Fig. 39 is a longitudinal cross-sectional view schematically illustrating the longitudinal cross-sectional structure of the solid-state image capturing device according to a ninth embodiment of the present technique.
[Fig. 40]

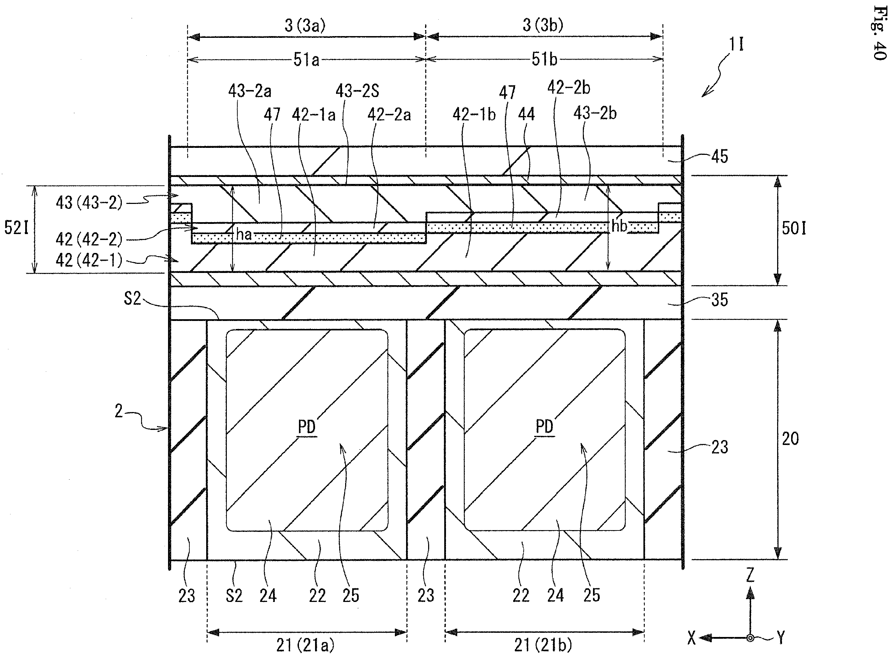

   Fig. 40 is a longitudinal cross-sectional view illustrating two pixels adjacent to each other in Fig. 39.
[Fig. 41]

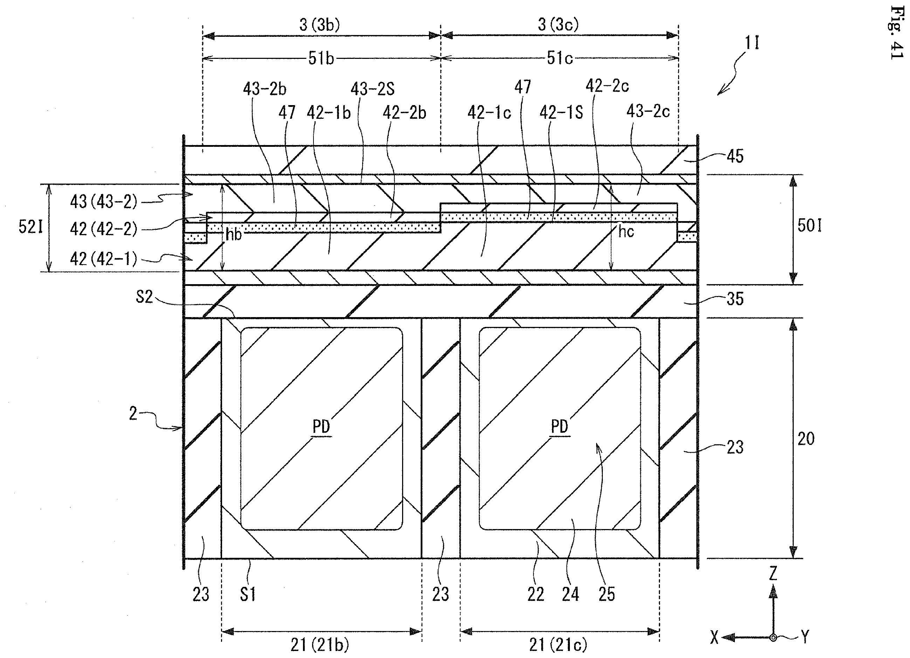

   Fig. 41 is a longitudinal cross-sectional view illustrating two pixels adjacent to each other in Fig. 39.
[Fig. 42]

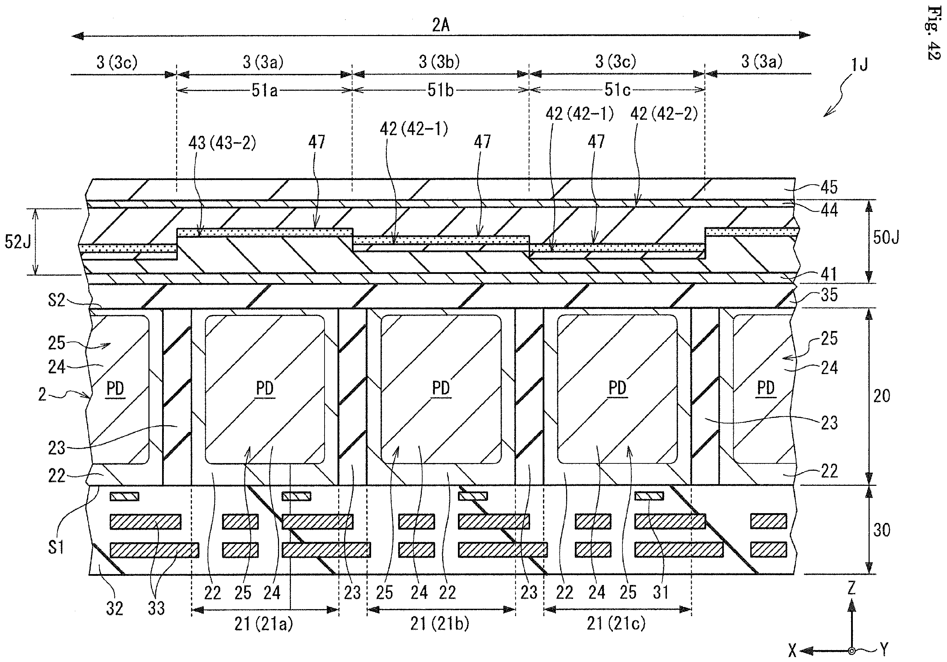

   Fig. 42 is a longitudinal cross-sectional view schematically illustrating the longitudinal cross-sectional structure of the solid-state image capturing device according to a tenth embodiment of the present technique.
[Fig. 43]

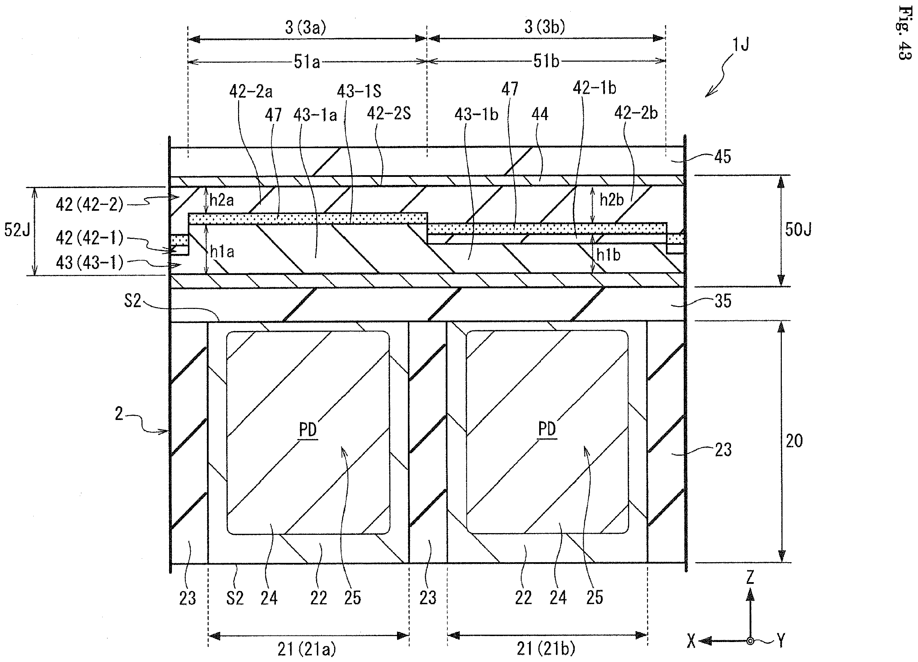

   Fig. 43 is a longitudinal cross-sectional view illustrating two pixels adjacent to each other in Fig. 42.
[Fig. 44]

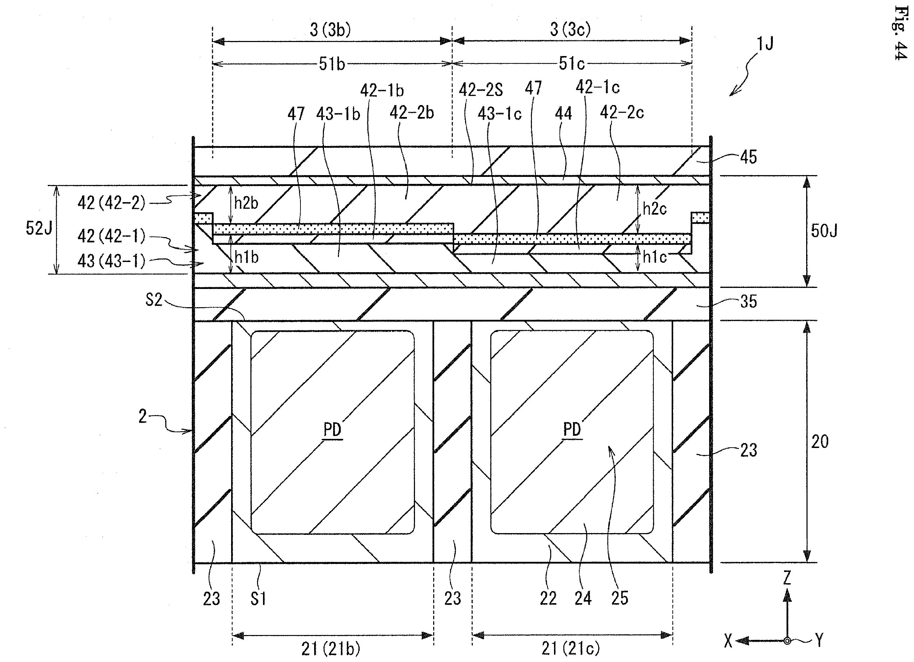

   Fig. 44 is a longitudinal cross-sectional view illustrating two pixels adjacent to each other in Fig. 42.
[Fig. 45]

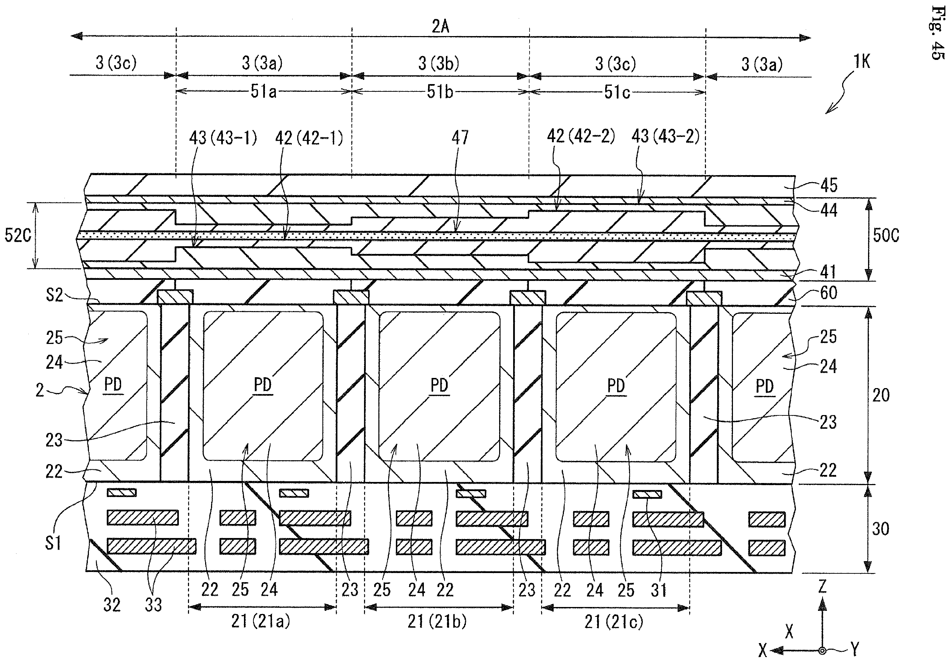

   Fig. 45 is a longitudinal cross-sectional view schematically illustrating the longitudinal cross-sectional structure of the solid-state image capturing device according to an eleventh embodiment of the present technique.
[Fig. 46]

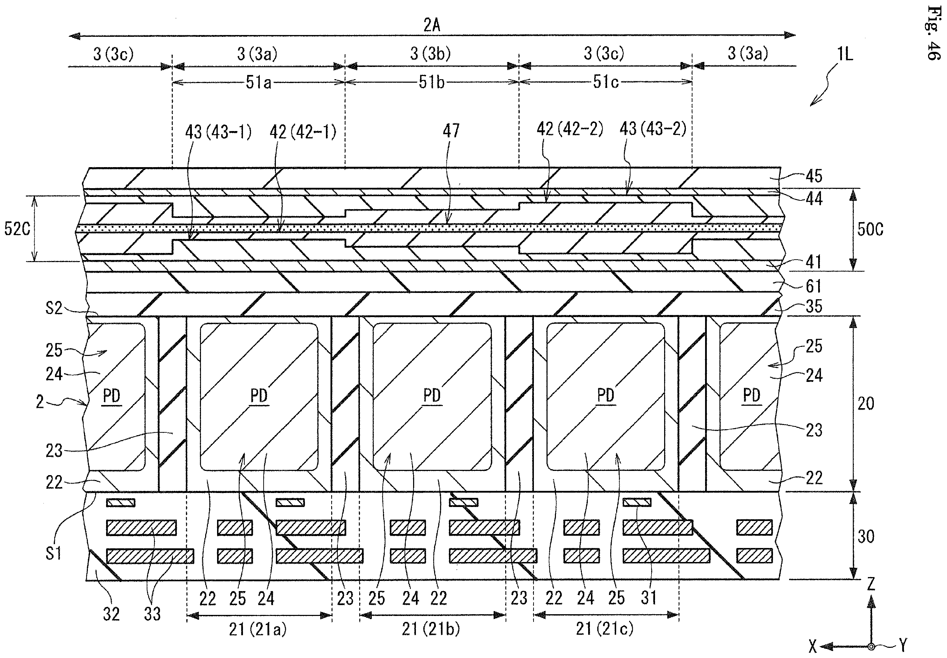

   Fig. 46 is a longitudinal cross-sectional view schematically illustrating the longitudinal cross-sectional structure of the solid-state image capturing device according to a twelfth embodiment of the present technique.
[Fig. 47]

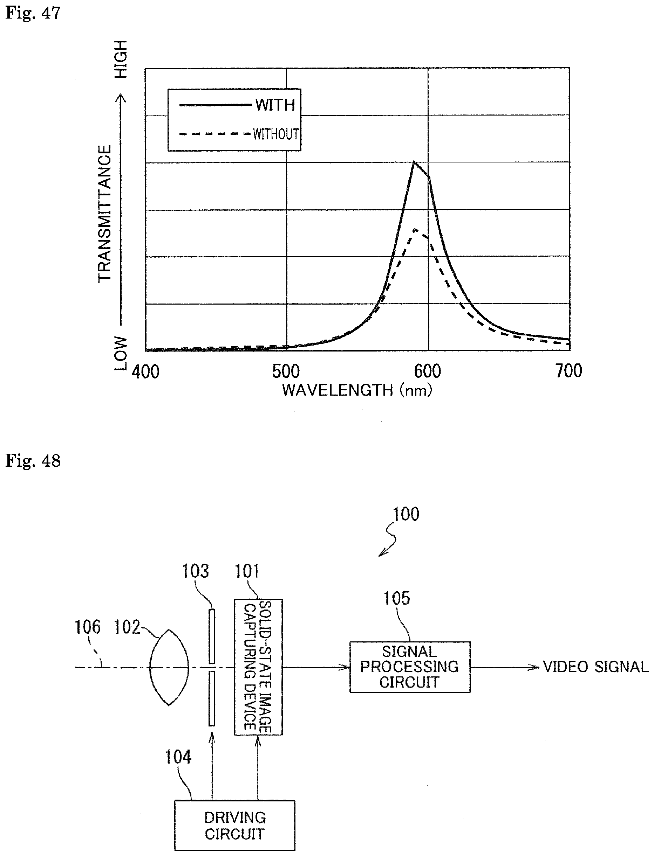

   Fig. 47 is a diagram illustrating a correlation between transmittance and the presence or absence of an antireflection layer.
[Fig. 48]
   Fig. 48 is a diagram illustrating an example of the configuration of an electronic device according to a thirteenth embodiment of the present technique.

### [Description of Embodiments]

Embodiments of the present technique will be described hereinafter with reference to the drawings.

In the descriptions of the drawings referred to in the following, identical or similar parts will be given identical or similar reference signs. However, it should be noted that the drawings are schematic, and the relationships between thicknesses and planar dimensions, the ratios of thicknesses of layers, and the like are different from the actual ratios, thicknesses, and the like. Therefore, specific thicknesses and dimensions should be determined in light of the following descriptions.

In addition, it goes without saying that the drawings also include parts having dimensional relationships and ratios different from those in other drawings. Furthermore, the effects described in the present specification are merely exemplary and not intended to be limiting, and other effects may be provided as well.

The following embodiments exemplify devices, methods, and the like for embodying the technical spirit of the present technique, and the configurations are not limited to those described below. In other words, the technical spirit of the present technique can be modified in various ways within the technical scope set forth in the claims.

In addition, it is to be understood that definitions of directions such as "up-down" in the following descriptions are merely definitions provided for the sake of brevity and are not intended to limit the technical spirit of the present technique. For example, it is obvious that when an object is observed after being rotated by 90 degrees, "up-down" is transformed into and interpreted as "left-right", and when an object is observed after being rotated by 180 degrees, "up-down" is interpreted as being inverted.

The following embodiments describe a case where as the conductivity types of semiconductors, a first conductivity type is p-type and a second conductivity type is n-type. However, the reverse relationship may be selected for the conductivity types, such that the first conductivity type is n-type and the second conductivity type is p-type.

Furthermore, in the following embodiments, a first direction and a second direction orthogonal to each other in a two-dimensional plane are defined as an X direction and a Y direction, respectively, and a third direction orthogonal to the two-dimensional plane is defined as an X direction. Finally, in the following embodiments, a thickness direction of a semiconductor layer 20 (described later) will be defined as being a Z direction.

### [First Embodiment]

A first embodiment will describe an example in which the present technique is applied to a solid-state image capturing device that is a backside-illuminated Complementary Metal Oxide Semiconductor (CMOS) image sensor, serving as a light detection device.

### <<Overall Configuration of Solid-State Image Capturing Device>>

The overall configuration of a solid-state image capturing device 1A will be described first. As illustrated in Fig. 1, the solid-state image capturing device 1A according to the first embodiment of the present technique is constituted mainly by a semiconductor chip 2, which has a square two-dimensional planar shape when viewed in plan view. In other words, the solid-state image capturing device 1A is installed on the semiconductor chip 2, and the semiconductor chip 2 can therefore be regarded as the solid-state image capturing device 1A. As illustrated in Fig. 48, the solid-state image capturing device 1A (101) takes in image light from a subject (incident light 106) through an optical lens 102, converts the amount of incident light 106 formed on an image capturing plane into electrical signals on a pixel-by-pixel basis, and outputs the electrical signals as pixel signals.

As illustrated in Fig. 1, the semiconductor chip 2 on which the solid-state image capturing device 1A is installed includes a square pixel array part 2A provided in a central area and a peripheral part 2B provided outside the pixel array part 2A so as to surround the pixel array part 2A, in the two-dimensional plane including the X direction and the Y direction orthogonal to each other. The semiconductor chip 2 is formed by subdividing a semiconductor wafer, which includes the semiconductor layer 20 (described later), into each of chip formation regions in a manufacturing process. Accordingly, the configuration of the solid-state image capturing device 1A described below is generally the same in the wafer state prior to subdividing the semiconductor wafer. In other words, the present technique can be applied in both a semiconductor chip state and a semiconductor wafer state.

The pixel array part 2Ais a light-receiving surface that receives the light focused by the optical lens (optical system) 102 illustrated in Fig. 48, for example. In the pixel array part 2A, a plurality of pixels (sensor pixels) 3 are arranged in a matrix in the two-dimensional plane including the X direction and the Y direction. In other words, the pixels 3 are arranged in a repeating manner in both the X direction and the Y direction, which are orthogonal to each other in the two-dimensional plane. As illustrated in Fig. 4, the plurality of pixels 3 include a pixel (sensor pixel) 3a, a pixel (sensor pixel) 3b, and a pixel (sensor pixel) 3c.

As illustrated in Fig. 1, a plurality of bonding pads 14 are disposed in the peripheral part 2B. Each of the plurality of bonding pads 14, for example, is disposed along one of the four sides of the two-dimensional plane of the semiconductor chip 2. Each of the plurality of bonding pads 14 functions as an input/output terminal that electrically connects the semiconductor chip 2 to an external device.

### <Logic Circuit>

The semiconductor chip 2 includes a logic circuit 13, which is illustrated in Fig. 2. As illustrated in Fig. 2, the logic circuit 13 includes a vertical drive circuit 4, column signal processing circuits 5, a horizontal drive circuit 6, an output circuit 7, a control circuit 8, and the like. The logic circuit 13 is constituted by a Complementary MOS (CMOS) circuit having an n-channel conductive Metal Oxide Semiconductor Field Effect Transistor (MOSFET) and a p-channel conductive MOSFET as field effect transistors, for example.

The vertical drive circuit 4 is constituted by a shift register, for example. The vertical drive circuit 4 selects a desired pixel drive line 10 in sequence, supplies a pulse for driving the pixels 3 to the selected pixel drive line 10, and drives respective pixels 3 in unit of rows. In other words, the vertical drive circuit 4 sequentially performs selective scanning of the pixels 3 of the pixel array part 2A in units of rows in a vertical direction, and supplies pixel signals from the pixels 3, which are based on signal charges generated in accordance with the amount of light received by photoelectric conversion units (photoelectric conversion elements) of the pixels 3, to the column signal processing circuits 5 through vertical signal lines 11.

The column signal processing circuits 5 are provided, for example, for corresponding columns of pixels 3, and perform signal processing such as noise removal for each pixel column on a signal output from the pixels 3 corresponding to one row. For example, the column signal processing circuit 5 performs signal processing such as correlated double sampling (CDS) and analog-digital (AD) conversion for removing pixel-specific fixed pattern noise.

The horizontal drive circuit 6 is constituted by a shift register, for example. The horizontal drive circuit 6 sequentially selects each column signal processing circuit 5 by sequentially outputting a horizontal scanning pulse to the column signal processing circuit 5, and outputs a pixel signal on which signal processing has been performed from each column signal processing circuit 5 to a horizontal signal line 12.

The output circuit 7 performs signal processing on the pixel signals sequentially supplied from the respective column signal processing circuits 5 through the horizontal signal line 12, and outputs the resulting pixel signals. Examples of the signal processing which may be used include buffering, black level adjustment, column variation correction, various types of digital signal processing, and the like, for example.

The control circuit 8 generates a clock signal or a control signal as a reference for operations of the vertical drive circuit 4, the column signal processing circuit 5, the horizontal drive circuit 6, and the like based on a vertical synchronization signal, a horizontal synchronization signal, and a master clock signal. The control circuit 8 then outputs the generated clock signal or control signal to the vertical drive circuit 4, the column signal processing circuits 5, the horizontal drive circuit 6, and the like.

### <Circuit Configuration of Pixel>

As illustrated in Fig. 3, each pixel 3 of the plurality of pixels 3 includes a photoelectric conversion region 21 and a readout circuit 15. The photoelectric conversion region 21 includes a photoelectric conversion unit 25, a transfer transistor TR serving as a pixel transistor, and a floating diffusion region FD serving as a charge holding unit. The readout circuit 15 is electrically connected to the floating diffusion region FD of the photoelectric conversion region 21. Although the first embodiment will describe a circuit configuration in which one readout circuit 15 is assigned to one pixel 3 as an example, the configuration is not limited thereto, and a circuit configuration in which one readout circuit 15 is shared by a plurality of pixels 3 may be used.

The photoelectric conversion unit 25 illustrated in Fig. 3 is constituted by, for example, a pn junction photodiode (PD), and generates a signal charge according to an amount of light received. The photoelectric conversion unit 25 is electrically connected to the source region of the transfer transistor TR on the cathode side, and to a reference potential line (e.g., ground) on the anode side.

The transfer transistor TR illustrated in Fig. 3 transfers the signal charge resulting from the photoelectric conversion by the photoelectric conversion unit 25 to the floating diffusion region FD. The source region of a transfer transistor RTL is electrically connected to the cathode side of the photoelectric conversion unit 25, and the drain region of the transfer transistor TR is electrically connected to the floating diffusion region FD. The gate electrode of the transfer transistor TR is electrically connected to a transfer transistor drive line of the pixel drive line 10 (see Fig. 2).

The floating diffusion region FD illustrated in Fig. 3 temporarily holds (accumulates) the signal charge transferred from the photoelectric conversion unit 25 through the transfer transistor TR.

The photoelectric conversion region 21 including the photoelectric conversion unit 25, the transfer transistor TR, and the floating diffusion region FD is provided in the semiconductor layer 20 (described later; see Fig. 4).

The readout circuit 15 illustrated in Fig. 3 reads out the signal charge held in the floating diffusion region FD and outputs a pixel signal based on this signal charge. Although not limited thereto, the readout circuit 15 includes, for example, an amplifying transistor AMP, a selection transistor SEL, and a reset transistor RST as pixel transistors. Each of the transistors (AMP, SEL, and RST) and the transfer transistor TR described above is constituted by a MOSFET having, for example, a gate insulating film formed from a silicon oxide (SiO₂) film, a gate electrode, and a pair of main electrode regions functioning as a source region and a drain region, as a field effect transistor. The transistor may be a metal insulator semiconductor FET (MISFET) whose gate insulating film is a silicon nitride (a Si₃N₄) film or a layered film including a silicon nitride film, a silicon oxide film, or the like.

As illustrated in Fig. 3, the amplifying transistor AMP has a source region electrically connected to a drain region of the selection transistor SEL, and a drain region electrically connected to a power source line Vdd and a drain region of the reset transistor RST. The gate electrode of the amplifying transistor AMP is electrically connected to the floating diffusion region FD and a source region of the reset transistor RST.

The selection transistor SEL has a source electrically connected to the vertical signal line 11 (VSL), and a drain region electrically connected to a source region of the amplifying transistor AMP. The gate electrode of the selection transistor SEL is electrically connected to a selection transistor drive line of the pixel drive line 10 (see Fig. 2).

The reset transistor RST has a source region electrically connected to the floating diffusion region FD and the gate electrode of the amplifying transistor AMP, and a drain region electrically connected to the power source line Vdd and the drain region of the amplifying transistor AMP. The gate electrode of the reset transistor RST is electrically connected to a reset transistor drive line of the pixel drive line 10 (see Fig. 2).

When the transfer transistor TR is turned on, the transfer transistor TR transfers the signal charge generated by the photoelectric conversion unit 25 to the floating diffusion region FD.

When the reset transistor RST is turned on, the reset transistor RST resets the potential of the floating diffusion region FD (the signal charge) to the potential of the power source line Vdd. The selection transistor SEL controls the timing at which the pixel signal is output from the readout circuit 15.

The amplifying transistor AMP generates, as the pixel signal, a signal at a voltage based on the level of the signal charge held in the floating diffusion region FD. The amplifying transistor AMP constitutes a source-follower amplifier, and outputs a pixel signal at a voltage based on the level of the signal charge generated by the photoelectric conversion unit 25. When the selection transistor SEL is turned on, the amplifying transistor AMP amplifies the potential of the floating diffusion region FD and outputs a voltage based on that potential to the column signal processing circuit 5 over the vertical signal line 11 (VSL).

During the operation of the solid-state image capturing device 1A according to the first embodiment, the signal charge generated by the photoelectric conversion unit 25 of the pixel 3 is held (accumulated) in the floating diffusion region FD via the transfer transistor TR of the pixel 3. The signal charge held in the floating diffusion region FD is then read out by the readout circuit 15 and applied to the gate electrode of the amplifying transistor AMP of the readout circuit 15. A horizontal line selection control signal is provided from the vertical shift register to the gate electrode of the selection transistor SEL of the readout circuit 15. Then, when the selection control signal is set to high (H) level, the selection transistor SEL becomes conductive, and a current corresponding to the potential of the floating diffusion region FD, amplified by the amplifying transistor AMP, flows in the vertical signal line 11. Additionally, when a reset control signal applied to the gate electrode of the reset transistor RST of the readout circuit 15 is set to high (H) level, the reset transistor RST becomes conductive and resets the signal charge accumulated in the floating diffusion region FD.

Note that the selection transistor SEL may be omitted as necessary. When the selection transistor SEL is omitted, the source region of the amplifying transistor AMP is electrically connected to the vertical signal line 11 (VSL).

### «Specific Configuration of Solid-State Image Capturing Device»

The specific configuration of the semiconductor chip 2 (the solid-state image capturing device 1A) will be described next with reference to Figs. 4 to 6.

Fig. 4 is a longitudinal cross-sectional view schematically illustrating the longitudinal cross-sectional structure of the pixel array part 2A of the solid-state image capturing device 1A, and illustrates five pixels as an example. Fig. 5 is a longitudinal cross-sectional view illustrating two pixels 3 adjacent to each other in Fig. 4, and illustrates pixels 3a and 3b, which are the second and third pixels of the five pixels 3 in Fig. 4 counted from the left side, as an example. Fig. 6 is a longitudinal cross-sectional view illustrating two pixels 3 adjacent to each other in Fig. 4, and illustrates pixels 3b and 3c, which are the third and fourth pixels of the five pixels 3 in Fig. 4 counted from the left side, as an example.

### <Semiconductor Chip>

As illustrated in Fig. 4, the semiconductor chip 2 includes the semiconductor layer 20, which has a first surface S1 and a second surface S2 located on opposite sides from each other in the thickness direction (the Z direction), and provided with the photoelectric conversion region 21 for each pixel 3; and an optical filter layer 40 provided on a light incidence surface side, which is the second surface S2 side of the semiconductor layer 20. The semiconductor chip 2 further includes an insulating layer 35 provided between the semiconductor layer 20 and the optical filter layer 40, and an insulating layer 45 provided on the side of the optical filter layer 40 opposite from the side on which the semiconductor layer 20 is located. The semiconductor chip 2 further includes a multilayer wiring layer 30 disposed on the first surface S1 side of the semiconductor layer 20, and a support substrate 34 provided on the side of the multilayer wiring layer 30 opposite from the side on which the semiconductor layer 20 is located.

### <Semiconductor Layer>

As illustrated in Fig. 4, the semiconductor layer 20 is provided with an isolation region 23 extending in the thickness direction of the semiconductor layer 20 (the Z direction), and a plurality of the photoelectric conversion regions 21 partitioned by the isolation region 23 for each pixel 3. The photoelectric conversion regions 21 among the plurality of photoelectric conversion regions 21 are, when viewed in plan view, adjacent to each other with the isolation region 23 located therebetween.

The isolation region 23 extends from the first surface S1 side to the second surface S2 side of the semiconductor layer 20, and electrically and optically separates the photoelectric conversion regions 21 adjacent to each other. Although not limited thereto, the isolation region 23 has an isolation structure in which an insulating film is embedded in a trench part of the semiconductor layer 20, for example.

A Si substrate, a SiGe substrate, an InGaAs substrate, or the like can be used as the semiconductor layer 20. In the first embodiment, a p-type semiconductor substrate constituted by monocrystalline silicon, for example, is used as the semiconductor layer 20.

Here, the first surface S1 of the semiconductor layer 20 may also be referred to as a "device formation surface" or a "main surface", and the second surface S2 side may be referred to as the "light incidence surface" or a "rear surface". The solid-state image capturing device 1A according to the first embodiment uses the photoelectric conversion region 21 (photoelectric conversion unit 25) provided in the semiconductor layer 20 to photoelectrically convert light incident from the second surface (light incidence surface, rear surface) S2 side of the semiconductor layer 20.

"Plan view" refers to a view from a direction parallel to the thickness direction of the semiconductor layer 20 (the Z direction). "Cross-sectional view" refers to a cross-section parallel to the thickness direction of the semiconductor layer 20 (the Z direction) viewed from a direction orthogonal to the thickness direction of the semiconductor layer 20 (the Z direction) (that is, viewed from the X direction or the Y direction). The photoelectric conversion region 21 can also be referred to as a "photoelectric conversion cell".

### <Photoelectric Conversion Region>

As illustrated in Fig. 4, each photoelectric conversion region 21 of the plurality of photoelectric conversion regions (photoelectric conversion cells) 21 includes a p-type well region 22 provided in the semiconductor layer 20, an n-type semiconductor region 24 provided in the p-type well region 22, and the photoelectric conversion unit 25 described above. Although not illustrated in Fig. 4, each photoelectric conversion region 21 includes the floating diffusion region FD and the transfer transistor TR described above, as well as the pixel transistors (AMP, SEL, and RST) included in the readout circuit 15 described above. Note also that Fig. 4 illustrates a gate electrode 31 of the transfer transistor TR.

The floating diffusion region FD, the transfer transistor TR, and the pixel transistors (AMP, SEL, and RST) are provided on the first surface S1 side of the semiconductor layer 20.

As illustrated in Fig. 4, the p-type well region 22 extends from the first surface S1 side to the second surface S2 side of the semiconductor layer 20, and is constituted by a p-type semiconductor region, for example.

Here, the photoelectric conversion unit 25 is mainly constituted by the n-type semiconductor region 24, and is configured as a pn junction photodiode (PD) by the p-type well region 22 and the n-type semiconductor region 24.

### <Multilayer Wiring Layer>

As illustrated in Fig. 4, the multilayer wiring layer 30 is disposed on the first surface S1 side on the side of the semiconductor layer 20 opposite from the side on which the light incidence surface (the second surface S2) is located, and is configured such that a plurality of wiring layers each including wiring 33 are stacked with an interlayer insulating film 32 provided therebetween. The pixel transistors (AMP, SEL, and RST) and the transfer transistor TR of each pixel 3 are driven through the wiring 33 of the multilayer wiring layer 30. Because the multilayer wiring layer 30 is disposed on the side opposite from the side of the semiconductor layer 20 on which the light incidence surface side (the second surface S2 side) is located, the layout of the wiring 33 can be set with freedom.

### <Support Substrate>

The support substrate 34 is disposed on the side of the multilayer wiring layer 30 opposite from the side on which the semiconductor layer 20 is located. The support substrate 34 is a substrate for ensuring the strength of the semiconductor layer 20 in the manufacturing stage of the solid-state image capturing device 1A. For example, a silicon (Si) substrate can be used as the material of the support substrate 34.

### <Insulating Layer>

As illustrated in Fig. 4, the insulating layer 35 is provided between the semiconductor layer 20 and the optical filter layer 40. The insulating layer 35 insulates and isolates the semiconductor layer 20 and the optical filter layer 40. The insulating layer 35 covers the entirety of the light incidence surface side of the semiconductor layer 20 in the pixel array part 2A such that the light incidence surface (second surface S2) side of the semiconductor layer 20 is a flat, even surface. A silicon oxide (SiO₂) film can be used as the insulating layer 35, for example.

### <Optical Filter Layer>

As illustrated in Fig. 4, the optical filter layer 40 includes: a first metal film 41 provided on the second surface S2 side (the light incidence surface side) of the semiconductor layer 20 with the insulating layer 35 located therebetween; a first dielectric film 42 and a second dielectric film 43, which are arranged in the thickness direction (the Z direction) of the semiconductor layer 20 side by side on the side of the first metal film 41 opposite from the side on which the semiconductor layer 20 is located, and which have different refractive indices from each other; and a second metal film 44 provided on the side of the first and second dielectric films 42 and 43 opposite from the side on which the first metal film 41 is located. In other words, the optical filter layer 40 has a multilayer structure in which the first dielectric film 42 and the second dielectric film 43, which have different refractive indices, are interposed between the two metal films (41 and 44).

In the first embodiment, the first dielectric film 42 is provided further on the first metal film 41 side than the second dielectric film 43, and has a greater (higher) refractive index than the second dielectric film 43.

Each of the first metal film 41, the first dielectric film 42, the second dielectric film 43, and the second metal film 44 is provided across a plurality of pixels 3. Although not limited thereto, Fig. 4 illustrates five pixels 3 (3c, 3a, 3b, 3c, and 3a) as an example, and the films are provided across the five pixels 3. Furthermore, although not illustrated in detail, in the first embodiment, each of the first metal film 41, the first dielectric film 42, the second dielectric film 43, and the second metal film 44 is provided across the entirety of the pixel array part 2A, for example. Although not limited thereto, the first dielectric film 42 and the second dielectric film 43 are provided so as to be in contact with each other, for example.

As illustrated in Figs. 5 and 6, the first dielectric film 42 includes: a first part 42a which overlaps with a photoelectric conversion region 21a of the pixel 3a in plan view; a second part 42b which overlaps with a photoelectric conversion region 21b of the pixel 3b in plan view and which is thicker than the first part 42a; and a third part 42c which overlaps with a photoelectric conversion region 21c of the pixel 3c in plan view and which is thicker than the second part 42b. In other words, the thickness of the first dielectric film 42 is different for each of the pixels 3a, 3b, and 3c (the photoelectric conversion regions 21a, 21b, and 21c), and the thickness increases in stages in order of the pixels 3a, 3b, and 3c.

As illustrated in Figs. 5 and 6, the second dielectric film 43 includes: a first part 43a which overlaps with the first part 42a of the first dielectric film 42 in plan view; a second part 43b which overlaps with the second part 42b of the first dielectric film 42 in plan view and which is thinner than the first part 43a of the second dielectric film 43; and a third part 43c which overlaps with the third part 42c of the first dielectric film 42 in plan view and which is thinner than the second part 43b of the second dielectric film 43. In other words, the thickness of the second dielectric film 43 is different for each of the pixels 3a, 3b, and 3c (the photoelectric conversion regions 21a, 21b, and 21c), and, opposite from the first dielectric film 42, the thickness decreases in stages in order of the pixels 3a, 3b, and 3c.

As illustrated in Figs. 5 and 6, the optical filter layer 40 includes a first filter part 40a which overlaps with the photoelectric conversion region 21a of the pixel 3a in plan view, a second filter part 40b which overlaps with the photoelectric conversion region 21b of the pixel 3b in plan view, and a third filter part 40c which overlaps with the photoelectric conversion region 21c of the pixel 3c in plan view.

The first filter part 40a includes the first parts 42a and 43a of the first and second dielectric films 42 and 43, respectively, between the first metal film 41 and the second metal film 44. The second filter part 40b includes the second parts 42b and 43b of the first and second dielectric films 42 and 43, respectively, between the first metal film 41 and the second metal film 44. The third filter part 40c includes the third parts 42c and 43c of the first and second dielectric films 42 and 43, respectively, between the first metal film 41 and the second metal film 44.

The ratio of the thicknesses of the first dielectric film 42 and the second dielectric film 43 is different in each of the first filter part 40a, the second filter part 40b, and the third filter part 40c.

For example, although not limited thereto, the ratio of the thicknesses of the first dielectric film 42 and the second dielectric film 43 is 1:3 in the first filter part 40a, 2:2 in the second filter part 40b, and 3:1 in the third filter part 40c. A total thickness h₁ of the first dielectric film 42 and the second dielectric film 43 in the first filter part 40a, a total thickness h₂ of the first dielectric film 42 and the second dielectric film 43 in the second filter part 40b, and a total thickness h₃ of the first dielectric film 42 and the second dielectric film 43 in the third filter part 40c are designed to be the same. In other words, the total thickness of the first dielectric film 42 and the second dielectric film 43 is generally the same in the first filter part 40a (h₁), the second filter part 40b (h₂), and the third filter part 40c (h₃).

As illustrated in Figs. 5 and 6, a surface layer part 42S on the second dielectric film 43 side of the first dielectric film 42 has a step part 42z₁ produced by the difference in the thicknesses of the first part 42a and the second part 42b of the first dielectric film 42, a step part 42z₂ produced by the difference in the thicknesses of the second part 42b and the third part 42c of the first dielectric film 42, and a step part 42z₃ produced by the difference in the thicknesses of the third part 42c and the first part 42a of the first dielectric film 42. In other words, the surface layer part 42S of the first dielectric film 42 has step parts (42z₁, 42z₂, and 42z₃) between the pixels 3 adjacent to each other.

On the other hand, a surface layer part 43S on the second metal film 44 side of the second dielectric film 43 is flat across the pixels 3 adjacent to each other. In a manufacturing process (described later), the parts having different thicknesses (42a, 42b, and 42c) are formed by etching the surface layer part 42S side of the first dielectric film 42 to form the step parts (42z₁, 42z₂, and 42z₃) on the surface layer part 42S side. The second dielectric film 43 covers the entirety of the first dielectric film 42 across the pixels 3 adjacent to each other such that the steps produced by the differences in the thickness of the first dielectric film 42 in the lower layer are embedded and the surface layer part 43s on the second metal film 44 side is a flat, even surface.

As described above, the first dielectric film 42 is provided further on the first metal film 41 side than the second dielectric film 43, and the refractive index thereof greater than the refractive index of the second dielectric film 43.

The first dielectric film 42 is constituted by an inorganic film containing any one material among titanium oxide (TiO₂), tantalum oxide (Ta₂O₅), silicon nitride (SiN), or hafnium oxide (HfO₂), for example.

The second dielectric film 43 is also constituted by an inorganic film containing any one material among silicon oxide (SiO₂) or silicon oxynitride (SiON), for example.

As illustrated in Figs. 5 and 6, each of the first metal film 41 and the second metal film 44 is provided across the pixels 3 adjacent to each other. Each of the first metal film 41 and the second metal film 43 is constituted by a film containing any one material among aluminum (Al), silver (Ag), gold (Au), copper (Cu), chromium (Cr), or tungsten (W), for example. The first metal film 41 is thicker than the second metal film 44.

As illustrated in Figs. 5 and 6, the insulating layer 45 is provided on the side of the second metal film 44 opposite from the side on which the second dielectric film 43 is located. The insulating layer 45 is provided across the pixels 3 adjacent to each other and covers the second metal film 44. The insulating layer 45 prevents incident light from being reflected at the second metal film 44, and also protects the optical filter layer 40. The insulating layer 45 is constituted by a silicon oxide film having excellent light transmittance, for example.

### <<Method for Manufacturing Solid-State Image Capturing Device>>

A method for manufacturing the solid-state image capturing device 1A according to the first embodiment will be described next with reference to Figs. 7A to 7L. A case will be described where in the manufacturing method according to the first embodiment, the first dielectric film is formed before the second dielectric film.

First, as illustrated in Fig. 7A, the semiconductor layer 20 is prepared. A monocrystalline silicon substrate is used as the semiconductor layer 20, for example.

Next, as illustrated in Fig. 7A, the p-type well region 22, constituted by a p-type semiconductor region, is formed on the first surface S1 side of the semiconductor layer 20.

Next, as illustrated in Fig. 7B, the plurality of photoelectric conversion regions 21 segmented by the isolation region 23 extending from the first surface S1 side to the second surface S2 side of the semiconductor layer 20 are formed in the semiconductor layer 20, after which the n-type semiconductor region 24 is formed within the p-type well region 22 of each photoelectric conversion region 21.

In this step, the photoelectric conversion unit 25 is formed as a pn junction photodiode (PD) by the p-type well region 22 and the n-type semiconductor region 24.

Next, although not illustrated, the floating diffusion region FD, the transfer transistor TR, and the pixel transistors (AMP, SEL, and RST) included in the readout circuit 15 described above are formed on the first surface S1 side of the semiconductor layer 20.

Next, as illustrated in Fig. 7C, the multilayer wiring layer 30, in which a plurality of wiring layers each including the wiring 33 are stacked with the interlayer insulating film 32 provided therebetween, is formed on the first surface S1 side of the semiconductor layer 20.

Next, the support substrate 34 is joined to the side of the multilayer wiring layer 30 opposite from the side on which the semiconductor layer 20 is located. Then, as illustrated in Fig. 7D, the second surface (light incidence surface) S2 side of the semiconductor layer 20 is polished through CMP or the like until the isolation region 23 is exposed, which reduces the thickness of the semiconductor layer 20.

Next, as illustrated in Fig. 7E, the insulating layer (a planarization layer) 35 is formed on the second surface S2 side of the semiconductor layer 20. The insulating layer 35 can be formed by, for example, forming a silicon oxide film on the second surface S2 side of the semiconductor layer 20 through CVD, and then polishing through CMP or etching back the surface of the silicon oxide film. The insulating layer 35 is formed across the photoelectric conversion regions 21 adjacent to each other (21a, 21b, and 21c), and covers the entire first surface S1 side of the semiconductor layer 20.

Next, as illustrated in Fig. 7F, the first metal film 41 is formed on the side of the insulating layer 35 opposite from the side on which the semiconductor layer 20 is located. The first metal film 41 can be formed by forming a film containing any one of aluminum, silver (Ag), copper (Cu), gold (Au), chromium (Cr), or tungsten (W) through a well-known sputtering technique, atomic layer deposition (ALD), or the like, for example. The first metal film 41 is formed across the photoelectric conversion regions 21 adjacent to each other (21a, 21b, and 21c).

Next, as illustrated in Fig. 7G, the first dielectric film 42 is formed on the side of the first metal film 41 opposite from the side on which the semiconductor layer 20 is located. The first dielectric film 42 can be formed by forming an inorganic film containing any one material of titanium oxide (TiO₂), tantalum oxide (Ta₂O₅), silicon nitride (SiN), or hafnium oxide (HfO₂) through a well-known CVD technique, ALD, or the like, for example. The first dielectric film 42 is formed across the photoelectric conversion regions 21 adjacent to each other (21a, 21b, and 21c).

Next, using well-known photolithography and dry etching techniques, the first dielectric film 42 overlapping with the photoelectric conversion region 21a in plan view is selectively etched to form the first part 42a, which is thinner than the first dielectric film 42 overlapping with the photoelectric conversion regions 21b and 21c in plan view, as illustrated in Fig. 7H.

In this step, a step part is formed by the difference in the thickness between the first part 42a and the parts of the first dielectric film 42 aside from the first part.

Next, using well-known photolithography and dry etching techniques, the first dielectric film 42 overlapping with the photoelectric conversion region 21b in plan view is selectively etched to form the second part 42b, which is thinner than the first dielectric film 42 overlapping with the photoelectric conversion region 21c and thicker than the first part 42a in plan view, as illustrated in Fig. 7I.

In this step, by forming the second part 42b, the remaining first dielectric film 42 overlapping with the photoelectric conversion region 21c in plan view becomes the third part 42c, which is thicker than the second part 42b.

The first dielectric film 42 having the first part 42a, the second part 42b, and the third part 42c, which have different thicknesses, are formed in this step. The step part 42z₁ produced by the difference in the thicknesses of the first part 42a and the second part 42b, the step part 42z₂ produced by the difference in the thicknesses of the second part 42b and the third part 42c, and the step part 42z₃ produced by the difference in the thicknesses of the third part 42c and the first part 42a are also formed in the surface layer part 42S of the first dielectric film 42 (see Figs. 5 and 6).

Next, as illustrated in Fig. 7J, the second dielectric film 43, which has a refractive index different from that of the first dielectric film 42, is formed on the side of the first dielectric film 42 opposite from the side on which the first metal film 41 is located. In the first embodiment, the second dielectric film 43 having a smaller (lower) refractive index than that of the first dielectric film 42 is formed. The second dielectric film 43 can be formed by forming, through CVD, an inorganic film containing any one material of silicon oxide (SiO₂) or silicon oxynitride (SiON), for example, on the side of the first dielectric film 42 opposite from the side on which the first metal film 41 is located, and then polishing through CMP or etching back the surface of the film. The second dielectric film 43 is formed across the photoelectric conversion regions 21 adjacent to each other (21a, 21b, and 21c).

In this step, the steps produced by the differences in the thickness of the first dielectric film 42 in the lower layer are embedded in the second dielectric film 43, and the surface layer part 43S is flattened.

Additionally, in this step, the second dielectric film 43 takes on a configuration including: the first part 43a which overlaps with the first part 42a of the first dielectric film 42 in plan view; the second part 43b which overlaps with the second part 42b of the first dielectric film 42 in plan view and which is thinner than the first part 43a; and the third part 43c which overlaps with the third part 42c of the first dielectric film 42 in plan view and which is thinner than the second part 43b.

Additionally, in this step, the parts are formed such that the total thickness h₁ of the first parts 42a and 43a of the first and second dielectric films 42 and 43, the total thickness h₂ of the second parts 42b and 43b of the first and second dielectric films 42 and 43, and the total thickness h₃ of the third parts 42c and 43c of the first and second dielectric films 42 and 43 are generally the same.

Next, as illustrated in Fig. 7K, the second metal film 44, which is thinner than the first metal film 41, is formed on the side of the second dielectric film 43 opposite from the side on which the first dielectric film 42 is located. The second metal film 44 can be formed by forming a film containing any one of aluminum, silver (Ag), copper (Cu), gold (Au), chromium (Cr), or tungsten (W) through a well-known sputtering technique, ALD, or the like, for example. The second metal film 44 is formed across the photoelectric conversion regions 21 adjacent to each other (21a, 21b, and 21c).

In this step, the step parts produced by the differences in the thickness of the first dielectric film 42 in the lower layer are embedded in the second dielectric film 43, and the surface layer part 43S of the second dielectric film 43 is flat across the photoelectric conversion regions 21 (pixels 3) adjacent to each other, which makes it possible to increase the adhesion of the second metal film 44 and suppress peeling of the second metal film 44. The first filter part 40a, which includes the first metal film 41, the first parts 42a and 43a of the first and second dielectric films 42 and 43, respectively, and the second metal film 44, and which overlaps with the photoelectric conversion region 21a in plan view, is formed in this step. The second filter part 40b, which includes the first metal film 41, the second parts 42b and 43b of the first and second dielectric films 42 and 43, respectively, and the second metal film 44, and which overlaps with the photoelectric conversion region 21b in plan view, is formed as well. The third filter part 40c, which includes the first metal film 41, the third parts 42c and 43c of the first and second dielectric films 42 and 43, respectively, and the second metal film 44, and which overlaps with the photoelectric conversion region 21c in plan view, is formed as well. The optical filter layer 40 including the first filter part 40a, the second filter part 40b, and the third filter part 40c is formed on the light incidence surface side (the second surface S2 side) of the semiconductor layer 20.

Next, as illustrated in Fig. 7L, the insulating layer 45 covering the optical filter layer 40 is formed on the side of the optical filter layer 40 opposite from the side on which the semiconductor layer 20 is located.

The solid-state image capturing device 1A including the semiconductor layer 20, the multilayer wiring layer 30, the support substrate 34, the insulating layer 35, the optical filter layer 40, the insulating layer 45, and the like is essentially completed by this step.

The solid-state image capturing device 1A is formed in each of a plurality of chip formation regions separated by scribe lines (dicing lines) on a semiconductor substrate called a "semiconductor wafer". The semiconductor chip 2 provided with the solid-state image capturing device 1A illustrated in Figs. 1 to 4 is formed by separating (fragmenting) the plurality of chip formation regions along the scribe lines individually.

### <<Main Effects of First Embodiment>>

The main effects of the first embodiment will be described next.

As described with reference to Figs. 5 and 6, the optical filter layer 40 of the first embodiment can spectrally split the light incident from the second metal film 44 side (incident light) through reflection (resonance) and absorption between the first metal film 41 and the second metal film 44. Furthermore, with the optical filter layer 40 of the first embodiment, changing the ratio of the thicknesses of the first dielectric film 42 and the second dielectric film 43 changes the optical path length, which makes it possible to change the wavelength band of the light passing through the filter parts (40a, 40b, and 40c). As a result, by employing a configuration in which the ratio of the thicknesses of the first dielectric film 42 and the second dielectric film 43 is different in the first filter part 40a, the second filter part 40b, and the third filter part 40c, as in the optical filter layer 40 of the first embodiment, the wavelength bands of the light passing through the first filter part 40a, the second filter part 40b, and the third filter part 40c can be changed. Although the first embodiment describes changing the ratio of the thicknesses of the first dielectric film 42 and the second dielectric film 43 for the three filter parts 40a, 40b, and 40c as an example, the ratio of the thicknesses of the first dielectric film 42 and the second dielectric film 43 can be changed so as to correspond to four or more filter parts, and the incident light can be spectrally split into light in a greater number of wavelength bands. Therefore, the solid-state image capturing device 1A according to the first embodiment makes it possible to achieve spectral separation, where incident light is divided into a variety of wavelength bands.

Additionally, because the wavelength band of transmitted light can be changed by changing the ratio of the thicknesses of the first dielectric film 42 and the second dielectric film 43, the optical filter layer 40 of the first embodiment can achieve spectral separation at a lower cost than a conventional color filter layer which uses a plurality of types of resins to which pigments are added.

Additionally, in the manufacturing process for the optical filter layer 40 of the first embodiment, the step parts produced by the differences in the thickness of the first dielectric film 42 in the lower layer are embedded in the second dielectric film 43, and the surface layer part 43S of the second dielectric film 43 is flat across the photoelectric conversion regions 21 (pixels 3) adjacent to each other, which makes it possible to increase the adhesion of the second metal film 44 and suppress peeling of the second metal film 44. Therefore, the solid-state image capturing device 1A according to the first embodiment makes it possible to achieve spectral separation while suppressing a drop in yield caused by peeling of the second metal film 44.

Additionally, in the optical filter layer 40 of the first embodiment, the first metal film 41 is thicker than the second metal film 44, and thus color mixing can be reduced without changing the transmittance.

Fig. 8Ais a characteristic chart indicating the quantum efficiency QE when the first metal film 41 and the second metal film 44 are the same thickness, and Fig. 8B is a characteristic chart indicating the quantum efficiency QE when the first metal film 41 is thicker than the second metal film 44. In both Figs. 8A and 8B, D1 to D6 represent data obtained when the thickness of the first dielectric film 42, which has the higher refractive index among the first and second dielectric films 42 and 43, is changed sequentially.

As can be seen from Figs. 8A and 8B, setting the first metal film to be thicker than the second metal film results in a narrower spectrum half-value width, which makes it possible to reduce color mixing.

### [Second Embodiment]

A second embodiment of the present technique will be described next with reference to Figs. 9 to 11.

Fig. 9 is a longitudinal cross-sectional view schematically illustrating the longitudinal cross-sectional structure of the pixel array part 2A of a solid-state image capturing device 1B, and illustrates five pixels 3 as an example. Fig. 10 is a longitudinal cross-sectional view illustrating two pixels 3 adjacent to each other in Fig. 9, and illustrates pixels 3a and 3b, which are the second and third pixels of the five pixels 3 in Fig. 9 counted from the left side, as an example. Fig. 11 is a longitudinal cross-sectional view illustrating two pixels 3 adjacent to each other in Fig. 9, and illustrates pixels 3b and 3c, which are the third and fourth pixels of the five pixels 3 in Fig. 9 counted from the left side, as an example.

The solid-state image capturing device 1B according to the second embodiment of the present technique has basically the same configuration as the solid-state image capturing device 1A according to the first embodiment described above, with the exception of the following configurations.

First, as illustrated in Fig. 9, the solid-state image capturing device 1B according to the second embodiment includes an optical filter layer 46 instead of the optical filter layer 40 illustrated in Fig. 4 described above in the first embodiment. The optical filter layer 46 has basically the same configuration as the optical filter layer 40, but the order of arrangement of the first dielectric film 42 and the second dielectric film 43 in the thickness direction of the semiconductor layer 20 is different.

Specifically, in the optical filter layer 40 of the first embodiment described above, the first dielectric film 42 is provided further on the first metal film 41 side than the second dielectric film 43, as illustrated in Fig. 4.

In contrast, in the optical filter layer 46 of the second embodiment, the first dielectric film 42 is provided further on the second metal film 44 side than the second dielectric film 43, as illustrated in Fig. 9. The refractive index of the first dielectric film 42 is greater than the refractive index of the second dielectric film 43.

In other words, the optical filter layer 46 of the second embodiment has a multilayer structure in which the first metal film 41, the second dielectric film 43, the first dielectric film 42, and the second metal film 44 are stacked in that order from the second surface S2 side of the semiconductor layer 20.

Additionally, as illustrated in Figs. 10 and 11, the first part 42a, the second part 42b, and the third part 42c of the first dielectric film 42 are provided further on the second metal film 44 side than the first part 43a, the second part 43b, and the third part 43c of the second dielectric film 43, in the first filter part 40a, the second filter part 40b, and the third filter part 40b of the optical filter layer 46 as well.

Furthermore, as illustrated in Figs. 10 and 11, in the optical filter layer 46 of the second embodiment, the surface layer part 43S on the first dielectric film 42 side of the second dielectric film 43 has a step part 43z₁ produced by the difference in the thicknesses of the first part 43a and the second part 43b of the second dielectric film 43, a step part 43z₂ produced by the difference in the thicknesses of the second part 43b and the third part 43c of the second dielectric film 43, and a step part 43z₃ produced by the difference in the thicknesses of the third part 43c and the first part 43a of the second dielectric film 43. The surface layer part 43S of the second dielectric film 43 has the step parts (43z₁, 43z₂, and 43z₃) between the pixels 3 adjacent to each other.

On the other hand, as illustrated in Figs. 10 and 11, the surface layer part 43S on the second metal film 44 side of the second dielectric film 43 is flat across the pixels 3 adjacent to each other. Because the first dielectric film 42 is formed after the second dielectric film 43 in the manufacturing process, the steps produced by the differences in the thickness of the first dielectric film 42 in the lower layer are embedded in the second dielectric film 43, and a surface layer part 44s on the second metal film 44 side becomes a flat, even surface, covering the entirety of the first dielectric film 42 across the pixels 3 adjacent to each other.

Additionally, in the optical filter layer 46 of the second embodiment, the ratio of the thicknesses of the first dielectric film 42 and the second dielectric film 43 is different in the first filter part 40a, the second filter part 40b, and the third filter part 40c. Furthermore, the total thickness of the first dielectric film 42 and the second dielectric film 43 is generally the same in the first filter part 40a (h₁), the second filter part 40b (h₂), and the third filter part 40c (h₃).

The solid-state image capturing device 1B according to the second embodiment provides effects similar to those of the solid-state image capturing device 1A according to the first embodiment described above.

Although the foregoing first and second embodiments describe a case where two dielectric films 42 and 43 are provided, three or more dielectric films may be provided. In addition, a third dielectric film may be provided between the first dielectric film 42 and the second dielectric film 43. In this case, it is preferable to use a film having a greater refractive index than the second dielectric film 43 as the third dielectric film.

### [Third Embodiment]

In a third embodiment, an optical filter layer 50C including a light absorption film 47 will be described as the optical filter layer.

Fig. 12 is a longitudinal cross-sectional view schematically illustrating the longitudinal cross-sectional structure of the pixel array part 2A of a solid-state image capturing device 1C, and illustrates five pixels 3 as an example.

Fig. 13 is a longitudinal cross-sectional view illustrating two pixels 3 adjacent to each other in Fig. 12, and illustrates pixels 3a and 3b, which are the second and third pixels of the five pixels 3 in Fig. 12 counted from the left side, as an example.

Fig. 14 is a longitudinal cross-sectional view illustrating two pixels 3 adjacent to each other in Fig. 12, and illustrates pixels 3b and 3c, which are the third and fourth pixels of the five pixels 3 in Fig. 12 counted from the left side, as an example.

### «Configuration of Solid-State Image Capturing Device»

The solid-state image capturing device 1C according to the third embodiment of the present technique has basically the same configuration as the solid-state image capturing device 1A according to the first embodiment described above, with the exception of the following configurations.

First, as illustrated in Fig. 12, the solid-state image capturing device 1C according to the third embodiment includes the optical filter layer 50C instead of the optical filter layer 40 illustrated in Fig. 4 described above in the first embodiment. The other configurations are generally the same as those described in the foregoing first embodiment.

### <Optical Filter Layer>

As illustrated in Fig. 12, the optical filter layer 50C of the third embodiment includes: the first metal film 41 provided on the second surface S2 side (the light incidence surface side) of the semiconductor layer 20 with the insulating layer 35 located therebetween; the first dielectric film 42 and the second dielectric film 43, which are arranged in the thickness direction of the semiconductor layer 20 side by side on the side of the first metal film 41 opposite from the side on which the semiconductor layer 20 is located, and which have different refractive indices from each other; the second metal film 44 provided on the side of the first and second dielectric films 42 and 43 opposite from the side on which the first metal film 41 is located; and the light absorption film 47 provided between the first dielectric film 42 and the second dielectric film 43.

The optical filter layer 50C of the third embodiment further includes two first dielectric films 42-1 and 42-2 as the first dielectric film 42, and two second dielectric films 43-1 and 43-2 as the second dielectric film 43. The two first dielectric films 42-1 and 42-2 have a higher (greater) refractive index than the respective two second dielectric films 43-1 and 43-2. The light absorption film 47 has a higher (greater) light absorption rate than the two first dielectric films 42-1 and 42-2 and the two second dielectric films 43-1 and 43-2.

Here, the first dielectric film 42 may be referred to as a high refraction film, and the second dielectric film 43 may be referred to as a low refraction film.

Each of the first dielectric film (high refraction film) 42-1 and the second dielectric film (low refraction film) 43-1 is provided further on the first metal film 41 side than the light absorption film 47. Furthermore, the first dielectric film 42-1 is provided further on the light absorption film 47 side than the second dielectric film 43-1. Likewise, each of the first dielectric film (high refraction film) 42-2 and the second dielectric film (low refraction film) 43-2 is provided further on the second metal film 44 side than the light absorption film 47. Furthermore, the first dielectric film 42-2 is provided further on the light absorption film 47 side than the second dielectric film 43-2. In other words, the optical filter 50C of the third embodiment includes a resonance layer 52C in which the second dielectric film 43-1, the first dielectric film 42-1, the light absorption film 47, the first dielectric film 42-2, and the second dielectric film 43-2 are stacked in that order from the first metal film 41 side. The resonance layer 52C is provided between the first metal film 41 and the second metal film 44.

As illustrated in Fig. 12, each of the first metal film 41, the second dielectric film 43-1, the first dielectric film 42-1, the light absorption film 47, the first dielectric film 42-2, the second dielectric film 43-2, and the second metal film 44 is provided across a plurality of pixels 3. Although not limited thereto, Fig. 12 illustrates five pixels 3 (3c, 3a, 3b, 3c, and 3a) as an example, and the films are provided across the five pixels 3. Furthermore, although not illustrated in detail, in the third embodiment, each of the first metal film 41, the second dielectric film 43-1, the first dielectric film 42-1, the light absorption film 47, the first dielectric film 42-2, the second dielectric film 43-2, and the second metal film 44 is provided across the entirety of the pixel array part 2A, for example.

Although not limited thereto, of the first metal film 41, the second dielectric film 43-1, the first dielectric film 42-1, the light absorption film 47, the first dielectric film 42-2, the second dielectric film 43-2, and the second metal film 44, the pairs of films facing each other in the thickness direction are provided so as to be in contact with each other, for example.

### <Second Dielectric Film on First Metal Film Side>

As illustrated in Figs. 13 and 14, the second dielectric film 43-1 located further on the first metal film 41 side than the light absorption film 47 includes a first part 43-1a which overlaps with the photoelectric conversion region 21a of the pixel 3a in plan view (see Fig. 13), a second part 43-lb which overlaps with the photoelectric conversion region 21b of the pixel 3b in plan view and which is thinner than the first part 43-1a (see Figs. 13 and 14), and a third part 43-1c which overlaps with the photoelectric conversion region 21c of the pixel 3c in plan view and which is thinner than the second part 43-Ib (see Fig. 14). In other words, the thickness of the second dielectric film 43-1 is different for each of the pixels 3a, 3b, and 3c (the photoelectric conversion regions 21a, 21b, and 21c), and the thickness decreases in stages in order of the pixels 3a, 3b, and 3c.

### <First Dielectric Film on First Metal Film Side>

As illustrated in Figs. 12 and 13, the first dielectric film 42-1 further on the first metal film 41 side than the light absorption film 47 includes a first part 42-1a which overlaps with the first part 43-1a of the second dielectric film 43-1 in plan view (see Fig. 13), a second part 42-1b which overlaps with the second part 43-lb of the second dielectric film 43-1 in plan view and which is thicker than the first part 42-1a of the first dielectric film 42-1 (see Figs. 13 and 14), and a third part 42-1c which overlaps with the third part 43-1c of the second dielectric film 43-1 in plan view and which is thicker than the second part 43-Ib of the second dielectric film 43-1 (see Fig. 14). In other words, the thickness of the first dielectric film 42-1 is different for each of the pixels 3a, 3b, and 3c (the photoelectric conversion regions 21a, 21b, and 21c), and, opposite from the second dielectric film 43-1, the thickness increases in stages in order of the pixels 3a, 3b, and 3c.

### <First Dielectric Film on Second Metal Film Side>

As illustrated in Figs. 13 and 14, the first dielectric film 42-2 located further on the second metal film 44 side than the light absorption film 47 includes a first part 42-2a which overlaps with the first part 42-1a of the first dielectric film 42-1 (the photoelectric conversion region 21a of the pixel 3a) in plan view (see Fig. 13), a second part 42-2b which overlaps with the second part 42-lb of the first dielectric film 42-1 (the photoelectric conversion region 21b of the pixel 3b) in plan view and which is thicker than the first part 42-2a (see Figs. 13 and 14), and a third part 42-2c which overlaps with the first part 42-1c of the first dielectric film 42-1 (the photoelectric conversion region 21c of the pixel 3c) in plan view and which is thicker than the second part 42-2b (see Fig. 14). In other words, the thickness of the first dielectric film 42-2 is different for each of the pixels 3a, 3b, and 3c (the photoelectric conversion regions 21a, 21b, and 21c), and the thickness increases in stages in order of the pixels 3a, 3b, and 3c.

### <Second Dielectric Film on Second Metal Film Side>

As illustrated in Figs. 13 and 14, the second dielectric film 43-2 located further on the second metal film 44 side than the light absorption film 47 includes a first part 43-2a which overlaps with the first part 42-2a of the first dielectric film 42-2 in plan view (see Fig. 13), a second part 43-2b which overlaps with the second part 42-2b of the first dielectric film 42-2 in plan view and which is thinner than the first part 43-2a of the second dielectric film 43-2 (see Figs. 13 and 14), and a third part 43-2c which overlaps with the third part 42-2c of the first dielectric film 42-2 in plan view and which is thinner than the second part 43-2b of the second dielectric film 43-2 (see Fig. 14). In other words, the thickness of the second dielectric film 43-2 is different for each of the pixels 3a, 3b, and 3c (the photoelectric conversion regions 21a, 21b, and 21c), and, opposite from the first dielectric film 42-2, the thickness decreases in stages in order of the pixels 3a, 3b, and 3c.

### <Light Absorption Film>

As illustrated in Figs. 13 and 14, the light absorption film 47 is provided continuously across the pixels 3a, 3b, and 3c. Although not limited thereto, the design value for the thickness of the light absorption film 47 is the same across the pixels 3a, 3b, and 3c. Here, the thickness being the same includes a permissible range of variation occurring during the manufacturing process.

### <Filter Parts>

As illustrated in Figs. 13 and 14, the optical filter layer 50C includes a first filter part 51a which overlaps with the photoelectric conversion region 21a of the pixel 3a in plan view, a second filter part 51b which overlaps with the photoelectric conversion region 21b of the pixel 3b in plan view, and a third filter part 51c which overlaps with the photoelectric conversion region 21c of the pixel 3c in plan view.

As illustrated in Fig. 13, the first filter part 51a includes the first part 43-1a of the second dielectric film 43-1, the first part 42-1a of the first dielectric film 42-1, the light absorption film 47, the first part 42-2a of the first dielectric film 42-2, and the first part 43-2a of the second dielectric film 43-2, provided in that order from the first metal film 41 side, between the first metal film 41 and the second metal film 44.

As illustrated in Figs. 13 and 14, the second filter part 51b includes the second part 43-1b of the second dielectric film 43-1, the second part 42-1b of the first dielectric film 42-1, the light absorption film 47, the second part 42-2b of the first dielectric film 42-2, and the second part 43-2b of the second dielectric film 43-2, provided in that order from the first metal film 41 side, between the first metal film 41 and the second metal film 44.

As illustrated in Fig. 14, the third filter part 51c includes the third part 43-1c of the second dielectric film 43-1, the third part 42-1c of the first dielectric film 42-1, the light absorption film 47, the third part 42-2c of the first dielectric film 42-2, and the third part 43-2c of the second dielectric film 43-2, provided in that order from the first metal film 41 side, between the first metal film 41 and the second metal film 44.

In other words, the first dielectric 42 and the second dielectric film 43 are provided on the first metal film 41 side and the second metal film 44 side, respectively, of the light absorption film 47, in each of the first to third filter parts 51a to 50c.

### <Film Thicknesses>

As illustrated in Figs. 13 and 14, each of the first filter part 51a, the second filter part 51b, and the third filter part 51c has a different ratio of the thicknesses of the first dielectric film 42-1 and the second dielectric film 43-1 on the first metal film 41 side of the light absorption film 47. Additionally, each of the first filter part 51a, the second filter part 51b, and the third filter part 51c has a different ratio of the thicknesses of the first dielectric film 42-2 and the second dielectric film 43-2 on the second metal film 44 side of the light absorption film 47. In other words, the ratio of the thicknesses of the first dielectric film (high refraction film) 42 and the second dielectric film (low refraction film) 43 is different in each of the first filter part 51a, the second filter part 51b, and the third filter part 51c.

For example, although not limited thereto, on the first metal film 41 side of the light absorption film 47, the ratio of the thicknesses of the first dielectric film 42-1 and the second dielectric film 43-1 is 1:3 in the first filter part 51a, 2:2 in the second filter part 51b, and 3:1 in the third filter part 51c. A total thickness h1a of the first dielectric film 42-1 and the second dielectric film 43-1 in the first filter part 51a, a total thickness h1b of the first dielectric film 42-1 and the second dielectric film 43-1 in the second filter part 51b, and a total thickness h1c of the first dielectric film 42-1 and the second dielectric film 43-1 in the third filter part 51c are designed to be the same. In other words, the total thickness of the first dielectric film 42-1 and the second dielectric film 43-1 is generally the same in the first filter part 51a (hla), the second filter part 51b (hlb), and the third filter part 51c (hlc). Additionally, although not limited thereto, on the second metal film 44 side of the light absorption film 47, the ratio of the thicknesses of the first dielectric film 42-2 and the second dielectric film 43-2 is 1:3 in the first filter part 51a, 2:2 in the second filter part 51b, and 3:1 in the third filter part 51c. A total thickness h2a of the first dielectric film 42-2 and the second dielectric film 43-2 in the first filter part 51a, a total thickness h2b of the first dielectric film 42-2 and the second dielectric film 43-2 in the second filter part 51b, and a total thickness h2c of the first dielectric film 42-2 and the second dielectric film 43-2 in the third filter part 51c are designed to be the same. In other words, the total thickness of the first dielectric film 42-2 and the second dielectric film 43-2 is generally the same in the first filter part 51a (h2a), the second filter part 51b (h2b), and the third filter part 51c (h2c). In other words, in the optical filter layer 50C of the fifth embodiment, the thickness of the resonance layer 52C between the first metal film 41 and the second metal film 44 is generally the same in each of the first to third filter parts 51a, 51b, and 51c.

### <Steps and Flat Surface on First Metal Side>

As illustrated in Figs. 13 and 14, on the first metal 41 side of the light absorption film 47, a surface layer part 43-1S on the first dielectric film 42-1 side of the second dielectric film 43-1 has a step part 43-1z₁ produced by the thickness difference (the difference in the thicknesses) of the first part 43-1a and the second part 43-Ib of the second dielectric film 43-1, a step part 43-1z₂ produced by the difference in the thicknesses of the second part 43-1b and the third part 43-1c of the second dielectric film 43-1, and a step part 43-1z₃ produced by the difference in the thicknesses of the third part 43-1c and the first part 43-1a of the second dielectric film 43-1.

In other words, the surface layer part 43-1S of the second dielectric film 43 has step parts (43-lzi, 43-1z₂, and 43-1z₃) between the pixels 3 adjacent to each other.

On the other hand, a surface layer part 42-1S on the light absorption film 47 side of the first dielectric film 42-1 is flat across the pixels 3 adjacent to each other. In the manufacturing process (described later), the surface layer part 43-1S side of the second dielectric film 43-1 is etched to form parts having different thicknesses (the first part 43-1a, the second part 43-lb, and the third part 43-1c), and thus the step parts (43-1z₁, 43-1z₂, and 43-1z₃) are formed on the surface layer part 43-1S side. The first dielectric film 42-1 covers the entirety of the second dielectric film 43-1 across the pixels 3 adjacent to each other such that the steps produced by the differences in the thickness of the second dielectric film 43-1 in the lower layer are embedded and the surface layer part 42-1S on the light absorption film 47 side is a flat, even surface.

### <Steps and Flat Surface on Second Metal Film Side>

As illustrated in Figs. 13 and 14, on the second metal film 44 side of the light absorption film 47, a surface layer part 42-2S on the second dielectric film 43-2 side of the first dielectric film 42-2 has a step part 42-2z₁ produced by the difference in the thicknesses of the first part 42-2a and the second part 42-2b of the first dielectric film 42-2, a step part 42-2z₂ produced by the difference in the thicknesses of the second part 42-2b and the third part 42-2c of the first dielectric film 42-1, and a step part 42-zs produced by the difference in the thicknesses of the third part 42-2c and the first part 42-2a of the first dielectric film 42-2. In other words, the surface layer part 42-2S of the first dielectric film 42-2 has step parts (42-2z₁, 42-2z₂, and 42-2z₃) between the pixels 3 adjacent to each other.

On the other hand, a surface layer part 43-2S on the second metal film 44 side of the second dielectric film 43-2 is flat across the pixels 3 adjacent to each other. In the manufacturing process (described later), the surface layer part 42-2S side of the first dielectric film 42-2 is etched to form parts having different thicknesses (the first part 42-2a, the second part 42-2b, and the third part 42-2c), and thus the step parts (42-2z₁, 42-2z₂, and 42-2z₃) are formed on the surface layer part 42-2S side. The second dielectric film 43-2 covers the entirety of the first dielectric film 42-2 across the pixels 3 adjacent to each other such that the steps produced by the differences in the thickness of the first dielectric film 42-2 in the lower layer are embedded and the surface layer part 43-2s on the second metal film 44 side is a flat, even surface.

### <Materials>

As illustrated in Figs. 13 and 14, each of the first dielectric films 42-1 and 42-2 is provided further on the light absorption film 47 side than the second dielectric films 43-1 and 43-2, respectively, and has a higher (greater) refractive index than the refractive index of each of the second dielectric films 43-1 and 43-2, respectively.

An inorganic film containing any one material among titanium oxide (TiO₂), tantalum oxide (Ta₂O₅), silicon nitride (SiN), or hafnium oxide (HfO₂), for example, can be used for each of the first dielectric films 42-1 and 42-2. The first dielectric films 42-1 and 42-2 may be constituted by the same material, or may be constituted by different materials.

An inorganic film containing any one material among silicon oxide (SiO₂) or silicon oxynitride (SiON), for example, can be used for each of the second dielectric films 43-1 and 43-2. The second dielectric films 43-1 and 43-2 may be constituted by the same material, or may be constituted by different materials.

As illustrated in Figs. 13 and 14, the light absorption film 47 is provided across the pixels 3 (photoelectric conversion regions 21) adjacent to each other. A film containing a semiconductor material such as amorphous silicon (a-Si), monocrystalline silicon (mono-Si), polysilicon (Poly-Si), germanium (Ge), silicon germanium (Si-Ge), indium-gallium-arsenic (InGaAs), or the like, a film containing a metal material such as titanium (Ti), tungsten (W), copper (Cu), or the like, or an alloy material having these metal materials as principal components, can be used as the light absorption film 47, for example.

### <First and Second Metal Films>

As illustrated in Figs. 13 and 14, each of the first metal film 41 and the second metal film 44 is provided across the pixels 3 (photoelectric conversion regions 21) adjacent to each other, as in the first embodiment described above. Furthermore, the first metal film 41 is thicker than the second metal film 44. A film containing any one material among aluminum (Al), silver (Ag), gold (Au), copper (Cu), chromium (Cr), or tungsten (W), for example, can be used as each of the first metal film 41 and the second metal film 44.

### <<Method for Manufacturing Solid-State Image Capturing Device>>

A method for manufacturing the solid-state image capturing device 1C according to the third embodiment will be described next with reference to Figs. 15A to 15I.

The manufacturing method of the third embodiment is similar to the foregoing first embodiment up to the step of forming the first metal film 41, the steps up to the forming of the first metal film 41 will not be described.

After the first metal film 41 is formed as illustrated in Fig. 15A, the second dielectric film 43-1 is formed on the side of the first metal film 41 opposite from the side on which the semiconductor layer 20 is located, as illustrated in Fig. 15B. The second dielectric film 43-1 can be formed by depositing an inorganic film containing any material among silicon oxide (SiO₂) or silicon oxynitride (SiON), for example, through CVD. The second dielectric film 43-1 is formed across the photoelectric conversion regions 21 adjacent to each other in plan view (21a, 21b, and 21c).

Next, using well-known photolithography and dry etching techniques, the second dielectric film 43-1 is selectively etched to form the first part 43-1a, which overlaps with the photoelectric conversion region 21a in plan view, the second part 43-lb, which overlaps with the photoelectric conversion region 21b in plan view and which is thinner than the first part 43-1a, and the third part 43-1c, which overlaps with the photoelectric conversion region 21c in plan view and which is thinner than the second part 43-lb, as illustrated in Fig. 15C. Each of the first part 43-1a, the second part 43-lb, and the third part 43-1c can be formed by repeating the photolithography and the dry etching steps several times. In this step, the step part 43-1z₁ produced by the difference in the thicknesses of the first part 43-1a and the second part 43-lb, the step part 43-1z₂ produced by the difference in the thicknesses of the second part 43-1b and the third part 43-lc, and the step part 43-1z₃ produced by the difference in the thicknesses of the third part 43-1c and the first part 43-1a are formed in the surface layer part 43-1S on the side of the second dielectric film 43-1 opposite from the side on which the first metal film 41 is located.

Next, as illustrated in Fig. 15D, the first dielectric film 42-1 having a refractive index different from that of the second dielectric film 43-1 is formed on the surface part 43-1S side of the second dielectric film 43-1. In the first embodiment, the first dielectric film 42-1 having a higher (greater) refractive index than the second dielectric film 43-1 is formed. The first dielectric film 42-1 can be formed by forming an inorganic film containing any one material of titanium oxide (TiO₂), tantalum oxide (Ta₂O₅), silicon nitride (SiN), or hafnium oxide (HfO₂), for example, on the surface layer part 43-1S side of the second dielectric film 43-1 through a well-known CVD technique, ALD, or the like, and then flattening the surface of the film through CMP or etching the film back. The first dielectric film 42-1 is formed across the photoelectric conversion regions 21 adjacent to each other (21a, 21b, and 21c).

In this step, the steps produced by the differences in the thickness of the second dielectric film 43-1 in the lower layer are embedded in the first dielectric film 42-1, and the surface layer part 42-1S is flattened.

Additionally, in this step, the first dielectric film 42-1 takes on a configuration including the first part 42-1a which overlaps with the first part 43-1a of the second dielectric film 43-1 in plan view, the second part 42-1b which overlaps with the second part 43-Ib of the second dielectric film 43-1 in plan view and which is thicker than the first part 42-la, and the third part 42-1c which overlaps with the third part 43-1c of the second dielectric film 43-1 in plan view and which is thicker than the second part 42-Ib.

Additionally, in this step, the parts are formed such that the total thickness h1a of the first parts 43-1a and 42-1a of the second and first dielectric films 43-1 and 42-1, the total thickness h1b of the second parts 43-lb and 42-1b of the second and first dielectric films 43-1 and 42-1, and the total thickness h1c of the third parts 43-1c and 42-1c of the first and second dielectric films 43-1 and 42-1 are generally the same.

Next, as illustrated in Fig. 15E, the light absorption film 47 and the first dielectric film 42-2 are formed in that order on the side of the first dielectric film 42-1 opposite from the side on which the first metal film 41 is located.

The light absorption film 47 can be formed by depositing a film containing a semiconductor material such as amorphous silicon (a-Si), monocrystalline silicon (mono-Si), polysilicon (Poly-Si), germanium (Ge), silicon germanium (Si-Ge), indium-gallium-arsenic (InGaAs), or the like, a film containing a metal material such as titanium (Ti), tungsten (W), copper (Cu), or the like, or an alloy material having these metal materials as principal components, for example. The light absorption film 47 is formed across the photoelectric conversion regions 21 adjacent to each other (21a, 21b, and 21c).

The first dielectric film 42-2 can be formed by forming an inorganic film containing any one material of titanium oxide (TiO₂), tantalum oxide (Ta₂O₅), silicon nitride (SiN), or hafnium oxide (HfO₂) through a well-known CVD technique, ALD, or the like, for example. The first dielectric film 42-2 is formed across the photoelectric conversion regions 21 adjacent to each other (21a, 21b, and 21c).

In this step, the step parts produced by the differences in the thickness of the second dielectric film 43-1 in the lower layer are embedded in the first dielectric film 42-1, and the surface layer part 42-1S of the first dielectric film 42-1 is flat across the photoelectric conversion regions 21 adjacent to each other, which makes it possible to increase the adhesion of each of the light absorption film 47 and the first dielectric film 42-2, and suppress peeling of each of the light absorption film 47 and the first dielectric film 42-2.

Next, using well-known photolithography and dry etching techniques, the first dielectric film 42-2 is selectively etched to form the first part 42-2a, which overlaps with the first part 42-1a of the first dielectric film 42-1 (the photoelectric conversion region 21a) in plan view, the second part 42-2b, which overlaps with the second part 42-lb of the first dielectric film 42-1 (the photoelectric conversion region 21b) in plan view and which is thicker than the first part 42-2a, and the third part 42-2c, which overlaps with the third part 42-1c of the first dielectric film 42-1 (the photoelectric conversion region 21c) in plan view and which is thicker than the second part 42-2b, as illustrated in Fig. 15F. Each of the first part 42-2a, the second part 42-2b, and the third part 42-2c can be formed by repeating the photolithography and the dry etching steps several times.

In this step, the step part 42-2z₁ produced by the difference in the thicknesses of the first part 42-2a and the second part 42-2b, the step part 42-2z₂ produced by the difference in the thicknesses of the second part 42-2b and the third part 42-2c, and the step part 42-2zs produced by the difference in the thicknesses of the third part 42-2c and the first part 42-2a, are formed in the surface layer part 42-2S on the side of the first dielectric film 42-2 opposite from the side on which the light absorption film 47 is located.

Next, as illustrated in Fig. 15G, the second dielectric film 43-2, which has a refractive index different from that of the first dielectric film 42-2, is formed on the side of the first dielectric film 42-2 opposite from the side on which the light absorption film 47 (the first metal film 41) is located. In the third embodiment, the second dielectric film 43-2 having a lower (smaller) refractive index than that of the first dielectric film 42-2 is formed. The second dielectric film 43-2 can be formed by forming, through CVD, an inorganic film containing any one material of silicon oxide (SiO₂) or silicon oxynitride (SiON), for example, on the side of the first dielectric film 42-2 opposite from the side on which the light absorption film 47 is located, and then polishing through CMP or etching back the surface of the film. The second dielectric film 43-2 is formed across the photoelectric conversion regions 21 adjacent to each other (21a, 21b, and 21c).

In this step, the steps produced by the differences in the thickness of the first dielectric film 42-2 in the lower layer are embedded in the second dielectric film 43-2, and the surface layer part 43-2S is flattened.

Additionally, in this step, the second dielectric film 43-2 takes on a configuration including: the first part 43-2a which overlaps with the first part 42-2a of the first dielectric film 42-2 in plan view; the second part 43-2b which overlaps with the second part 42-2b of the first dielectric film 42-2 in plan view and which is thinner than the first part 43-2a; and the third part 43-2c which overlaps with the third part 42-2c of the first dielectric film 42-2 in plan view and which is thinner than the second part 43-2b.

Additionally, in this step, the parts are formed such that the total thickness h2a of the first parts 42-2a and 43-2a of the first and second dielectric films 42-2 and 43-2, the total thickness h2b of the second parts 42-2b and 43-2b of the first and second dielectric films 42-2 and 43-2, and the total thickness h2c of the third parts 42-2c and 43-2c of the first and second dielectric films 42-2 and 43-2 are generally the same.

Additionally, the resonance layer 52C, which includes the second dielectric film 43-1, the first dielectric film 42-1, the light absorption film 47, the first dielectric film 42-2, and the second dielectric film 43-2, is formed in this step.

Next, as illustrated in Fig. 15H, the second metal film 44, which is thinner than the first metal film 41, is formed on the side of the second dielectric film 43-2 opposite from the side on which the light absorption film 47 (the first dielectric film 42-2) is located. The second metal film 44 can be formed by forming a film containing any one of aluminum, silver (Ag), copper (Cu), gold (Au), chromium (Cr), or tungsten (W) through a well-known sputtering technique, ALD, or the like, for example. The second metal film 44 is formed across the photoelectric conversion regions 21 adjacent to each other (21a, 21b, and 21c).

In this step, the step parts produced by the differences in the thickness of the first dielectric film 42-2 in the lower layer are embedded in the second dielectric film 43-2, and the surface layer part 43-2S of the second dielectric film 43-2 is flat across the photoelectric conversion regions 21 (pixels 3) adjacent to each other, which makes it possible to increase the adhesion of the second metal film 44 and suppress peeling of the second metal film 44.

The first filter part 51a, which includes the first metal film 41, the first parts 42-1a, 42-2a, 43-la, and 43-2a of the first and second dielectric films 42-1, 42-2, 43-1, and 43-2, respectively, and the second metal film 44, and which overlaps with the photoelectric conversion region 21a in plan view, is formed in this step.

Additionally, the first filter part 51b, which includes the first metal film 41, the second parts 42-lb, 42-2b, 43-lb, and 43-2b of the first and second dielectric films 42-1, 42-2, 43-1, and 43-2, respectively, and the second metal film 44, and which overlaps with the photoelectric conversion region 21b in plan view, is formed in this step.

Additionally, the first filter part 51c, which includes the first metal film 41, the third parts 42-1c, 42-2c, 43-1c, and 43-2c of the first and second dielectric films 42-1, 42-2, 43-1, and 43-2, respectively, and the second metal film 44, and which overlaps with the photoelectric conversion region 21c in plan view, is formed in this step.

The optical filter layer 50C including the first filter part 51a, the second filter part 51b, and the third filter part 51c is formed on the light incidence surface side (the second surface S2 side) of the semiconductor layer 20.

Next, as illustrated in Fig. 15I, the insulating layer 45 covering the optical filter layer 50C (the second metal film 44) is formed on the side of the optical filter layer 50C opposite from the side on which the semiconductor layer 20 is located.

The solid-state image capturing device 1C including the semiconductor layer 20, the multilayer wiring layer 30, the support substrate 34, the insulating layer 35, the optical filter layer 50C, the insulating layer 45, and the like is essentially completed by this step.

Note that the solid-state image capturing device 1C takes on the state of the semiconductor chip 2 illustrated in Fig. 1 by dividing a semiconductor wafer including the semiconductor layer 20, the optical filter layer 50C, and the like into chip formation regions.

### <<Light Absorption Function of Optical Filter Layer>>

A light absorption function of the optical filter layer 50C according to the third embodiment will be described next with comparison to the optical filter layer 40 according to the foregoing first embodiment serving as a reference example.

In an optical filter layer using Fabry-Perot resonance, a sub-peak may appear on the short wavelength side when the signal is taken on the long wavelength side. Such a sub-peak may affect color mixing, and it is therefore preferable to suppress the sub-peak.

Fig. 16A is a longitudinal cross-sectional view schematically illustrating the optical filter layer 40 of the first embodiment as a reference example.

Fig. 16B is a diagram illustrating a correlation between transmittance and the thickness of the first dielectric film (high refraction film) 42 in the optical filter layer 40 of the reference example illustrated in Fig. 16A (a diagram illustrating the dependence of transmittance on the thickness of the first dielectric film).

Fig. 17A is a longitudinal cross-sectional view schematically illustrating the optical filter layer 50C of the third embodiment.

Fig. 17B is a diagram illustrating a correlation between transmittance and the total thickness of two first dielectric films (high refraction films) 42 on respective sides of the light absorption film 47 in the optical filter layer 50C of the third embodiment illustrated in Fig. 17A (a diagram illustrating the dependence of transmittance on the thickness of the first dielectric film).

A difference between the optical filter layer 40 of the reference example illustrated in Fig. 16A and the optical filter layer 50C of the third embodiment illustrated in Fig. 17A is the presence or absence of the light absorption film 47. Furthermore, in the optical filter layer 50C of the third embodiment, the first dielectric film 42 and the second dielectric film 43 are each provided on both sides of the light absorption film 47 in the thickness direction. In Figs. 16B and 17B, "T" represents the thickness of the first dielectric film (high refraction film) 42. The data in Fig. 16B is data obtained when, for example, the thickness of a resonance layer 52A between the first metal film 41 and the second metal film 44 is 120 nm, the thickness of the first metal film 41 is 10 nm, the thickness of the second metal film 44 is 5 nm, and TiO₂ film is used as the first dielectric film 42, in the optical filter layer 40 of the reference example illustrated in Fig. 16A.

Meanwhile, the data in Fig. 17B is data obtained when, for example, the thickness of the resonance layer 52C between the first metal film 41 and the second metal film 44 is 270 nm, the thickness of the light absorption film 47 is 10 nm, the thickness of the first metal film 41 is 10 nm, the thickness of the second metal film 44 is 5 nm, TiO₂ film is used as the first dielectric film 42, and Ge film is used as the light absorption film 47, in the optical filter layer 50C of the third embodiment illustrated in Fig. 17A.

As illustrated in Fig. 16B, in the optical filter layer 40 of the reference example, at T = 120 nm, secondary resonance (sub-peak) occurs on the short wavelength side separately from the primary resonance.

In contrast, as illustrated in Fig. 17B, in the optical filter layer 50C of the third embodiment, the secondary resonance (sub-peak) on the short wavelength side can be eliminated by the light absorption film 47.

Fig. 18 is a diagram illustrating stationary waves (standing waves) for each of orders of resonance in a Fabry-Perot resonance structure in which a dielectric film is interposed between two metal films. In the figure, a region R₁ enclosed within the solid line corresponds to the optical filter layer 40 of the reference example illustrated in Fig. 16A. Fig. 19 is a diagram illustrating stationary waves (standing waves) for each of orders of resonance in a Fabry-Perot resonance structure in which a dielectric film, into which a light absorption film has been inserted, is interposed between two metal films. In the figure, a region R₂ enclosed within the solid line corresponds to the optical filter layer 50C of the third embodiment illustrated in Fig. 17A. A Ge film is used as the light absorption film.

In Figs. 18 and 19, m = 1, m = 2, m = 3, and m = 4 indicate orders of resonance.

The stationary waves Sw indicated in Fig. 18 have high light intensities at the antinodes, and low light intensities at the nodes.

Accordingly, as illustrated in Fig. 19, inserting the light absorption film 47 at the antinode parts of the stationary wave Sw makes it possible to selectively absorb stationary waves Sw at odd-numbered orders (m = 1 and 3) and suppress resonance at odd-numbered orders (m = 1 and 3).

Fig. 20 is a diagram illustrating a correlation between transmittance, the thickness of the resonance layer 52A in the optical filter layer 40 according to the reference example illustrated in Fig. 16A, and the thickness of the resonance layer 52C in the optical filter layer 50C according to the third embodiment illustrated in Fig. 17A.

In Fig. 20, data D₁₁ is data obtained when, for example, the thickness of the resonance layer 52A is 120 nm, the thickness of the first dielectric film 42 is 110 nm, and TiO₂ film is used as the first dielectric film 42, in the optical filter layer 40 of the reference example illustrated in Fig. 16A.

Meanwhile, data D₁₂ is data obtained when, for example, the thickness of the resonance layer 52C is 270 nm, the thickness of the light absorption film 47 is 10 nm, the total thickness of the two first dielectric films 42 is 200 nm, and TiO₂ film is used as the first dielectric film 42, in the optical filter layer 50C of the third embodiment illustrated in Fig. 17A.

As illustrated in Fig. 20, making the resonance layer 52C thicker than the resonance layer 52A makes it possible to use the peak at m = 2 as a main peak, i.e., a higher-order peak with a small half-value width, which makes it possible to improve the accuracy of light source estimation.

Fig. 21A is a diagram illustrating stationary waves (standing waves) for each of orders of resonance in a Fabry-Perot resonance structure in which a dielectric film, into which a light absorption film has been inserted, is interposed between two metal films. In the figure, a region R₃ enclosed within the solid line corresponds to the optical filter layer 50C of the third embodiment illustrated in Fig. 17A. A Ge film is used as the light absorption film. Fig. 21B is a diagram illustrating correlation between transmittance and the thickness of the light absorption film in the Fabry-Perot resonance structure illustrated in Fig. 21A (a diagram illustrating the dependence of transmittance on the thickness of the light absorption film).

As can be seen from Figs. 21A and 21B, setting the thickness of the light absorption film 47 to at least 30 nm makes it possible to suppress a peak at m = 4 as well. In the optical filter layer 50C of the third embodiment, the thickness of the light absorption film 47 is preferably at least 10% of the thickness of the resonance layer 52C.

Fig. 22 is a diagram illustrating a correlation between transmittance and the thickness of a light absorption film in a Fabry-Perot resonance structure in which a dielectric film, into which the light absorption film 47 has been inserted, is interposed between two metal films (a diagram illustrating the dependence of the transmittance on the thickness of the light absorption film). A Ge film is used as the light absorption film 47.

From Fig. 22, it can be seen that the light absorption film 47 has an effect of suppressing sub-peaks from a thickness of at least 2 nm.

Fig. 23 is a diagram illustrating a correlation between transmittance and the material of a light absorption film in a Fabry-Perot resonance structure in which a dielectric film, into which the light absorption film 47 has been inserted, is interposed between two metal films (a diagram illustrating the dependence of the transmittance on the material of the light absorption film).

From Fig. 23, it can be seen that the light absorption film 47 has an effect of suppressing sub-peaks when formed from a material having an extinction coefficient which is not 0.

### <<Main Effects of Third Embodiment>>

The optical filter layer 50C of the third embodiment has a Fabry-Perot resonance structure. As described with reference to Figs. 13 and 14, the optical filter layer 50C of the third embodiment can spectrally split the light incident from the second metal film 44 side (incident light) through reflection (resonance) and absorption between the first metal film 41 and the second metal film 44. Furthermore, with the optical filter layer 50C of the third embodiment, changing the ratio of the thicknesses of the first dielectric film 42 and the second dielectric film 43 changes the optical path length, which makes it possible to change the wavelength band of the light passing through the filter parts (51a, 51b, and 51c). As a result, by employing a configuration in which the ratio of the thicknesses of the first dielectric film 42 and the second dielectric film 43 is different in the first filter part 51a, the second filter part 51b, and the third filter part 51c, as in the optical filter layer 50C of the third embodiment, the wavelength bands of the light passing through the first filter part 51a, the second filter part 51b, and the third filter part 51c can be changed. Although the third embodiment describes changing the ratio of the thicknesses of the first dielectric film 42 and the second dielectric film 43 for the three filter parts 51a, 51b, and 51c as an example, the ratio of the thicknesses of the first dielectric film 42 and the second dielectric film 43 can be changed so as to correspond to four or more filter parts, and the incident light can be spectrally split into light in a greater number of wavelength bands. Therefore, like the solid-state image capturing device 1A of the first embodiment described above, the solid-state image capturing device 1C according to the third embodiment makes it possible to achieve spectral separation, where incident light is divided into a variety of wavelength bands.

Additionally, like the foregoing first embodiment, because the wavelength band of transmitted light can be changed by changing the ratio of the thicknesses of the first dielectric film 42 and the second dielectric film 43, the optical filter layer 50C of the third embodiment can achieve spectral separation at a lower cost than a conventional color filter layer which uses a plurality of types of resins to which pigments are added.

Additionally, in the manufacturing process for the optical filter layer 50C of the third embodiment, the step parts produced by the differences in the thickness of the dielectric film in the lower layer are embedded in the dielectric film in the upper layer, and the surface layer part of the dielectric film in the upper layer is flat across the photoelectric conversion regions 21 (pixels 3) adjacent to each other, which makes it possible to increase the adhesion of the second metal film 44 and suppress peeling of the second metal film 44. Therefore, like the solid-state image capturing device 1A according to the first embodiment described above, the solid-state image capturing device 1C according to the third embodiment makes it possible to achieve spectral separation while suppressing a drop in yield caused by peeling of the second metal film 44.

Additionally, like the optical filter layer 40 of the first embodiment described above, in the optical filter layer 50C of the third embodiment, the first metal film 41 is thicker than the second metal film 44, and thus color mixing can be reduced without changing the transmittance.

Additionally, the optical filter layer 50C of the third embodiment includes the light absorption film 47 provided between the first dielectric film 42 and the second dielectric film 43, and thus sub-peaks on the short wavelength side can be eliminated. Therefore, the solid-state image capturing device 1C according to the third embodiment makes it possible to further suppress color mixing, which makes it possible to greatly improve the estimation accuracy of the light source.

In addition, the solid-state image capturing device 1C according to the third embodiment makes it possible to use a higher-order peak, which in turn makes it possible to reduce the half-value width and improve the estimation accuracy of the light source.

### [Fourth Embodiment]

A solid-state image capturing device 1D according to a fourth embodiment of the present technique, illustrated in Figs. 24 to 26, has basically the same configuration as in the third embodiment described above, with the exception of the following configurations.

First, as illustrated in Figs. 24 to 26, the solid-state image capturing device 1D according to the fourth embodiment of the present technique includes an optical filter layer 50D instead of the optical filter layer 50C illustrated in Figs. 12 to 14 described above in the third embodiment. The difference between the optical filter layer 50D of the fourth embodiment and the optical filter layer 50C of the third embodiment described above is that the optical filter layer 50D does not include the first dielectric film 42-1.

### <Optical Filter Layer>

As illustrated in Fig. 24, the optical filter layer 50D of the fourth embodiment includes: the first metal film 41 provided on the second surface S2 side (the light incidence surface side) of the semiconductor layer 20 with the insulating layer 35 located therebetween; the first dielectric film (high refraction film) 42 and the second dielectric film (low refraction film) 43, which are arranged in the thickness direction of the semiconductor layer 20 side by side on the side of the first metal film 41 opposite from the side on which the semiconductor layer 20 is located, and which have different refractive indices from each other; the second metal film 44 provided on the side of the first and second dielectric films 42 and 43 opposite from the side on which the first metal film 41 is located; and the light absorption film 47 provided between the first dielectric film 42 and the second dielectric film 43.

The optical filter layer 50D of the fourth embodiment further includes one first dielectric film 42-2 as the first dielectric film 42, and two second dielectric films 43-1 and 43-2 as the second dielectric film 43. In other words, the optical filter layer 50D of the fourth embodiment includes a resonance layer 47D in which the second dielectric film 43-1, the light absorption film 47, the first dielectric film 42-2, and the second dielectric film 43-2 are stacked in that order from the first metal film 41 side. The resonance layer 47D is provided between the first metal film 41 and the second metal film 44.

As illustrated in Fig. 24, each of the first metal film 41, the second dielectric film 43-1, the light absorption film 47, the first dielectric film 42-2, the second dielectric film 43-2, and the second metal film 44 is provided across a plurality of pixels 3. As in the third embodiment described above, Fig. 24 illustrates five pixels 3 (3c, 3a, 3b, 3c, and 3a) as an example, and the films are provided across the five pixels 3. Furthermore, although not illustrated in detail, in the fourth embodiment as well, each of the first metal film 41, the second dielectric film 43-1, the light absorption film 47, the first dielectric film 42-2, the second dielectric film 43-2, and the second metal film 44 is provided across the entirety of the pixel array part 2A, for example.

Although not limited thereto, of the first metal film 41, the second dielectric film 43-1, the light absorption film 47, the first dielectric film 42-2, the second dielectric film 43-2, and the second metal film 44, the pairs of films facing each other in the thickness direction are provided so as to be in contact with each other, for example.

### <Second Dielectric Film on First Metal Film Side>

As illustrated in Figs. 25 and 26, the second dielectric film 43-1 located further on the first metal film 41 side than the light absorption film 47 is provided continuously across each of the pixels 3a, 3b, and 3c (the photoelectric conversion regions 21a, 21b, and 21c) at a constant thickness, unlike the second dielectric film 43-1 of the third embodiment described above. In other words, the second dielectric film 43-1 is designed to have the same thickness in the first part 43-1a which overlaps with the photoelectric conversion region 21a of the pixel 3a in plan view (see Fig. 25), the second part 43-lb which overlaps with the photoelectric conversion region 21b of the pixel 3b in plan view (see Figs. 25 and 26), and the third part 43-1c which overlaps with the photoelectric conversion region 21c of the pixel 3c in plan view (see Fig. 26).

### <First Dielectric Film on Second Metal Film Side>

As illustrated in Figs. 25 and 26, the first dielectric film 42-2 located further on the second metal film 47 side than the light absorption film 47 includes the first part 42-2a which overlaps with the first part 43-1a of the second dielectric film 43-1 (the photoelectric conversion region 21a of the pixel 3a) in plan view (see Fig. 25), the second part 42-2b which overlaps with the second part 43-lb of the second dielectric film 43-1 (the photoelectric conversion region 21b of the pixel 3b) in plan view and which is thicker than the first part 42-2a (see Figs. 25 and 26), and the third part 42-2c which overlaps with the third part 43-1c of the second dielectric film 43-1 (the photoelectric conversion region 21c of the pixel 3c) in plan view and which is thicker than the second part 42-2b (see Fig. 26). In other words, the thickness of the first dielectric film 42-2 is different for each of the pixels 3a, 3b, and 3c (the photoelectric conversion regions 21a, 21b, and 21c), and the thickness increases in stages in order of the pixels 3a, 3b, and 3c.

### <Second Dielectric Film on Second Metal Film Side>

As illustrated in Figs. 25 and 26, like the third embodiment described above, the second dielectric film 43-2 located further on the second metal film 44 side than the light absorption film 47 includes the first part 43-2a which overlaps with the first part 42-2a of the first dielectric film 42-2 in plan view (see Fig. 25), the second part 43-2b which overlaps with the second part 42-2b of the first dielectric film 42-2 in plan view and which is thinner than the first part 43-2a of the second dielectric film 43-2 (see Figs. 25 and 26), and the third part 43-2c which overlaps with the third part 42-2c of the first dielectric film 42-2 in plan view and which is thinner than the second part 43-2b of the second dielectric film 43-2 (see Fig. 26). In other words, the thickness of the second dielectric film 43-2 is different for each of the pixels 3a, 3b, and 3c (the photoelectric conversion regions 21a, 21b, and 21c), and, opposite from the first dielectric film 42-2, the thickness decreases in stages in order of the pixels 3a, 3b, and 3c.

### <Light Absorption Film>

As illustrated in Figs. 25 and 26, like the third embodiment described above, the light absorption film 47 of this embodiment is provided continuously across the pixels 3a, 3b, and 3c. Although not limited thereto, the design value for the thickness of the light absorption film 47 is the same across the pixels 3a, 3b, and 3c.

### <Filter Parts>

As illustrated in Figs. 25 and 26, the optical filter layer 50D includes the first filter part 51a which overlaps with the photoelectric conversion region 21a of the pixel 3a in plan view, the second filter part 51b which overlaps with the photoelectric conversion region 21b of the pixel 3b in plan view, and the third filter part 51c which overlaps with the photoelectric conversion region 21c of the pixel 3c in plan view.

As illustrated in Fig. 25, the first filter part 51a includes the first part 43-1a of the second dielectric film 43-1, the light absorption film 47, the first part 42-2a of the first dielectric film 42-2, and the first part 43-2a of the second dielectric film 43-2, in that order from the first metal film 41 side, between the first metal film 41 and the second metal film 44.

As illustrated in Figs. 25 and 26, the second filter part 51b includes the second part 43-1b of the second dielectric film 43-1, the light absorption film 47, the second part 42-2b of the first dielectric film 42-2, and the second part 43-2b of the second dielectric film 43-2, in that order from the first metal film 41 side, between the first metal film 41 and the second metal film 44.

As illustrated in Fig. 25, the third filter part 51c includes the third part 43-1c of the second dielectric film 43-1, the light absorption film 47, the third part 42-2c of the first dielectric film 42-2, and the third part 43-2c of the second dielectric film 43-2, in that order from the first metal film 41 side, between the first metal film 41 and the second metal film 44.

Here, the second dielectric film 43 is provided on both the first metal film 41 side and the second metal film 44 side of the light absorption film 47, in each of the first to third filter parts 51a to 51c. On the other hand, the first dielectric film 42 is provided only on one of the first metal film 41 side and the second metal film 44 side of the light absorption film 47, in each of the first to third filter parts 51a to 51c. In the fourth embodiment, the first dielectric film 42 is provided on the second metal film 44 side of the light absorption film 47, and is not provided on the first metal film 41 side of the light absorption film 47.

### <Film Thicknesses>

As illustrated in Figs. 25 and 26, on the second metal film 44 side of the light absorption film 47, in each of the first to third filter parts 51a, 51b, and 51c, the ratio of the thicknesses of the first dielectric film 42-2 and the second dielectric film 43-2 is the same as in the third embodiment described above. On the other hand, unlike the third embodiment described above, on the first metal film 41 side of the light absorption film 47, the single-layer second dielectric film 43-1 is provided at the same thickness across the first to third filter parts 51a, 51b, and 51c. In other words, like the resonance layer 52C of the third embodiment described above, in the optical filter layer 50D of the fourth embodiment, the thickness of a resonance layer 52D between the first metal film 41 and the second metal film 44 is generally the same in each of the first to third filter parts 51a, 51b, and 51c.

### <Steps and Flat Surface>

As illustrated in Figs. 25 and 26, on the first metal film 41 side of the light absorption film 47, the surface layer part 43-1S on the light absorption film 47 side of the second dielectric film 43-1 is flat across the pixels 3 (the photoelectric conversion regions 21) adjacent to each other, unlike in the third embodiment described above.

As illustrated in Figs. 25 and 26, on the second metal film 44 side of the light absorption film 47, the surface layer part 43-2S on the second metal film 44 side of the second dielectric film 43-2 is flat across the pixels 3 (the photoelectric conversion regions 21) adjacent to each other, as in the third embodiment described above. The second dielectric film 43-2 covers the entirety of the first dielectric film 42-2 across the pixels 3 adjacent to each other such that the steps produced by the differences in the thickness of the first dielectric film 42-2 in the lower layer are embedded and the surface layer part 43-2s on the second metal film 44 side is a flat, even surface.

### <<Main Effects of Fourth Embodiment>>

The solid-state image capturing device 1D according to the fourth embodiment provides effects similar to those of the solid-state image capturing device 1C according to the third embodiment described above.

### [Fifth Embodiment]

A solid-state image capturing device 1E according to a fifth embodiment of the present technique, illustrated in Figs. 27 to 29, has basically the same configuration as the solid-state image capturing device 1C according to the third embodiment described above, with the exception of the following configurations.

First, as illustrated in Figs. 27 to 29, the solid-state image capturing device 1E according to the fifth embodiment of the present technique includes an optical filter layer 50E instead of the optical filter layer 50C illustrated in Figs. 12 to 14 described above in the third embodiment. The difference between the optical filter layer 50E of the fifth embodiment and the optical filter layer 50C of the third embodiment described above is that the first dielectric film 42-2 in the optical filter layer 50E is provided in a selective manner.

### <Optical Filter Layer>

As illustrated in Fig. 27, the optical filter layer 50E of the fifth embodiment includes: the first metal film 41 provided on the second surface S2 side (the light incidence surface side) of the semiconductor layer 20 with the insulating layer 35 located therebetween; the first dielectric film (high refraction film) 42 and the second dielectric film (low refraction film) 43, which are arranged in the thickness direction of the semiconductor layer 20 side by side on the side of the first metal film 41 opposite from the side on which the semiconductor layer 20 is located, and which have different refractive indices from each other; the second metal film 44 provided on the side of the first and second dielectric films 42 and 43 opposite from the side on which the first metal film 41 is located; and the light absorption film 47 provided between the first dielectric film 42 and the second dielectric film 43.

The optical filter layer 50E of the fifth embodiment further includes two first dielectric films 42-1 and 42-2 as the first dielectric film 42, and two second dielectric films 43-1 and 43-2 as the second dielectric film 43. In other words, the optical filter layer 50E of the fifth embodiment includes a resonance layer 52E in which the second dielectric film 43-1, the first dielectric film 42-1, the light absorption film 47, the first dielectric film 42-2, and the second dielectric film 43-2 are stacked in that order from the first metal film 41 side. The resonance layer 52E is provided between the first metal film 41 and the second metal film 44.

As illustrated in Fig. 27, each of the first metal film 41, the second dielectric film 43-1, the first dielectric film 42-1, the light absorption film 47, the second dielectric film 43-2, and the second metal film 44 is provided across, for example, five of the pixels 3, as in the third embodiment described above. On the other hand, unlike the third embodiment described above, the first dielectric film 42-2 is selectively provided in the second filter part 51b and the second filter part 51c of the optical filter layer 50E, and is not provided in the first filter part 51a.

### <First and Second Dielectric Films on First Metal Film Side>

As illustrated in Figs. 28 and 29, each of the second dielectric film 43-1 and the first dielectric film 42-1 located further on the first metal film 41 side than the light absorption film 47 is provided continuously across each of the pixels 3a, 3b, and 3c (the photoelectric conversion regions 21a, 21b, and 21c) at a constant thickness, unlike the second dielectric film 43-1 and the first dielectric film 42-1 of the third embodiment described above.

In other words, the second dielectric film 43-1 includes the first part 43-1a which overlaps with the photoelectric conversion region 21a of the pixel 3a in plan view, the second part 43-1b which overlaps with the photoelectric conversion region 21b of the pixel 3b in plan view, and the third part 43-1c which overlaps with the photoelectric conversion region 21c of the pixel 3c in plan view. Each of the first to third parts 43-1a, 43-lb, and 43-1c is designed to have the same thickness.

The first dielectric film 42-1 also includes the first part 42-1a which overlaps with the first part (the photoelectric conversion region 21a of the pixel 3a) 43-1a of the second dielectric film 43-1 in plan view, the second part 42-lb which overlaps with the second part 43-lb of the second dielectric film 43-1 (the photoelectric conversion region 21b of the pixel 3b) in plan view, and the third part 42-1c which overlaps with the third part 43-1c of the second dielectric film 43-1 (the photoelectric conversion region 21c of the pixel 3c) in plan view. Each of the first to third parts 42-1a, 42-lb, and 42-1c is designed to have the same thickness.

### <First and Second Dielectric Films on Second Metal Film Side>

As illustrated in Figs. 28 and 29, unlike the first dielectric film 42-2 of the third embodiment described above, the first dielectric film 42-2 located further on the second metal film 44 side than the light absorption film 47 does not include a first part which overlaps with the first part 42-1a (the photoelectric conversion region 21a of the pixel 3a) of the first dielectric film 42-1 in plan view. Furthermore, as illustrated in Figs. 28 and 29, the first dielectric film 42-2 includes the second part 42-2b which overlaps with the second part 42-lb of the first dielectric film 42-1 (the photoelectric conversion region 21b of the pixel 3b) in plan view, and the third part 42-2c which overlaps with the third part 42-1c of the first dielectric film 42-1 (the photoelectric conversion region 21c of the pixel 3c) in plan view and which is thicker than the second part 42-2b. In other words, the thickness of the first dielectric film 42-2 of the fifth embodiment is different for each of the pixels 3b and 3c (the photoelectric conversion regions 21b and 21c), and the thickness increases in stages in order of the pixels 3b and 3c.

As illustrated in Figs. 28 and 29, unlike the second dielectric film 43-2 of the third embodiment described above, the second dielectric film 43-2 located further on the second metal film 44 side than the light absorption film 47 includes the first part 43-2a which overlaps with the first part 42-1a of the first dielectric film 42-1 (the photoelectric conversion region 21a of the pixel 3a) in plan view, the second part 43-2b which overlaps with the second part 42-2b of the first dielectric film 42-2 in plan view, and the third part 43-2c which overlaps with the third part 42-2c of the first dielectric film 42-2 in plan view. In other words, the thickness of the second dielectric film 43-2 is different for each of the pixels 3a, 3b, and 3c (the photoelectric conversion regions 21a, 21b, and 21c), and, opposite from the first dielectric film 42-2, the thickness decreases in stages in order of the pixels 3a, 3b, and 3c.

### <Light Absorption Film>

As illustrated in Figs. 28 and 29, like the third embodiment described above, the light absorption film 47 of this embodiment is provided continuously across the pixels 3a, 3b, and 3c. Although not limited thereto, the design value for the thickness of the light absorption film 47 is the same across the pixels 3a, 3b, and 3c.

### <Filter Parts>

As illustrated in Figs. 28 and 29, the optical filter layer 50E includes the first filter part 51a which overlaps with the photoelectric conversion region 21a of the pixel 3a in plan view, the second filter part 51b which overlaps with the photoelectric conversion region 21b of the pixel 3b in plan view, and the third filter part 51c which overlaps with the photoelectric conversion region 21c of the pixel 3c in plan view.

As illustrated in Fig. 28, the first filter part 51a includes the first part 43-1a of the second dielectric film 43-1, the first part 42-1a of the first dielectric film 42-1, the light absorption film 47, and the first part 43-2a of the second dielectric film 43-2, in that order from the first metal film 41 side, between the first metal film 41 and the second metal film 44.

As illustrated in Figs. 28 and 29, the second filter part 51b includes the second part 43-lb of the second dielectric film 43-1, the second part 42-1b of the first dielectric film 42-1, the light absorption film 47, the second part 42-2b of the first dielectric film 42-2, and the second part 43-2b of the second dielectric film 43-2, in that order from the first metal film 41 side, between the first metal film 41 and the second metal film 44.

As illustrated in Fig. 29, the third filter part 51c includes, in order from the first metal film 41 side, the third part 43-1c of the second dielectric film 43-1, the third part 42-1c of the first dielectric film 42-1, the light absorption film 47, the third part 42-2c of the first dielectric film 42-2, and the third part 43-2c of the second dielectric film 43-2, in that order from the first metal film 41 side, between the first metal film 41 and the second metal film 44.

Here, the second dielectric film 43 is provided on both the first metal film 41 side and the second metal film 44 side of the light absorption film 47, in each of the first to third filter parts 51a to 51c. On the other hand, the first dielectric film 42 is provided on one of the first metal film 41 side or the second metal film 44 side of the light absorption film 47 in the first filter part 51a, and on both the first metal film 41 side and the second metal film 44 side of the light absorption film 47 in the second and third filter parts 51b and 51c. In the fifth embodiment, in the first filter part 51a, the first dielectric film 42 is provided on the first metal film 41 side of the light absorption film 47, and is not provided on the second metal film 44 side of the light absorption film 47.

### <Film Thicknesses>

As illustrated in Figs. 28 and 29, on the first metal film 41 side of the light absorption film 47, in each of the first to third filter parts 51a, 51b, and 51c, the ratio of the thicknesses of the first dielectric film 42-1 and the second dielectric film 43-1 is the same. On the other hand, on the second metal film 44 side of the light absorption film 47, in each of the first to third filter parts 51a, 51b, and 51c, the ratios of the thicknesses of the first dielectric film 42-2 and the second dielectric film 43-2 are different.

Furthermore, on the first metal film 41 side of the light absorption film 47, the total thicknesses hla, hlb, and h1c of the first dielectric film 42-1 and the second dielectric film 43-1 in the first to third filter parts 51a, 51b, and 51c are designed to be the same. Likewise, on the second metal film 44 side of the light absorption film 47, the total thicknesses h2a, h2b, and h2c of the first dielectric film 42-2 and the second dielectric film 43-2 in the first to third filter parts 51a, 51b, and 51c are designed to be the same.

In other words, in the optical filter layer 50E of the fifth embodiment as well, the thickness of the resonance layer 52E between the first metal film 41 and the second metal film 44 is generally the same in each of the first to third filter parts 51a, 51b, and 51c.

### <Steps and Flat Surface>

As illustrated in Figs. 28 and 29, on the first metal film 41 side of the light absorption film 47, the surface layer part 43-1S on the light absorption film 47 side of the second dielectric film 43-1 and the surface layer part 42-1S on the light absorption film 47 side of the first dielectric film 42-1 are flat across the pixels 3 adjacent to each other.

As illustrated in Figs. 28 and 29, on the second metal film 44 side of the light absorption film 47, the surface layer part 43-2S on the second metal film 44 side of the second dielectric film 43-2 is flat across the pixels 3 (the photoelectric conversion regions 21) adjacent to each other. The second dielectric film 43-2 covers the entirety of the first dielectric film 42-2 across the pixels 3 adjacent to each other such that the steps produced by the differences in the thickness of the first dielectric film 42-2 in the lower layer are embedded and the surface layer part 43-2s on the second metal film 44 side is a flat, even surface.

### <<Main Effects of Fifth Embodiment>>

The solid-state image capturing device 1E according to the fifth embodiment provides effects similar to those of the solid-state image capturing device 1C according to the third embodiment described above.

### [Sixth Embodiment]

A solid-state image capturing device 1F according to a sixth embodiment of the present technique, illustrated in Figs. 30 to 32, has basically the same configuration as the solid-state image capturing device 1C according to the third embodiment described above, with the exception of the following configurations.

First, as illustrated in Figs. 30 to 32, the solid-state image capturing device 1F according to the sixth embodiment of the present technique includes an optical filter layer 50F instead of the optical filter layer 50C illustrated in Figs. 12 to 14 described above in the third embodiment. Furthermore, in the optical filter layer 50F of the sixth embodiment, the configuration on the first metal film 41 side of the light absorption film 47 and the configuration on the second metal film 44 side of the light absorption film 47 are inverted vertically from those in the optical filter layer 50D of the fourth embodiment described above.

### <Optical Filter Layer>

As illustrated in Fig. 30, the optical filter layer 50F of the sixth embodiment includes: the first metal film 41 provided on the second surface S2 side (the light incidence surface side) of the semiconductor layer 20 with the insulating layer 35 located therebetween; the first dielectric film (high refraction film) 42 and the second dielectric film (low refraction film) 43, which are arranged in the thickness direction of the semiconductor layer 20 side by side on the side of the first metal film 41 opposite from the side on which the semiconductor layer 20 is located, and which have different refractive indices from each other; the second metal film 44 provided on the side of the first and second dielectric films 42 and 43 opposite from the side on which the first metal film 41 is located; and the light absorption film 47 provided between the first dielectric film 42 and the second dielectric film 43.

The optical filter layer 50F of the sixth embodiment further includes one first dielectric film 42-1 as the first dielectric film 42, and two second dielectric films 43-1 and 43-2 as the second dielectric film 43. In other words, the optical filter layer 50F of the fifth embodiment includes a resonance layer 52F in which the second dielectric film 43-1, the first dielectric film 42-1, the light absorption film 47, and the second dielectric film 43-2 are stacked in that order from the first metal film 41 side. The resonance layer 52F is provided between the first metal film 41 and the second metal film 44.

As illustrated in Fig. 30, each of the first metal film 41, the second dielectric film 43-1, the first dielectric film 42-1, the light absorption film 47, the second dielectric film 43-2, and the second metal film 44 is provided across, for example, five of the pixels 3, as in the third embodiment described above.

### <Second Dielectric Film on First Metal Film Side>

As illustrated in Figs. 31 and 32, the second dielectric film 43-1 located further on the first metal film 41 side than the light absorption film 47 includes the first part 43-1a which overlaps with the photoelectric conversion region 21a of the pixel 3a in plan view, the second part 43-lb which overlaps with the photoelectric conversion region 21b of the pixel 3b in plan view and which is thinner than the first part 43-1a, and the third part 43-1c which overlaps with the photoelectric conversion region 21c of the pixel 3c in plan view and which is thinner than the second part 43-lb. In other words, the thickness of the second dielectric film 43-1 in this embodiment is different for each of the pixels 3a, 3b, and 3c (the photoelectric conversion regions 21a, 21b, and 21c), and the thickness decreases in stages in order of the pixels 3a, 3b, and 3c.

### <First Dielectric Film on First Metal Film Side>

As illustrated in Figs. 31 and 32, the first dielectric film 42-1 further on the first metal film 41 side than the light absorption film 47 includes the first part 42-1a which overlaps with the first part 43-1a of the second dielectric film 43-1 in plan view, the second part 42-1b which overlaps with the second part 43-1b of the second dielectric film 43-1 in plan view and which is thicker than the first part 42-1a of the first dielectric film 42-1, and the third part 42-1c which overlaps with the third part 43-1c of the second dielectric film 43-1 in plan view and which is thicker than the second part 42-1b of the first dielectric film 42-1. In other words, the thickness of the first dielectric film 42-1 in this embodiment is different for each of the pixels 3a, 3b, and 3c (the photoelectric conversion regions 21a, 21b, and 21c), and, opposite from the second dielectric film 43-1, the thickness increases in stages in order of the pixels 3a, 3b, and 3c.

### <Second Dielectric Film on Second Metal Film Side>

As illustrated in Figs. 31 and 32, the second dielectric film 43-2 located further on the second metal film 44 side than the light absorption film 47 is provided continuously across each of the pixels 3a, 3b, and 3c (the photoelectric conversion regions 21a, 21b, and 21c) at a constant thickness, unlike the second dielectric film 43-2 of the third embodiment described above. In other words, the second dielectric film 43-2 of this embodiment includes the first part 43-2a which overlaps with the first part 42-1a of the first dielectric film 42-1 (the photoelectric conversion region 21a of the pixel 3a) in plan view, the second part 43-2b which overlaps with the second part 42-1b of the first dielectric film 42-1 (the photoelectric conversion region 21b of the pixel 3b) in plan view, and the third part 43-2c which overlaps with the third part 42-1c of the first dielectric film 42-1 (the photoelectric conversion region 21c of the pixel 3c) in plan view. Each of the first to third parts 43-2a, 43-2b, and 43-2c is designed to have the same thickness.

### <Light Absorption Film>

As illustrated in Figs. 31 and 32, like the fourth embodiment described above, the light absorption film 47 of this embodiment is provided continuously across the pixels 3a, 3b, and 3c. Although not limited thereto, the design value for the thickness of the light absorption film 47 is the same across the pixels 3a, 3b, and 3c.

### <Filter Parts>

As illustrated in Figs. 31 and 32, the optical filter layer 50F includes the first filter part 51a which overlaps with the photoelectric conversion region 21a of the pixel 3a in plan view, the second filter part 51b which overlaps with the photoelectric conversion region 21b of the pixel 3b in plan view, and the third filter part 51c which overlaps with the photoelectric conversion region 21c of the pixel 3c in plan view.

As illustrated in Fig. 31, the first filter part 51a includes the first part 43-1a of the second dielectric film 43-1, the first part 42-1a of the first dielectric film 42-1, the light absorption film 47, and the first part 43-2a of the second dielectric film 43-2, in that order from the first metal film 41 side, between the first metal film 41 and the second metal film 44.

As illustrated in Figs. 31 and 32, the second filter part 51b includes the second part 43-1b of the second dielectric film 43-1, the second part 42-1b of the first dielectric film 42-1, the light absorption film 47, the second part 42-2b of the first dielectric film 42-2, and the second part 43-2b of the second dielectric film 43-2, in that order from the first metal film 41 side, between the first metal film 41 and the second metal film 44.

As illustrated in Fig. 32, the third filter part 51c includes the third part 43-1c of the second dielectric film 43-1, the third part 42-1c of the first dielectric film 42-1, the light absorption film 47, the third part 42-2c of the first dielectric film 42-2, and the third part 43-2c of the second dielectric film 43-2, in that order from the first metal film 41 side, between the first metal film 41 and the second metal film 44.

Here, the second dielectric film 43 is provided on both the first metal film 41 side and the second metal film 44 side of the light absorption film 47, in each of the first to third filter parts 51a to 51c. On the other hand, the first dielectric film 42 is provided only on one of the first metal film 41 side and the second metal film 44 side of the light absorption film 47, in each of the first to third filter parts 51a to 51c. In the sixth embodiment, the first dielectric film 42 is provided on the first metal film 41 side of the light absorption film 47, and is not provided on the second metal film 44 side of the light absorption film 47.

### <Film Thicknesses>

As illustrated in Figs. 31 and 32, on the first metal film 41 side of the light absorption film 47, in each of the first to third filter parts 51a, 51b, and 51c, the ratios of the thicknesses of the first dielectric film 42-1 and the second dielectric film 43-1 are different. On the other hand, on the second metal film 44 side of the light absorption film 47, the single-layer second dielectric film 43-2 is provided at the same thickness across the first to third filter parts 51a, 51b, and 51c.

Furthermore, on the first metal film 41 side of the light absorption film 47, the total thicknesses hla, hlb, and h1c of the first dielectric film 42-1 and the second dielectric film 43-1 in the first to third filter parts 51a, 51b, and 51c are designed to be the same. Likewise, on the second metal film 44 side of the light absorption film 47, the thicknesses h2a, h2b, and h2c of the second dielectric film 43-2 in the first to third filter parts 51a, 51b, and 51c are designed to be the same.

In other words, like the resonance layer 52C of the third embodiment described above, in the optical filter layer 50F of the sixth embodiment, the thickness of the resonance layer 52F between the first metal film 41 and the second metal film 44 is generally the same in each of the first to third filter parts 51a, 51b, and 51c.

### <Steps and Flat Surface>

As illustrated in Figs. 31 and 32, on the first metal film 41 side of the light absorption film 47, the surface layer part 42-1S on the light absorption film 47 side of the first dielectric film 42-1 is flat across the pixels 3 adjacent to each other. The first dielectric film 42-1 covers the entirety of the second dielectric film 43-1 across the pixels 3 adjacent to each other such that the steps produced by the differences in the thickness of the second dielectric film 43-1 in the lower layer are embedded and the surface layer part 42-1S on the light absorption film 47 side (the second metal film 44 side) is a flat, even surface. As illustrated in Figs. 31 and 32, on the second metal film 44 side of the light absorption film 47, the surface layer part 43-2S on the second metal film 44 side of the second dielectric film 43-2 is flat across the pixels 3 adjacent to each other.

### <<Main Effects of Sixth Embodiment>>

The solid-state image capturing device 1F according to the sixth embodiment provides effects similar to those of the solid-state image capturing device 1C according to the third embodiment described above.

### [Seventh Embodiment]

A solid-state image capturing device 1G according to a seventh embodiment of the present technique, illustrated in Figs. 33 to 35, has basically the same configuration as the solid-state image capturing device 1C according to the fourth embodiment described above, with the exception of the following configurations.

First, as illustrated in Figs. 33 to 35, the solid-state image capturing device 1G according to the seventh embodiment of the present technique includes an optical filter layer 50G instead of the optical filter layer 50C illustrated in Figs. 12 to 14 described above in the third embodiment. The other configurations are generally the same as those described in the foregoing third embodiment.

### <Optical Filter Layer>

As illustrated in Fig. 33, the optical filter layer 50G of the seventh embodiment includes: the first metal film 41 provided on the second surface S2 side (the light incidence surface side) of the semiconductor layer 20 with the insulating layer 35 located therebetween; the first dielectric film (high refraction film) 42 and the second dielectric film (low refraction film) 43, which are arranged in the thickness direction of the semiconductor layer 20 side by side on the side of the first metal film 41 opposite from the side on which the semiconductor layer 20 is located, and which have different refractive indices from each other; the second metal film 44 provided on the side of the first and second dielectric films 42 and 43 opposite from the side on which the first metal film 41 is located; and the light absorption film 47 provided between the first dielectric film 42 and the second dielectric film 43.

The optical filter layer 50G of the seventh embodiment further includes two first dielectric films 42-1 and 42-2 as the first dielectric film 42, and one second dielectric film 43-2 as the second dielectric film 43. In other words, the optical filter layer 50G of the seventh embodiment includes a resonance layer 52G in which the second dielectric film 43-1, the light absorption film 47, the first dielectric film 42-2, and the second dielectric film 43-2 are stacked in that order from the first metal film 41 side. The resonance layer 52G is provided between the first metal film 41 and the second metal film 44.

As illustrated in Fig. 33, each of the first metal film 41, the second dielectric film 43-1, the light absorption film 47, the second dielectric film 43-2, and the second metal film 44 is provided across, for example, five of the pixels 3, as in the third embodiment described above. Meanwhile, the first dielectric film 42-2 is selectively provided in the second filter part 51b and the second filter part 51c of the optical filter layer 50E, and is not provided in the first filter part 51a, as in the fifth embodiment described above.

### <First Dielectric Film on First Metal Film Side>

As illustrated in Figs. 34 and 35, the first dielectric film 42-1 located further on the first metal film 41 side than the light absorption film 47 is provided continuously across each of the pixels 3a, 3b, and 3c (the photoelectric conversion regions 21a, 21b, and 21c) at a constant thickness. Furthermore, the first dielectric film 42-1 includes the first part 42-1a which overlaps with the photoelectric conversion region 21a of the pixel 3a in plan view, the second part 42-1b which overlaps with the photoelectric conversion region 21b of the pixel 3b in plan view, and the third part 42-1c which overlaps with the photoelectric conversion region 21c of the pixel 3c in plan view. The respective thicknesses of the first to third parts 42-1a, 42-1b, and 42-1c (hla, hlb, and h1c) are designed to be the same.

### <First and Second Dielectric Films on Second Metal Film Side>

As illustrated in Figs. 34 and 35, the first dielectric film 42-2 located further on the second metal film 44 side than the light absorption film 47 does not include a first part which overlaps with the photoelectric conversion region 21a of the pixel 3a in plan view. Furthermore, as illustrated in Figs. 34 and 35, the first dielectric film 42-2 includes the second part 42-2b which overlaps with the second part 42-1b of the first dielectric film 42-1 (the photoelectric conversion region 21b of the pixel 3b) in plan view, and the third part 42-2c which overlaps with the third part 42-1c of the first dielectric film 42-1 (the photoelectric conversion region 21c of the pixel 3c) in plan view and which is thicker than the second part 42-2b of the first dielectric film 42-2. In other words, the thickness of the first dielectric film 42-2 of the seventh embodiment is different for each of the pixels 3b and 3c (the photoelectric conversion regions 21b and 21c), and the thickness increases in stages in order of the pixels 3b and 3c.

As illustrated in Figs. 34 and 35, the second dielectric film 43-2 located further on the second metal film 44 side than the light absorption film 47 includes the first part 43-2a which overlaps with the first part 42-1a of the first dielectric film 42-1 (the photoelectric conversion region 21a of the pixel 3a) in plan view, the second part 43-2b which overlaps with the second part 42-2b of the first dielectric film 42-2 in plan view and which is thinner than the second dielectric film 43-2a, and the third part 43-2c which overlaps with the third part 42-2c of the first dielectric film 42-2 in plan view and which is thicker than the second part 43-2b of the second dielectric film 43-2. In other words, the thickness of the second dielectric film 43-2 is different for each of the pixels 3a, 3b, and 3c (the photoelectric conversion regions 21a, 21b, and 21c), and, opposite from the first dielectric film 42-2, the thickness decreases in stages in order of the pixels 3a, 3b, and 3c.

### <Light Absorption Film>

As illustrated in Figs. 34 and 35, like the third embodiment described above, the light absorption film 47 of this embodiment is provided continuously across the pixels 3a, 3b, and 3c. Although not limited thereto, the design value for the thickness of the light absorption film 47 is the same across the pixels 3a, 3b, and 3c.

### <Filter Parts>

As illustrated in Figs. 34 and 35, the optical filter layer 50G includes the first filter part 51a which overlaps with the photoelectric conversion region 21a of the pixel 3a in plan view, the second filter part 51b which overlaps with the photoelectric conversion region 21b of the pixel 3b in plan view, and the third filter part 51c which overlaps with the photoelectric conversion region 21c of the pixel 3c in plan view.

As illustrated in Fig. 34, the first filter part 51a includes the first part 42-1a of the first dielectric film 42-1, the light absorption film 47, and the first part 43-2a of the second dielectric film 43-2, in that order from the second metal film 41 side, between the first metal film 41 and the second metal film 44.

As illustrated in Figs. 34 and 35, the second filter part 51b includes the second part 42-1b of the first dielectric film 42-1, the light absorption film 47, the second part 42-2b of the first dielectric film 42-2, and the second part 43-2b of the second dielectric film 43-2, in that order from the second metal film 41 side, between the first metal film 41 and the second metal film 44.

As illustrated in Fig. 35, the third filter part 51c includes the third part 42-1c of the first dielectric film 42-1, the light absorption film 47, the third part 42-2c of the first dielectric film 42-2, and the third part 43-2c of the second dielectric film 43-2, in that order from the second metal film 41 side, between the first metal film 41 and the second metal film 44.

Here, the second dielectric film 43 is provided only on one of the first metal film 41 side and the second metal film 44 side of the light absorption film 47, in each of the first to third filter parts 51a to 51c. On the other hand, the first dielectric film 42 is provided on one of the first metal film 41 side or the second metal film 44 side of the light absorption film 47 in the first filter part 51a, and on both the first metal film 41 side and the second metal film 44 side of the light absorption film 47 in the second and third filter parts. In the seventh embodiment, in the first filter part 51a, the first dielectric film 42 is provided on the second metal film 44 side of the light absorption film 47, and is not provided on the second metal film 44 side of the light absorption film 47.

### <Film Thicknesses>

As illustrated in Figs. 34 and 35, on the second metal film 44 side of the light absorption film 47, in each of the first to third filter parts 51a, 51b, and 51c, the ratios of the thicknesses of the first dielectric film 42-2 and the second dielectric film 43-2 are different. On the other hand, on the first metal film 41 side of the light absorption film 47, the single-layer first dielectric film 42-1 is provided at the same thickness across the first to third filter parts 51a, 51b, and 51c.

Furthermore, on the first metal film 41 side of the light absorption film 47, the total thicknesses hla, hlb, and h1c of the first dielectric film 42-1 and the second dielectric film 43-1 in the first to third filter parts 51a, 51b, and 51c are designed to be the same. Likewise, on the second metal film 44 side of the light absorption film 47, the total thicknesses h2a, h2b, and h2c of the first dielectric film 42-2 and the second dielectric film 43-2 in the first to third filter parts 51a, 51b, and 51c are designed to be the same. In other words, in the optical filter layer 50F of the seventh embodiment as well, the thickness of the resonance layer 52F between the first metal film 41 and the second metal film 44 is generally the same in each of the first to third filter parts 51a, 51b, and 51c.

### <Steps and Flat Surface>

As illustrated in Figs. 34 and 35, on the first metal film 41 side of the light absorption film 47, the surface layer part 42-1S on the light absorption film 47 side of the first dielectric film 42-1 is flat across the pixels 3 adjacent to each other.

As illustrated in Figs. 34 and 35, on the second metal film 44 side of the light absorption film 47, the surface layer part 43-2S on the second metal film 44 side of the second dielectric film 43-2 is flat across the pixels 3 adjacent to each other. The second dielectric film 43-2 covers the entirety of the first dielectric film 42-2 across the pixels 3 adjacent to each other such that the steps produced by the differences in the thickness of the first dielectric film 42-2 in the lower layer are embedded and the surface layer part 43-2s on the second metal film 44 side is a flat, even surface.

### <<Main Effects of Seventh Embodiment>>

The solid-state image capturing device 1G according to the seventh embodiment provides effects similar to those of the solid-state image capturing device 1C according to the third embodiment described above.

### [Eighth Embodiment]

A solid-state image capturing device 1H according to an eighth embodiment of the present technique, illustrated in Figs. 36 to 38, has basically the same configuration as the solid-state image capturing device 1C according to the third embodiment described above, with the exception of the following configurations.

First, as illustrated in Figs. 36 to 38, the solid-state image capturing device 1H according to the eighth embodiment of the present technique includes an optical filter layer 50H instead of the optical filter layer 50C illustrated in Figs. 12 to 14 described above in the third embodiment. Furthermore, in the optical filter layer 50H of the eighth embodiment, the configuration on the first metal film 41 side of the light absorption film 47 and the configuration on the second metal film 44 side of the light absorption film 47 are inverted vertically from those in the optical filter layer 50G of the seventh embodiment described above. The other configurations are generally the same as those described in the foregoing third embodiment.

### <Optical Filter Layer>

As illustrated in Fig. 36, the optical filter layer 50H of the eighth embodiment includes: the first metal film 41 provided on the second surface S2 side (the light incidence surface side) of the semiconductor layer 20 with the insulating layer 35 located therebetween; the first dielectric film (high refraction film) 42 and the second dielectric film (low refraction film) 43, which are arranged in the thickness direction of the semiconductor layer 20 side by side on the side of the first metal film 41 opposite from the side on which the semiconductor layer 20 is located, and which have different refractive indices from each other; the second metal film 44 provided on the side of the first and second dielectric films 42 and 43 opposite from the side on which the first metal film 41 is located; and the light absorption film 47 provided between the first dielectric film 42 and the second dielectric film 43.

The optical filter layer 50H of the eighth embodiment further includes two first dielectric films 42-1 and 42-2 as the first dielectric film 42, and one second dielectric film 43-1 as the second dielectric film 43. In other words, the optical filter layer 50H of the eighth embodiment includes a resonance layer 52H in which the second dielectric film 43-1, the first dielectric film 42-1, the light absorption film 47, and the first dielectric film 42-2 are stacked in that order from the first metal film 41 side. The resonance layer 52H is provided between the first metal film 41 and the second metal film 44.

As illustrated in Fig. 36, each of the first metal film 41, the second dielectric film 43-1, the light absorption film 47, the first dielectric film 42-2, and the second metal film 44 is provided continuously across, for example, five of the pixels 3. Meanwhile, the first dielectric film 42-1 is selectively provided in the second filter part 51b and the second filter part 51c of the optical filter layer 50H, and is not provided in the first filter part 51a.

### <First and Second Dielectric Films on First Metal Film Side>

As illustrated in Figs. 37 and 38, the second dielectric film 43-1 located further on the first metal film 41 side than the light absorption film 47 includes the first part 43-1a which overlaps with the photoelectric conversion region 21a of the pixel 3a in plan view, the second part 43-1b which overlaps with the photoelectric conversion region 21b of the pixel 3b in plan view and which is thinner than the first part 43-1a, and the third part 43-1c which overlaps with the photoelectric conversion region 21c of the pixel 3c in plan view and which is thinner than the second part 43-1b. In other words, the thickness of the second dielectric film 43-1 is different for each of the pixels 3a, 3b, and 3c (the photoelectric conversion regions 21a, 21b, and 21c), and the thickness decreases in stages in order of the pixels 3a, 3b, and 3c.

As illustrated in Figs. 37 and 38, the first dielectric film 42-1 located further on the first metal film 41 side than the light absorption film 47 does not include a first part which overlaps with the first part 43-1a of the second dielectric film 43-1 (the photoelectric conversion region 21a of the pixel 3a) in plan view. Furthermore, as illustrated in Figs. 37 and 38, the first dielectric film 42-1 includes the second part 42-1b which overlaps with the second part 43-1b of the second dielectric film 43-1 (the photoelectric conversion region 21b of the pixel 3b) in plan view, and the third part 42-1c which overlaps with the third part 43-1c of the second dielectric film 43-1 (the photoelectric conversion region 21c of the pixel 3c) in plan view and which is thicker than the second part 42-1b of the first dielectric film 42-1. In other words, the thickness of the first dielectric film 42-1 of the eighth embodiment is different for each of the pixels 3b and 3c (the photoelectric conversion regions 21b and 21c), and the thickness increases in stages in order of the pixels 3b and 3c.

### <First Dielectric Film on Second Metal Film Side>

As illustrated in Figs. 37 and 38, the first dielectric film 42-2 located further on the second metal film 44 side than the light absorption film 47 is provided continuously across each of the pixels 3a, 3b, and 3c (the photoelectric conversion regions 21a, 21b, and 21c) at a constant thickness. Furthermore, the first dielectric film 42-2 includes the first part 42-2a which overlaps with the first part 43-1a of the second dielectric film 43-1 (the photoelectric conversion region 21a of the pixel 3a) in plan view, the second part 42-2b which overlaps with the second part 42-1b of the first dielectric film 42-1 (the photoelectric conversion region 21b of the pixel 3b) in plan view, and the third part 42-2c which overlaps with the third part 42-1c of the first dielectric film 42-1 (the photoelectric conversion region 21c of the pixel 3c) in plan view. Each of the first to third parts 42-2a, 42-2b, and 42-2c is designed to have the same thickness.

### <Light Absorption Film>

As illustrated in Figs. 37 and 38, the light absorption film 47 of this embodiment is provided continuously across the pixels 3a, 3b, and 3c. Although not limited thereto, the design value for the thickness of the light absorption film 47 is the same across the pixels 3a, 3b, and 3c.

### <Filter Parts>

As illustrated in Figs. 37 and 38, the optical filter layer 50H includes the first filter part 51a which overlaps with the photoelectric conversion region 21a of the pixel 3a in plan view, the second filter part 51b which overlaps with the photoelectric conversion region 21b of the pixel 3b in plan view, and the third filter part 51c which overlaps with the photoelectric conversion region 21c of the pixel 3c in plan view.

As illustrated in Fig. 37, the first filter part 51a includes the first part 43-1a of the second dielectric film 43-1, the light absorption film 47, and the first part 42-2a of the first dielectric film 42-2, in that order from the first metal film 41 side, between the first metal film 41 and the second metal film 44.

As illustrated in Figs. 37 and 38, the second filter part 51b includes the second part 43-1b of the second dielectric film 43-1, the second part 42-1b of the first dielectric film 42-1, the light absorption film 47, and the second part 42-2b of the first dielectric film 42-2, in that order from the first metal film 41 side, between the first metal film 41 and the second metal film 44.

As illustrated in Fig. 38, the third filter part 51c includes the third part 43-1c of the second dielectric film 43-1, the third part 42-1c of the first dielectric film 42-1, the light absorption film 47, and the third part 42-2c of the first dielectric film 42-2, in that order from the first metal film 41 side, between the first metal film 41 and the second metal film 44.

Here, the second dielectric film 43 is provided only on one of the first metal film 41 side and the second metal film 44 side of the light absorption film 47, in each of the first to third filter parts 51a to 51c. On the other hand, the first dielectric film 42 is provided on one of the first metal film 41 side or the second metal film 44 side of the light absorption film 47 in the first filter part 51a, and on both the first metal film 41 side and the second metal film 44 side of the light absorption film 47 in the second and third filter parts. In the eighth embodiment, in the first filter part 51a, the first dielectric film 42 is provided on the second metal film 44 side of the light absorption film 47, and is not provided on the first metal film 41 side of the light absorption film 47.

### <Film Thicknesses>

As illustrated in Figs. 37 and 38, on the first metal film 41 side of the light absorption film 47, in each of the first to third filter parts 51a, 51b, and 51c, the ratios of the thicknesses of the first dielectric film 42-1 and the second dielectric film 43-1 are different. On the other hand, on the second metal film 44 side of the light absorption film 47, the single-layer first dielectric film 42-1 is provided at the same thickness across the first to third filter parts 51a, 51b, and 51c.

Furthermore, on the first metal film 41 side of the light absorption film 47, the total thicknesses hla, hlb, and h1c of the first dielectric film 42-1 and the second dielectric film 43-1 in the first to third filter parts 51a, 51b, and 51c are designed to be the same. Likewise, on the second metal film 44 side of the light absorption film 47, the total thicknesses h2a, h2b, and h2c of the first dielectric film 42-2 and the second dielectric film 43-2 in the first to third filter parts 51a, 51b, and 51c are designed to be the same.

In other words, in the optical filter layer 50H of the eighth embodiment as well, the thickness of the resonance layer 52H between the first metal film 41 and the second metal film 44 is generally the same in each of the first to third filter parts 51a, 51b, and 51c.

### <Steps and Flat Surface>

As illustrated in Figs. 37 and 38, on the first metal film 41 side of the light absorption film 47, the surface layer part 43-1S on the light absorption film 47 side of the second dielectric film 43-1 and the surface layer part 42-1S on the light absorption film 47 side of the first dielectric film 42-1 are flat across the pixels 3 adjacent to each other. The surface layer part 42-1S on the light absorption film 47 side of the first dielectric film 42-1 is also flat across the pixels 3 adjacent to each other.

As illustrated in Figs. 37 and 38, on the second metal film 44 side of the light absorption film 47, the surface layer part 43-2S on the second metal film 44 side of the second dielectric film 43-2 is flat across the pixels 3 adjacent to each other.

### <<Main Effects of Eighth Embodiment>>

The solid-state image capturing device 1H according to the eighth embodiment provides effects similar to those of the solid-state image capturing device 1C according to the third embodiment described above.

### [Ninth Embodiment]

A solid-state image capturing device 1I according to a ninth embodiment of the present technique, illustrated in Figs. 39 to 41, has basically the same configuration as the solid-state image capturing device 1C according to the third embodiment described above, with the exception of the following configurations.

First, as illustrated in Figs. 39 to 41, the solid-state image capturing device 1I according to the ninth embodiment of the present technique includes an optical filter layer 50I instead of the optical filter layer 50C illustrated in Figs. 12 to 14 described above in the third embodiment. The optical filter layer 50I of the ninth embodiment differs from the optical filter layer 50C of the third embodiment described above in terms of the location of the light absorption film 47 in the thickness direction (Z direction) in each filter part.

### <Optical Filter Layer>

As illustrated in Fig. 39, the optical filter layer 50I of the ninth embodiment includes: the first metal film 41 provided on the second surface S2 side (the light incidence surface side) of the semiconductor layer 20 with the insulating layer 35 located therebetween; the first dielectric film (high refraction film) 42 and the second dielectric film (low refraction film) 43, which are arranged in the thickness direction of the semiconductor layer 20 side by side on the side of the first metal film 41 opposite from the side on which the semiconductor layer 20 is located, and which have different refractive indices from each other; the second metal film 44 provided on the side of the first and second dielectric films 42 and 43 opposite from the side on which the first metal film 41 is located; and the light absorption film 47 provided between the first dielectric film 42 and the second dielectric film 43.

The optical filter layer 50I of the ninth embodiment further includes two first dielectric films 42-1 and 42-2 as the first dielectric film 42, and one second dielectric film 43-2 as the second dielectric film 43. In other words, the optical filter layer 50I of the ninth embodiment includes a resonance layer 52I in which the first dielectric film 42-1, the light absorption film 47, the first dielectric film 42-2, and the second dielectric film 43-2 are stacked in that order from the first metal film 41 side. The resonance layer 52I is provided between the first metal film 41 and the second metal film 44.

### <First Dielectric Film on First Metal Film Side>

As illustrated in Figs. 40 and 41, the first dielectric film 42-1 located further on the first metal film 41 side than the light absorption film 47 includes the first part 42-1a which overlaps with the photoelectric conversion region 21a of the pixel 3a in plan view, the second part 42-1b which overlaps with the photoelectric conversion region 21b of the pixel 3b in plan view and which is thicker than the first part 42-1a, and the third part 42- 1c which overlaps with the photoelectric conversion region 21c of the pixel 3c in plan view and which is thicker than the second part 42-1b. In other words, the thickness of the first dielectric film 42-1 of the ninth embodiment is different for each of the pixels 3a, 3b, and 3c (the photoelectric conversion regions 21a, 21b, and 21c), and the thickness increases in stages in order of the pixels 3a, 3b, and 3c.

### <First and Second Dielectric Films on Second Metal Film Side>

As illustrated in Figs. 40 and 41, the first dielectric film 42-2 located further on the second metal film 44 side than the light absorption film 47 is provided on each of the pixels 3a, 3b, and 3c (the photoelectric conversion regions 21a, 21b, and 21c) at a constant thickness. Furthermore, the first dielectric film 42-2 includes the first part 42-2a which overlaps with the first part 42-1a of the first dielectric film 42-1 (the photoelectric conversion region 21a of the pixel 3a) in plan view, the second part 42-2b which overlaps with the second part 42-1b of the first dielectric film 42-1 (the photoelectric conversion region 21b of the pixel 3b) in plan view, and the third part 42-2c which overlaps with the third part 42-1c of the first dielectric film 42-1 (the photoelectric conversion region 21c of the pixel 3c) in plan view. Each of the first to third parts 42-2a, 42-2b, and 42-2c is designed to have the same thickness.

As illustrated in Figs. 40 and 41, the second dielectric film 43-2 located further on the second metal film 41 side than the light absorption film 47 includes the first part 43-2a which overlaps with the first part 42-2a of the first dielectric film 42-2 in plan view, the second part 43-2b which overlaps with the second part 42-2b of the first dielectric film 42-2 in plan view and which is thinner than the first part 43-2a of the second dielectric film 43-2, and the third part 43-2c which overlaps with the third part 42-2c of the first dielectric film 42-2 in plan view and which is thinner than the second part 43-2b of the second dielectric film 43-2. In other words, the thickness of the second dielectric film 43-2 is different for each of the pixels 3a, 3b, and 3c (the photoelectric conversion regions 21a, 21b, and 21c), and the thickness decreases in stages in order of the pixels 3a, 3b, and 3c.

### <Light Absorption Film>

As illustrated in Figs. 40 and 41, the light absorption film 47 is provided for each of the pixels 3a, 3b, and 3c. Although not limited thereto, the design value for the thickness of the light absorption film 47 is the same for each of the pixels 3a, 3b, and 3c.

### <Filter Parts>

As illustrated in Figs. 40 and 41, the optical filter layer 50I includes the first filter part 51a which overlaps with the photoelectric conversion region 21a of the pixel 3a in plan view, the second filter part 51b which overlaps with the photoelectric conversion region 21b of the pixel 3b in plan view, and the third filter part 51c which overlaps with the photoelectric conversion region 21c of the pixel 3c in plan view.

As illustrated in Fig. 40, the first filter part 51a includes the first part 42-1a of the first dielectric film 42-1, the light absorption film 47, the first part 42-2a of the first dielectric film 42-2, and the first part 43-2a of the second dielectric 43-2, in that order from the first metal film 41 side, between the first metal film 41 and the second metal film 44.

As illustrated in Figs. 40 and 41, the second filter part 51b includes the second part 42-1b of the first dielectric film 42-1, the light absorption film 47, the second part 42-2b of the first dielectric film 42-2, and the second part 43-2b of the second dielectric film 43-2, in that order from the first metal film 41 side, between the first metal film 41 and the second metal film 44. The light absorption film 47 in the second filter part 51b is located further on the second metal film 44 side than the light absorption film 47 in the first filter part 51a. The second part 42-2b of the first dielectric film 42-2 in the second filter part 51b is also located further on the second metal film 44 side than the first part 42-2a of the first dielectric film 42-2 in the first filter part 51a.

As illustrated in Fig. 41, the third filter part 51c includes the third part 42-1c of the first dielectric film 42-1, the light absorption film 47, the third part 42-3b of the first dielectric film 42-2, and the third part 43-3b of the second dielectric film 43-2, in that order from the first metal film 41 side, between the first metal film 41 and the second metal film 44. The light absorption film 47 in the third filter part 51c is located further on the second metal film 44 side than the light absorption film 47 in the second filter part 51b. The third part 42-2c of the first dielectric film 42-2 in the third filter part 51c is also located further on the second metal film 44 side than the second part 42-2b of the first dielectric film 42-2 in the second filter part 51b.

In other words, the position, in the thickness direction of the optical filter layer 50I, of the light absorption film 47 is different in each of the first to third filter parts 51a, 51b, and 51c. In this ninth embodiment, the position of the light absorption film 47 in each of the first to third filter parts 51a, 51b, and 51c is displaced in stages toward the second metal film 44 side, in that order.

### <Film Thicknesses>

As illustrated in Figs. 40 and 41, in each of the first to third filter parts 51a, 51b, and 51c, the ratios of the thicknesses of the first dielectric film 42 and the second dielectric film 43 are different.

Furthermore, on the first metal film 41 side of the light absorption film 47, total thicknesses ha, hb, and hc of the first dielectric film 42-1 and the second dielectric film 43-1 in the first to third filter parts 51a, 51b, and 51c, respectively, are designed to be the same.

The solid-state image capturing device 1I according to the ninth embodiment provides effects similar to those of the solid-state image capturing device 1C according to the third embodiment described above.

### [Tenth Embodiment]

A solid-state image capturing device 1J according to a tenth embodiment of the present technique, illustrated in Figs. 42 to 44, has basically the same configuration as the solid-state image capturing device 1C according to the third embodiment described above, with the exception of the following configurations.

First, as illustrated in Figs. 42 to 44, the solid-state image capturing device 1J according to the tenth embodiment of the present technique includes an optical filter layer 50J instead of the optical filter layer 50C illustrated in Figs. 12 to 14 described above in the third embodiment. In the optical filter layer 50J of the tenth embodiment, the configuration on the first metal film 41 side of the light absorption film 47 and the configuration on the second metal film 44 side of the light absorption film 47 are inverted vertically from those in the optical filter layer 50I of the ninth embodiment described above. Furthermore, in the tenth embodiment, the first filter part 51a is configured not to include a first dielectric film on the first metal film 41 side of the light absorption film.

### <Optical Filter Layer>

As illustrated in Fig. 42, the optical filter layer 50J of the tenth embodiment includes: the first metal film 41 provided on the second surface S2 side (the light incidence surface side) of the semiconductor layer 20 with the insulating layer 35 located therebetween; the first dielectric film (high refraction film) 42 and the second dielectric film (low refraction film) 43, which are arranged in the thickness direction of the semiconductor layer 20 side by side on the side of the first metal film 41 opposite from the side on which the semiconductor layer 20 is located, and which have different refractive indices from each other; the second metal film 44 provided on the side of the first and second dielectric films 42 and 43 opposite from the side on which the first metal film 41 is located; and the light absorption film 47 provided between the first dielectric film 42 and the second dielectric film 43.

The optical filter layer 50J of the tenth embodiment further includes two first dielectric films 42-1 and 42-2 as the first dielectric film 42, and one second dielectric film 43-1 as the second dielectric film 43. In other words, the optical filter layer 50I of the tenth embodiment includes a resonance layer 52J in which the second dielectric film 43-1, the first dielectric film 42-1, the light absorption film 47, and the first dielectric film 42-2 are stacked in that order from the first metal film 41 side. The resonance layer 52J is provided between the first metal film 41 and the second metal film 44.

### <First and Second Dielectric Films on First Metal Film Side>

As illustrated in Figs. 43 and 44, the second dielectric film 43-1 located further on the first metal film 41 side than the light absorption film 47 includes the first part 43-1a which overlaps with the photoelectric conversion region 21a of the pixel 3a in plan view, the second part 43-1b which overlaps with the photoelectric conversion region 21b of the pixel 3b in plan view and which is thinner than the first part 43-1a, and the third part 43-1c which overlaps with the photoelectric conversion region 21c of the pixel 3c in plan view and which is thinner than the second part 43-1b. In other words, the thickness of the second dielectric film 43-1 is different for each of the pixels 3a, 3b, and 3c (the photoelectric conversion regions 21a, 21b, and 21c), and the thickness decreases in stages in order of the pixels 3a, 3b, and 3c.

As illustrated in Figs. 43 and 44, the first dielectric film 42-1 located further on the first metal film 41 side than the light absorption film 47 does not include a first part which overlaps with the first part 43-1a of the second dielectric film 43-1 (the photoelectric conversion region 21a of the pixel 3a) in plan view. Additionally, as illustrated in Figs. 43 and 44, the first dielectric film 42-1 is provided on each of the pixels 3b and 3c (the photoelectric conversion regions 21b and 21c) at a constant thickness. Furthermore, the first dielectric film 42-1 includes the second part 42-1b which overlaps with the second part 43-1b of the second dielectric film 43-1 (the photoelectric conversion region 21b of the pixel 3b) in plan view, and the third part 42- 1c which overlaps with the third part 43- 1c of the second dielectric film 43-1 (the photoelectric conversion region 21c of the pixel 3c) in plan view. Each of the second and third parts 42-2b and 42-2c is designed to have the same thickness.

### <First Dielectric Film on Second Metal Film Side>

As illustrated in Figs. 43 and 44, the first dielectric film 42-2 located further on the second metal film 44 side than the light absorption film 47 includes the first part 42-2a which overlaps with the first part 43-1a of the second dielectric film 43-1 in plan view, the second part 42-2b which overlaps with the second part 42-1b of the first dielectric film 42-1 in plan view and which is thicker than the second part 42-2a of the first dielectric film 42-2, and the third part 42-2c which overlaps with the third part 43-1c of the first dielectric film 42-1 in plan view and which is thicker than the second part 42-2b of the first dielectric film 42-2. In other words, the thickness of the first dielectric film 42-2 of the tenth embodiment is different for each of the pixels 3a, 3b, and 3c (the photoelectric conversion regions 21a, 21b, and 21c), and the thickness increases in stages in order of the pixels 3a, 3b, and 3c.

### <Filter Parts>

As illustrated in Figs. 43 and 44, the optical filter layer 50J includes the first filter part 51a which overlaps with the photoelectric conversion region 21a of the pixel 3a in plan view, the second filter part 51b which overlaps with the photoelectric conversion region 21b of the pixel 3b in plan view, and the third filter part 51c which overlaps with the photoelectric conversion region 21c of the pixel 3c in plan view.

As illustrated in Fig. 43, the first filter part 51a includes the first part 43-1a of the second dielectric film 43-1, the light absorption film 47, and the first part 42-2a of the first dielectric film 42-2, in that order from the first metal film 41 side, between the first metal film 41 and the second metal film 44.

As illustrated in Figs. 43 and 44, the second filter part 51b includes the second part 43-1b of the second dielectric film 43-1, the second part 42-1b of the first dielectric film 42-1, the light absorption film 47, and the second part 42-1c of the first dielectric film 42-2, in that order from the first metal film 41 side, between the first metal film 41 and the second metal film 44. The light absorption film 47 in the second filter part 51b is located further on the first metal film 41 side than the light absorption film 47 in the first filter part 51a.

As illustrated in Fig. 44, the third filter part 51c includes the second part 42-1b of the first dielectric film 42-1, the second part 42-1c of the first dielectric film 42-1, the light absorption film 47, and the third part 42-2cb of the first dielectric film 42-2, in that order from the first metal film 41 side, between the first metal film 41 and the second metal film 44. The light absorption film 47 in the third filter part 51c is located further on the first metal film 41 side than the light absorption film 47 in the second filter part 51a. The third part 42-1c of the first dielectric film 42-1 in the third filter part 51c is also located further on the second metal film 41 side than the third part 42-1c of the first dielectric film 42-1 in the second filter part 51b.

In other words, the position, in the thickness direction of the optical filter layer 50J, of the light absorption film 47 is different in each of the first to third filter parts 51a, 51b, and 51c. In this tenth embodiment, the position of the light absorption film 47 in each of the first to third filter parts 51a, 51b, and 51c is displaced in stages toward the first metal film 41 side, in that order.

### <Film Thicknesses>

As illustrated in Figs. 43 and 44, in each of the first to third filter parts 51a, 51b, and 51c, the ratios of the thicknesses of the first dielectric film 42 and the second dielectric film 43 are different.

Furthermore, on the first metal film 41 side of the light absorption film 47, total thicknesses ha, hb, and hc of the first dielectric film 42 and the second dielectric film 43 in the first to third filter parts 51a, 51b, and 51c, respectively, are designed to be the same.

The solid-state image capturing device 1J according to the tenth embodiment provides effects similar to those of the solid-state image capturing device 1C according to the third embodiment described above.

### [Eleventh Embodiment]

A solid-state image capturing device 1K according to an eleventh embodiment of the present technique, illustrated in Fig. 45, has basically the same configuration as the solid-state image capturing device 1C according to the third embodiment described above, with the exception of the following configurations.

First, as illustrated in Fig. 45, the solid-state image capturing device 1K according to the eleventh embodiment of the present technique further includes a color filter layer 60. The color filter layer 60 is provided between the semiconductor layer 20 and the optical filter layer 50C. The color filter layer 60 includes, for example, a color filter part provided for each of the pixels 3 (each of the photoelectric conversion regions 21). Although not limited thereto, a red (R) first color filter part, a green (G) second color filter part, a blue (B) third color filter part, and the like are provided as the color filter parts, for example. In the eleventh embodiment, color filter parts having three colors, namely R, G, and B, for example, are provided. The color filter layer 60 separates the colors of the incident light incident from the light incidence surface side of the semiconductor chip 2.

The solid-state image capturing device 1K according to the eleventh embodiment provides effects similar to those of the solid-state image capturing device 1C according to the third embodiment described above.

In addition, in the solid-state image capturing device 1K according to the eleventh embodiment, color mixing can be eliminated by the color filter layer 60.

Note that the color filter layer 60 can also be provided in the solid-state image capturing device according to the first to tenth embodiments described above.

### [Twelfth Embodiment]

A solid-state image capturing device 1L according to a twelfth embodiment of the present technique, illustrated in Fig. 46, has basically the same configuration as the solid-state image capturing device 1C according to the third embodiment described above, with the exception of the following configurations.

First, as illustrated in Fig. 46, the solid-state image capturing device 1L according to the twelfth embodiment of the present technique further includes an antireflection layer 61 that prevents incident light from being reflected at the first metal film 41. The antireflection layer 61 is provided between the semiconductor layer 20 and the first metal film 41. For example, a silicon oxide film having excellent light transmittance can be used as the antireflection layer 61.

Fig. 47 is a diagram illustrating a correlation between transmittance and the presence or absence of the antireflection layer.

From Fig. 47, it can be seen that providing the antireflection layer 61 as in the twelfth embodiment has an effect of improving the transmittance, compared to when the antireflection layer is not provided.

The solid-state image capturing device 1L according to the twelfth embodiment can achieve effects similar to those of the solid-state image capturing device 1C according to the third embodiment described above, while improving the transmittance.

Note that the antireflection layer 61 can also be provided in the solid-state image capturing device according to the first to eleventh embodiment described above.

### [Thirteenth Embodiment]

### «Example of Application in Electronic Device»

The present technique (the technique according to the present disclosure) may be applied to various electronic devices, including image capturing devices such as digital still cameras and digital video cameras, mobile phones having image capturing functions, or other devices having image capturing functions, for example.

Fig. 48 is a diagram illustrating the overall configuration of an electronic device (e.g., a camera) according to the third embodiment of the present technique.

As illustrated in Fig. 48, an electronic device 100 includes a solid-state image capturing device 101, the optical lens 102, a shutter device 103, a driving circuit 104, and a signal processing circuit 105. This electronic device 100 corresponds to an embodiment in a case where one of the solid-state image capturing devices 1A to 1L according to the first to twelfth embodiments of the present technique is used as the solid-state image capturing device 101 in an electronic device (e.g., a camera).

The optical lens 102 forms an image of image light (incident light 106) from a subject on an image capturing plane of the solid-state image capturing device 101. As a result, signal charges are accumulated in the solid-state image capturing device 101 over a set period. The shutter device 103 controls a light emission period and a light shielding period for the solid-state image capturing device 101. The driving circuit 104 supplies a drive signal for controlling a transfer operation of the solid-state image capturing device 101 and a shutter operation of the shutter device 103. An operation of transferring a signal to the solid-state image capturing device 101 is performed according to the drive signal (timing signal) supplied from the driving circuit 104. The signal processing circuit 105 performs various types of signal processing on signals (pixel signals) output from the solid-state image capturing device 101. A video signal having been subjected to the signal processing is stored in a storage medium such as a memory or output to a monitor.

According to this configuration, the solid-state image capturing device 101 can achieve spectral separation at a low cost, and thus the electronic device 100 of the third embodiment can improve image quality at a low cost.

The electronic device 100 to which the solid-state image capturing device of the foregoing embodiments can be applied is not limited to a camera, and the solid-state image capturing device can be applied to other electronic devices as well. For example, the solid-state image capturing device may be applied in an image capturing device such as a camera module for a mobile device such as a mobile phone or a tablet terminal.

In addition to solid-state image capturing devices serving as image sensors as described above, the present technique can be applied in all types of light detection devices, including range sensors which measure distances, known as time of flight (ToF) sensors, and the like. A range sensor is a sensor that emits irradiated light toward an object, detects reflected light which returns when the irradiated light is reflected by a surface of the object, and calculates a distance to the object based on a time of flight from when the irradiated light is emitted to when the reflected light is received. The structure of the optical filter layer described above can be employed as the structure of a device isolation region in the range sensor.

The present technique may be configured as follows.
(1) A light detection device including:
   a semiconductor layer in which a photoelectric conversion unit is provided for each of pixels; and
   an optical filter layer provided on a light incidence surface side of the semiconductor layer,
   wherein
   the optical filter layer includes a first filter part and a second filter part, each provided for each of the pixels,
   each of the first and second filter parts includes:
      a first metal film provided on the light incidence surface side of the semiconductor layer;
      a first dielectric film and a second dielectric film which have different refractive indices and which are arranged in a thickness direction of the semiconductor layer side by side, on a side of the first metal film opposite from a side on which the semiconductor layer is located; and
      a second metal film provided on a side of the first and second dielectric films opposite from a side on which the first metal film is located, and
      a ratio of thicknesses of the first dielectric film and the second dielectric film is different in the first filter part and in the second filter part.
(2) The light detection device according to (1), wherein a total thickness of the first dielectric film and the second dielectric is the same in the first filter part and in the second filter part.
(3) The light detection device according to (1) or (2), wherein each of the first metal film, the first dielectric film, the second dielectric film, and the second metal film is provided across adjacent ones of the pixels.
(4) The light detection device according to any one of (1) to (3), wherein the first dielectric film is provided further on a first metal film side than the second dielectric film, and has a higher refractive index than the second dielectric film.
(5) The light detection device according to (4), wherein a surface layer part on a second dielectric film side of the first dielectric film has a step between adjacent ones of the pixels, and
   a surface layer part on a second metal film side of the second dielectric film is flat across adjacent ones of the pixels.
(6) The light detection device according to any one of (1) to (3), wherein the first dielectric film is provided further on a second metal film side than the second dielectric film, and has a higher refractive index than the second dielectric film.
(7) The light detection device according to (6), wherein a surface layer part on a first dielectric film side of the second dielectric film has a step between adjacent ones of the pixels, and a surface layer part on a second metal film side of the first dielectric film is flat across adjacent ones of the pixels.
(8) The light detection device according to any one of (1) to (7), wherein the first dielectric film is a film containing any one of titanium oxide, tantalum oxide, silicon nitride, or hafnium oxide, and
   the second dielectric film is a film containing any one of silicon oxide or silicon oxynitride.
(9) The light detection device according to any one of (1) to (8), wherein the first metal film is thicker than the second metal film.
(10) (The light detection device according to any one of (1) to (9), wherein each of the first and second metal films is provided across adjacent ones of the pixels.
(11) The light detection device according to any one of (1) to (10), wherein each of the first and second metal films is a film containing any one of aluminum, silver, copper, gold, chromium, or tungsten.
(12) The light detection device according to any one of (1) to (11), further including:
   an insulating layer covering the second metal film on a side of the second metal film opposite from the side on which the first and second dielectric films are located.
(13) The light detection device according to any one of (1) to (12), wherein the optical filter layer further includes a light absorption film provided between the first dielectric film and the second dielectric film.
(14) The light detection device according to (1) to (13), wherein the light absorption film has a higher light absorption rate than the first and second dielectric films.
(15) The light detection device according to (14), wherein in each of the first and second filter parts, each of the first and second dielectric films is provided on both the first metal film side and the second metal film side of the light absorption film.
(16) The light detection device according to (13), wherein in each of the first and second filter parts, the second dielectric film is provided on both the first metal film side and the second metal film side of the light absorption film, and
   in each of the first and second filter parts, the first dielectric film is provided on one of the first metal film side or the second metal film side of the light absorption film.
(17) The light detection device according to (13), wherein in each of the first and second filter parts, the second dielectric film is provided on both the first metal film side and the second metal film side of the light absorption film, and
   in the first filter part, the first dielectric film is provided on one of the first metal film side or the second metal film side of the light absorption film, and in the second filter part, the first dielectric film is provided on both the first metal film side and the second metal film side of the light absorption film.
(18) The light detection device according to (13), wherein in each of the first and second filter parts, the second dielectric film is provided on one of the first metal film side or the second metal film side of the light absorption film, and
   in the first filter part, the first dielectric film is provided on both the first metal film side and the second metal film side of the light absorption film.
(19) The light detection device according to (13), wherein a position of the light absorption film in a thickness direction of the optical filter layer is different in the first filter part and in the second filter part.
(20) The light detection device according to any one of (13) to (19), further including:
   a color filter layer provided between the semiconductor layer and the optical filter layer.
(21) The light detection device according to any one of (13) to (20), further including:
   an antireflection film provided between the semiconductor layer and the first metal film.
(22) The light detection device according to any one of (1) to (21), wherein the light absorption film is a film containing any one of amorphous silicon, monocrystalline silicon, polycrystal silicon, germanium, silicon germanium, indium-gallium-arsenic, titanium, tungsten, or copper.
(23) A light detection device including:
   a semiconductor layer in which a photoelectric conversion unit is provided; and
   an optical filter layer provided on a light incidence surface side of the semiconductor layer,
   wherein
   the optical filter layer includes:
      a first metal film provided on the light incidence surface side of the semiconductor layer;
      a first dielectric film and a second dielectric film which have different refractive indices and which are arranged in a thickness direction of the semiconductor layer side by side, on a side of the first metal film opposite from a side on which the semiconductor layer is located;
      a second metal film provided on a side of the first and second dielectric films opposite from
      a side on which the first metal film is located; and
      a light absorption film provided between the first dielectric film and the second dielectric film.
(24) An electronic device including:
   the light detection device according to any one of (1) to (23);
   an optical lens that forms an image of image light from a subject on an image capturing plane of the light detection device; and
   a signal processing circuit that performs signal processing on a signal output from the semiconductor layer.

The scope of the present technique is not limited to the exemplary embodiments illustrated in the drawings and described above, and includes all embodiments which have the object of the present technique and provide equivalent effects. Furthermore, the scope of the present technique is not limited to the combinations of features of the invention defined by the claims, and can be defined by all desired combinations of specific features among all the features disclosed.

### [Reference Signs List]

1A, 1B, 1C, 1D, 1E, 1F, 1G, 1H, 1I, 1J, 1K, 1L Solid-state image capturing device
2 Semiconductor chip
2A Pixel array part
2B Peripheral part
3 Pixel
4 Vertical drive circuit
5 Column signal processing circuit
6 Horizontal drive circuit
7 Output circuit
8 Control circuit
10 Pixel driving wiring
11 Vertical signal line
12 Horizontal signal line
13 Logic circuit
14 Bonding pad
15 Readout circuit
20 Semiconductor layer
21 Photoelectric conversion region
22 p-type well region
23 Isolation region
24 n-type semiconductor region
25 Photoelectric conversion unit (PD)
30 Multilayer wiring layer
31 Gate electrode
32 Interlayer insulating film
33 Wiring
34 Support substrate
35 Insulating layer
40 Optical filter layer
40a First filter part
40a Second filter part
40c Third filter part
41 First metal film
42, 42-1, 42-2 First dielectric film
42a First part
42b Second part
42c Third part
43, 43-1, 43-2 Second dielectric film
43a First part
43b Second part
43c Third part
44 Second metal film
45 Insulating layer
46 Optical filter layer
50C to 50J Optical filter layer
51a First filter part
51a Second filter part
51c Third filter part
52A, 52C to 52J Resonance layer
60 Color filter layer
61 Antireflection layer
h₁, h₂, h₃ Film thickness
AMP Amplifying transistor
RST Reset transistor
S1 First surface
S2 Second surface
SEL Selection transistor
TR Transfer transistor
Vdd Power source line

## Claims

1. A light detection device comprising:
a semiconductor layer in which a photoelectric conversion unit is provided for each of pixels; and
an optical filter layer provided on a light incidence surface side of the semiconductor layer,
wherein
the optical filter layer includes a first filter part and a second filter part, each provided for each of the pixels,
each of the first and second filter parts includes:
a first metal film provided on the light incidence surface side of the semiconductor layer;
a first dielectric film and a second dielectric film which have different refractive indices and which are arranged in a thickness direction of the semiconductor layer side by side, on a side of the first metal film opposite from a side on which the semiconductor layer is located; and
a second metal film provided on a side of the first and second dielectric films opposite from a side on which the first metal film is located, and
a ratio of thicknesses of the first dielectric film and the second dielectric film is different in the first filter part and in the second filter part.

2. The light detection device according to claim 1, wherein a total thickness of the first dielectric film and the second dielectric is the same in the first filter part and in the second filter part.

3. The light detection device according to claim 1, wherein each of the first metal film, the first dielectric film, the second dielectric film, and the second metal film is provided across adjacent ones of the pixels.

4. The light detection device according to claim 1, wherein the first dielectric film is provided further on a first metal film side than the second dielectric film, and has a higher refractive index than the second dielectric film.

5. The light detection device according to claim 4, wherein a surface layer part on a second dielectric film side of the first dielectric film has a step between adjacent ones of the pixels, and
a surface layer part on a second metal film side of the second dielectric film is flat across adjacent ones of the pixels.

6. The light detection device according to claim 1, wherein the first dielectric film is provided further on a second metal film side than the second dielectric film, and has a higher refractive index than the second dielectric film.

7. The light detection device according to claim 6, wherein a surface layer part on a first dielectric film side of the second dielectric film has a step between adjacent ones of the pixels, and
a surface layer part on a second metal film side of the first dielectric film is flat across adjacent ones of the pixels.

8. The light detection device according to claim 1, wherein the first dielectric film is a film containing any one of titanium oxide, tantalum oxide, silicon nitride, or hafnium oxide, and the second dielectric film is a film containing any one of silicon oxide or silicon oxynitride.

9. The light detection device according to claim 1, wherein the first metal film is thicker than the second metal film.

10. The light detection device according to claim 1, wherein each of the first and second metal films is provided across adjacent ones of the pixels.

11. The light detection device according to claim 1, wherein each of the first and second metal films is a film containing any one of aluminum, silver, copper, gold, chromium, or tungsten.

12. The light detection device according to claim 1, further comprising:
an insulating layer covering the second metal film on a side of the second metal film opposite from the side on which the first and second dielectric films are located.

13. The light detection device according to claim 1, wherein the optical filter layer further includes a light absorption film provided between the first dielectric film and the second dielectric film.

14. The light detection device according to claim 13, wherein the light absorption film has a higher light absorption rate than the first and second dielectric films.

15. The light detection device according to claim 13, wherein in each of the first and second filter parts, each of the first and second dielectric films is provided on both the first metal film side and the second metal film side of the light absorption film.

16. The light detection device according to claim 13, wherein in each of the first and second filter parts, the second dielectric film is provided on both the first metal film side and the second metal film side of the light absorption film, and
in each of the first and second filter parts, the first dielectric film is provided on one of the first metal film side or the second metal film side of the light absorption film.

17. The light detection device according to claim 13, wherein in each of the first and second filter parts, the second dielectric film is provided on both the first metal film side and the second metal film side of the light absorption film, and
in the first filter part, the first dielectric film is provided on one of the first metal film side or the second metal film side of the light absorption film, and in the second filter part, the first dielectric film is provided on both the first metal film side and the second metal film side of the light absorption film.

18. The light detection device according to claim 13, wherein in each of the first and second filter parts, the second dielectric film is provided on one of the first metal film side or the second metal film side of the light absorption film, and
in the first filter part, the first dielectric film is provided on both the first metal film side and the second metal film side of the light absorption film.

19. The light detection device according to claim 13, wherein a position of the light absorption film in a thickness direction of the optical filter layer is different in the first filter part and in the second filter part.

20. The light detection device according to claim 13, further comprising:
a color filter layer provided between the semiconductor layer and the optical filter layer.

21. The light detection device according to claim 13, further comprising:
an antireflection film provided between the semiconductor layer and the first metal film.

22. The light detection device according to claim 13, wherein the light absorption film is a film containing any one of amorphous silicon, monocrystalline silicon, polycrystal silicon, germanium, silicon germanium, indium-gallium-arsenic, titanium, tungsten, or copper.

23. A light detection device comprising:
a semiconductor layer in which a photoelectric conversion unit is provided; and
an optical filter layer provided on a light incidence surface side of the semiconductor layer,
wherein
the optical filter layer includes:
a first metal film provided on the light incidence surface side of the semiconductor layer;
a first dielectric film and a second dielectric film which have different refractive indices and which are arranged in a thickness direction of the semiconductor layer side by side, on a side of the first metal film opposite from a side on which the semiconductor layer is located;
a second metal film provided on a side of the first and second dielectric films opposite from a side on which the first metal film is located; and
a light absorption film provided between the first dielectric film and the second dielectric film.

24. An electronic device comprising:
a light detection device;
an optical lens that forms an image of image light from a subject on an image capturing plane of the light detection device; and
a signal processing circuit that performs signal processing on a signal output from the semiconductor layer, wherein
the light detection device includes:
a semiconductor layer in which a photoelectric conversion unit is provided for each of pixels; and
an optical filter layer provided on a light incidence surface side of the semiconductor layer,
the optical filter layer includes a first filter part and a second filter part, each provided for each of the pixels,
each of the first and second filter parts includes:
a first metal film provided on the light incidence surface side of the semiconductor layer;
a first dielectric film and a second dielectric film which have different refractive indices and which are arranged in a thickness direction of the semiconductor layer side by side, on a side of the first metal film opposite from a side on which the semiconductor layer is located; and
a second metal film provided on a side of the first and second dielectric films opposite from a side on which the first metal film is located, and
a ratio of thicknesses of the first dielectric film and the second dielectric film is different in the first filter part and in the second filter part.
